# EUROPEAN PATENT SPECIFICATION

(11) **EP 3 728 275 B1**
(45) Date of publication and mention of the grant of the patent: **04.09.2024**
(21) Application number: 18822333.3
(22) Date of filing: 17.12.2018
(51) Int. Cl.: C07F 7/08, C09K 11/06, H10K 85/60, H10K 85/40

(54) **HETEROAROMATIC COMPOUNDS**
HETEROAROMATISCHE VERBINDUNGEN
COMPOSÉS HÉTÉROAROMATIQUES

(30) Priority: 20.12.2017 EP 17209057
(43) Date of publication of application: 28.10.2020
(73) Proprietor: Merck Patent GmbH, 64293 Darmstadt (DE)
(72) Inventor: MUJICA-FERNAUD, Teresa, 64283 DARMSTADT (DE); ANÉMIAN, Rémi Manouk, Seoul 657-169 (KR); WUCHERER-PLIETKER, Margarita, 64409 MESSEL (DE); JUNG, Il, Yongin-Si GYEONGGI-DO 16861 (KR); JO, Myoung-Gi, Anyang-si GYEONGGI-DO 14003 (KR); KIM, Jun-Ho, Hwaseong-si GYEONGGI-DO 445-700 (KR)
(74) Representative: Merck Patent Association
(86) International application number: PCT/EP2018/085150
(87) International publication number: WO 2019/121483

(56) References cited:
- EP-A1- 2 878 599
- WO-A1-2010/126270
- WO-A1-2011/055912
- WO-A1-2013/119985
- WO-A1-2015/047018
- US-B1- 6 229 012

## Description

The present application concerns silafluorene derivatives according to a specific formula. The silafluorene derivatives can be employed in electronic devices. Furthermore, the present application concerns methods for preparation of the silafluorene derivatives, and electronic devices comprising the silafluorene derivatives.

Electronic devices according to the present application are understood to be organic electronic devices, which contain organic semiconductor materials as functional materials. In particular, the electronic devices are organic electroluminescent devices (OLEDs). OLEDs, in the sense of the present application, are understood to be electronic devices which contain one or more layers of organic compounds, and which emit light if an electrical voltage is applied. The structure as well as the basic operating mode of OLEDs, as well as methods for the preparation of OLEDs, are known to the skilled person.

Regarding electronic devices, in particular OLEDs, there is strong interest in finding alternative compounds which can be used in OLEDs. Furthermore, there is strong interest in finding compounds which lead to an improvement of the performance of the electronic devices, in particular in respect to lifetime, efficiency, and operating voltage of the devices. Furthermore, there is strong interest in finding compounds which are easily processable, temperature stable, and have a high stability of their glassy state. Still, in spite of strong research efforts over the past decades, these demands have not been satisfied yet.

Layers with hole transporting function, such as hole injection layers, hole transporting layers, electron blocking layers and emitting layers, are known to have a large influence of the performance of OLEDs.

Therefore, there is a strong demand for new materials which are suitable for use in such layers, in particular for new materials which have hole transporting properties and which preferably cause an improvement in the above-mentioned properties of the OLEDs.

In the prior art, triazine derivatives are known as class of materials which are well suitable for use in layers with electron transporting function. Triazine derivatives with many different structural elements are known, for example fluorene groups and spirobifluorenyl groups.

WO 2010/126270 A1 relates to substituted triazine compounds to be used in an eletron transport layer of an organic electroluminescent compound. These compounds must have either a benzoxazole, benzthiazole or benzimidazole unit which is linked to the triazine group via a linker.

US 6,229,012 B1 relates to compounds where a fluorene type ring is substituted with two triazine groups to be used in an electron transport layer of an organic electroluminescent device.

WO 2011/055912 A1 describes substituted silafluorene compounds which may be substituted with a triazine group; WO 2015/047018 A1 describes compounds having a fluorene type ring unit which is linked to a triazine group via a heteroaromatic group and EP 2878599 A1 describes carbazole compounds which may have a fluorene type group as substituent. These compounds can all be used in organic electroluminescent devices.

According to the present invention, it has been found that the performance of electronic devices, in particular OLED devices, is improved by using a compound having a silafluorene group and a triazine group. With such silafluorene compounds, one or more of the following effects is achieved:
- Increased device lifetime
- Increased device efficiency
- Decreased operating voltage
- Improved processability of the material
- Improved temperature stability of the material
- Improved stability of the glassy state of the material.

The present invention provides therefore compounds comprising at least one electron transporting group bonded via L¹ to a structure according to formulae (1-1), (I-2), (I-3) or (I-4) 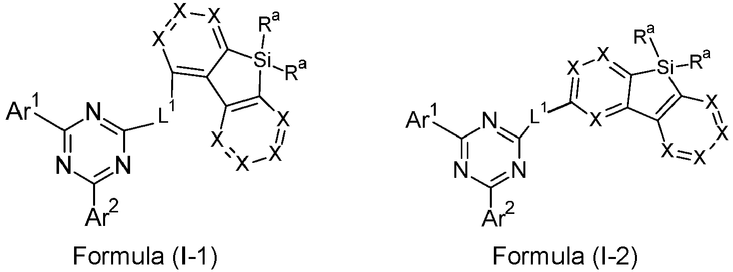 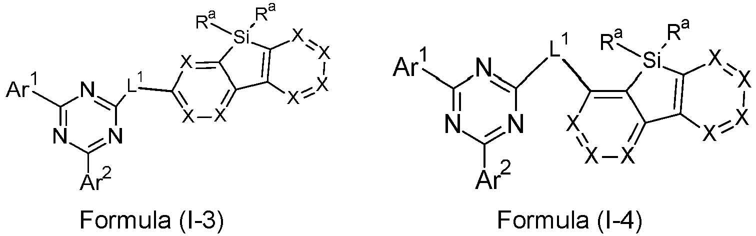 where the following applies to the variable groups:
Ar¹, Ar² are selected, identically or differently on each occurrence, from aromatic ring systems having 6 to 40 aromatic ring atoms, which may be substituted by one or more radicals R¹;
L¹ is a single bond or a group selected from aromatic ring systems having 6 to 50 aromatic ring atoms, each of which may be substituted by one or more radicals R²;
X is, identically or differently on each occurrence, selected from CR¹ and N;
R^{a} is selected, identically or differently at each occurrence, from H, D, F, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals R^{a} may be connected to each other to form a ring; where the said alkyl, alkoxy, alkenyl and alkynyl groups and the said aromatic and heteroaromatic ring systems may in each case be substituted by one or more radicals R², and where one or more CH₂ groups in the said alkyl, alkoxy, alkenyl and alkynyl groups may in each case be replaced by -R²C=CR²-, -C=C-, Si(R²)₂, C=O, C=NR², -C(=O)O-, -C(=O)NR²-, NR², P(=O)(R²), -O-, -S-, SO or SO₂;
R¹ is selected, identically or differently at each occurrence, from H, D, F, C(=O)R², CN, Si(R²)₃, P(=O)(R²)₂, OR², S(=O)R², S(=O)₂R², straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms; where two or more radicals R¹ may be connected to each other to form a ring; where the said alkyl, alkoxy, alkenyl and alkynyl groups and the said aromatic ring systems may in each case be substituted by one or more radicals R², and where one or more CH₂ groups in the said alkyl, alkoxy, alkenyl and alkynyl groups may in each case be replaced by -R²C=CR²-, -C=C-, Si(R²)₂, C=O, C=NR², -C(=O)O-, -C(=O)NR²-, NR², P(=O)(R²), -O-, -S-, SO or SO₂;
R² is selected, identically or differently at each occurrence, from H, D, F, C(=O)R³, CN, Si(R³)₃, N(R³)₂, P(=O)(R³)₂, OR³, S(=O)R³, S(=O)₂R³, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals R² may be connected to each other to form a ring; where the said alkyl, alkoxy, alkenyl and alkynyl groups and the said aromatic and heteroaromatic ring systems may in each case be substituted by one or more radicals R³, and where one or more CH₂ groups in the said alkyl, alkoxy, alkenyl and alkynyl groups may in each case be replaced by -R³C=CR³-, -C=C-, Si(R³)₂, C=O, C=NR³, -C(=O)O-, -C(=O)NR³-, NR³, P(=O)(R³), -O-, -S-, SO or SO₂ and
R³ is selected, identically or differently at each occurrence, from H, D, F, CN, alkyl groups having 1 to 20 C atoms, aromatic ring systems having 6 to 40 C atoms, or heteroaromatic ring systems having 5 to 40 aromatic ring atoms; where two or more radicals R³ may be connected to each other to form a ring; and where the said alkyl groups, aromatic ring systems and heteroaromatic ring systems may be substituted by F and CN.

Compounds of formulae (I-1), (I-3) and (I-4) are preferred and compounds of formula (I-1) and (I-4) are especially preferred.

The following definitions apply to the chemical groups used as general definitions. They only apply insofar as no more specific definitions are given.

An aryl group in the sense of this invention contains 6 to 50, preferably 6 to 40 aromatic ring atoms, of which none is a heteroatom. An aryl group here is taken to mean either a simple aromatic ring, for example benzene, or a condensed aromatic polycycle, for example naphthalene, phenanthrene, or anthracene. A condensed aromatic polycycle in the sense of the present application consists of two or more simple aromatic rings condensed with one another.

A heteroaryl group in the sense of this invention contains 5 to 50, preferably 5 to 40 aromatic ring atoms, at least one of which is a heteroatom. The heteroatoms are preferably selected from N, O and S. A heteroaryl group here is taken to mean either a simple heteroaromatic ring, such as pyridine, pyrimidine or thiophene, or a condensed heteroaromatic polycycle, such as quinoline or carbazole. A condensed heteroaromatic polycycle in the sense of the present application consists of two or more simple heteroaromatic rings condensed with one another.

An aryl or heteroaryl group, which may in each case be substituted by the above-mentioned radicals and which may be linked to the aromatic or heteroaromatic ring system via any desired positions, is taken to mean, in particular, groups derived from benzene, naphthalene, anthracene, phenanthrene, pyrene, dihydropyrene, chrysene, perylene, fluoranthene, benz-anthracene, benzophenanthrene, tetracene, pentacene, benzopyrene, furan, benzofuran, isobenzofuran, dibenzofuran, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, pheno-thiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, pyrazine, phenazine, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole.

An aromatic ring system in the sense of this invention contains 6 to 50, preferably 6 to 40 C atoms in the ring system and does not comprise any heteroatoms as aromatic ring atoms. An aromatic ring system in the sense of this application therefore does not comprise any heteroaryl groups. An aromatic ring system in the sense of this invention is intended to be taken to mean a system which does not necessarily contain only aryl groups, but instead in which, in addition, a plurality of aryl groups may be connected by a non-aromatic unit such as one or more optionally substituted C, Si, N, O or S atoms. The non-aromatic unit in such case comprises preferably less than 10% of the atoms other than H, relative to the total number of atoms other than H of the whole aromatic ring system. Thus, for example, systems such as 9,9'-spirobifluorene, 9,9'-diarylfluorene, triarylamine, diaryl ether, and stilbene are also intended to be taken to be aromatic ring systems in the sense of this invention, as are systems in which two or more aryl groups are connected, for example, by a linear or cyclic alkyl, alkenyl or alkynyl group or by a silyl group. Furthermore, systems in which two or more aryl groups are linked to one another via single bonds are also taken to be aromatic ring systems in the sense of this invention, such as, for example, systems such as biphenyl and terphenyl.

A heteroaromatic ring system in the sense of this invention contains 5 to 50, preferably 5 to 40 aromatic ring atoms, at least one of which is a heteroatom. The heteroatoms are preferably selected from N, O or S. A heteroaromatic ring system is defined as an aromatic ring system above, with the difference that it must obtain at least one heteroatom as one of the aromatic ring atoms. It thereby differs from an aromatic ring system according to the definition of the present application, which cannot comprise any heteroatom as aromatic ring atom.

An aromatic ring system having 6 to 50, preferably 6 to 40 aromatic ring atoms or a heteroaromatic ring system having 5 to 50, preferably 5 to 40 aromatic ring atoms is in particular a group which is derived from the above mentioned aryl or heteroaryl groups, or from biphenyl, terphenyl, quaterphenyl, fluorene, spirobifluorene, dihydrophenanthrene, dihydropyrene, tetrahydropyrene, indenofluorene, truxene, isotruxene, spirotruxene, spiroisotruxene, and indenocarbazole.

For the purposes of the present invention, a straight-chain alkyl group having 1 to 20 C atoms or a branched or cyclic alkyl group having 3 to 20 C atoms or an alkenyl or alkynyl group having 2 to 20 C atoms, in which, in addition, individual H atoms or CH₂ groups may be substituted by the groups mentioned above under the definition of the radicals, is preferably taken to mean the radicals methyl, ethyl, n-propyl, i-propyl, n-butyl, i-butyl, s-butyl, t-butyl, 2-methylbutyl, n-pentyl, s-pentyl, cyclopentyl, neopentyl, n-hexyl, cyclohexyl, neohexyl, n-heptyl, cycloheptyl, n-octyl, cyclooctyl, 2-ethylhexyl, trifluoromethyl, pentafluoroethyl, 2,2,2-trifluoroethyl, ethenyl, propenyl, butenyl, pentenyl, cyclopentenyl, hexenyl, cyclohexenyl, heptenyl, cycloheptenyl, octenyl, cyclooctenyl, ethynyl, propynyl, butynyl, pentynyl, hexynyl or octynyl.

An alkoxy or thioalkyl group having 1 to 20 C atoms is preferably taken to mean methoxy, trifluoromethoxy, ethoxy, n-propoxy, i-propoxy, n-butoxy, i-butoxy, s-butoxy, t-butoxy, n-pentoxy, s-pentoxy, 2-methylbutoxy, n-hexoxy, cyclohexyloxy, n-heptoxy, cycloheptyloxy, n-octyloxy, cyclooctyl-oxy, 2-ethylhexyloxy, pentafluoroethoxy, 2,2,2-trifluoroethoxy, methylthio, ethylthio, n-propylthio, i-propylthio, n-butylthio, i-butylthio, s-butylthio, t-butylthio, n-pentylthio, s-pentylthio, n-hexylthio, cyclohexylthio, n-heptyl-thio, cycloheptylthio, n-octylthio, cyclooctylthio, 2-ethylhexylthio, trifluoro-methylthio, pentafluoroethylthio, 2,2,2-trifluoroethylthio, ethenylthio, propenylthio, butenylthio, pentenylthio, cyclopentenylthio, hexenylthio, cyclohexenylthio, heptenylthio, cycloheptenylthio, octenylthio, cyclooctenyl-thio, ethynylthio, propynylthio, butynylthio, pentynylthio, hexynylthio, heptynylthio or octynylthio.

According to a preferred embodiment, the compound of the invention includes exactly one triazine group.

In a specific embodiment, the group Ar¹ in formulae (I-1), (I-2), (I-3) or (I-4) is different to the group Ar²

In a preferred embodiment, the group Ar² in formulae (I-1), (I-2), (I-3) or (I-4), comprises more aromatic ring atoms than the group Ar¹.

Preferably, the group Ar¹ in formulae (I-1), (I-2), (I-3) or (I-4) comprises at least two aromatic rings. These aromatic rings may be condensed or non-condensed, preferably these rings are non-condensed.

Preferably, the group Ar² in formulae (I-1), (I-2), (I-3) or (I-4) comprises at least two aromatic rings. These aromatic rings may be condensed or non-condensed, preferably these rings are non-condensed.

According to a specific embodiment, the group Ar² as mentioned above and below is preferably selected from phenyl, biphenyl, branched terphenyl, non-branched terphenyl, branched quaterphenyl, non-branched quaterphenyl, fluorenyl, naphthyl, anthracenyl, fluorenyl-phenylenyl, dibenzofuranyl-phenylenyl, dibenzothiophenyl-phenylenyl, phenanthrenyl and triphenylyl, each of which may be substituted by one or more radicals R¹; the group Ar² is more preferably selected from biphenyl, branched terphenyl, non-branched terphenyl, branched quaterphenyl, non-branched quaterphenyl, fluorenyl, naphthyl, anthracenyl, fluorenyl-phenylenyl, dibenzofuranyl-phenylenyl, dibenzothiophenyl-phenylenyl, phenanthrenyl and triphenylyl, each of which may be substituted by one or more radicals R¹.

In a specific embodiment, the inventive compound preferably conforms to one of formula (I-5), (I-6), (I-7) and (I-8) 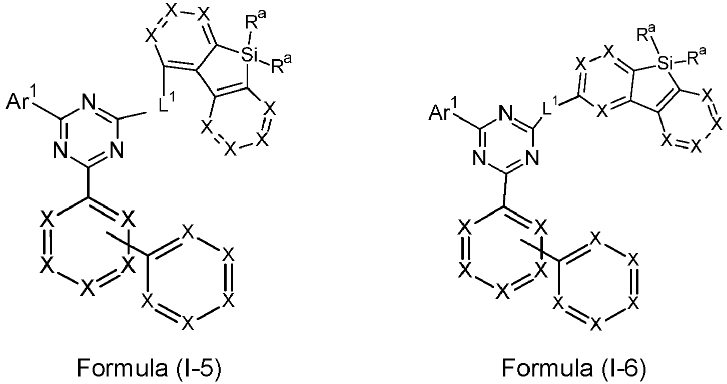 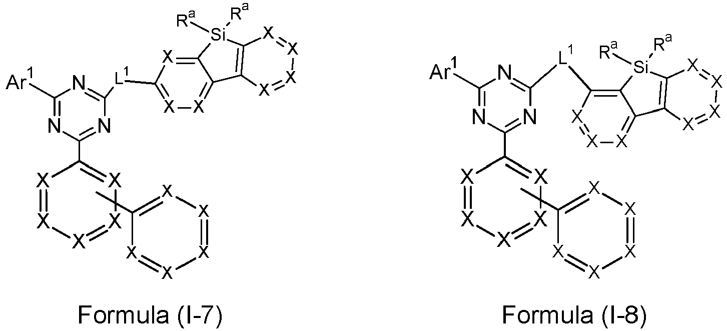 where the variables occurring are defined as above, wherein compounds of formulae (I-5), (I-7) and (I-8) are preferred and compounds of formula (I-5) and (I-8) are especially preferred.

In a further embodiment, the inventive compound preferably conforms to one of formula (I-5a), (I-6a), (I-7a) and (I-8a) 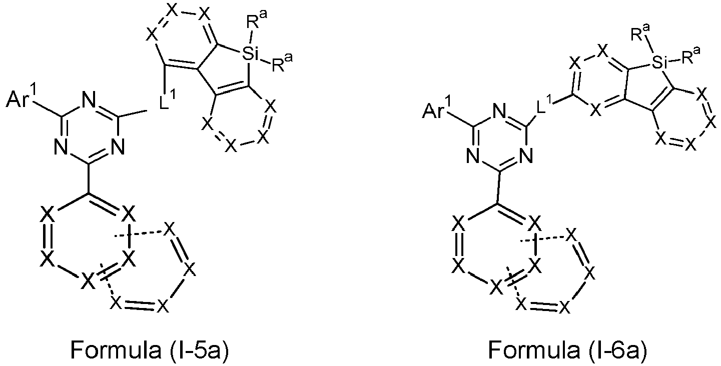 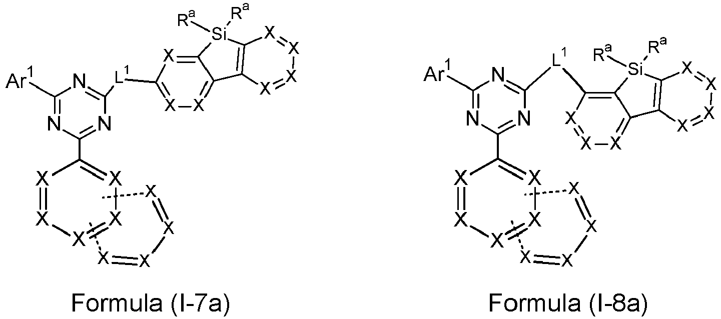 where the variables occurring are defined as above, and the dotted lines define the bonding to the aromatic ring for forming a condensed ring, wherein compounds of formula (I-5a), (I-7a) and (I-8a) are preferred and compounds of formula (I-5a) and (I-8a) are especially preferred.

According to a specific embodiment, the group Ar¹ as mentioned above and below is preferably selected from phenyl, biphenyl, branched terphenyl, non-branched terphenyl, branched quaterphenyl, non-branched quaterphenyl, fluorenyl, naphthyl, anthracenyl, fluorenyl-phenylenyl, dibenzofuranyl-phenylenyl, dibenzothiophenyl-phenylenyl, phenanthrenyl and triphenylyl, each of which may be substituted by one or more radicals R¹.

In an embodiment of the present invention, the inventive compound preferably conforms to one of formula (I-9), (I-10), (I-11) and (I-12) 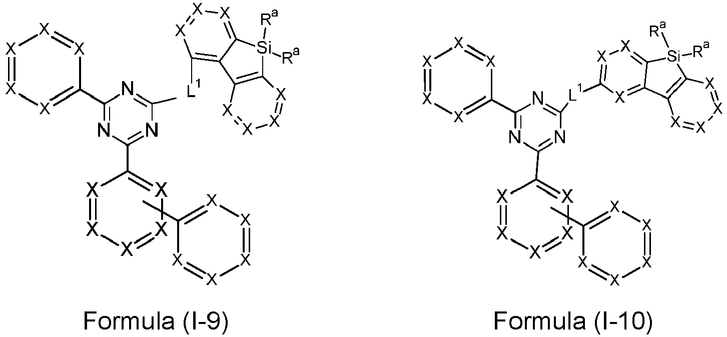 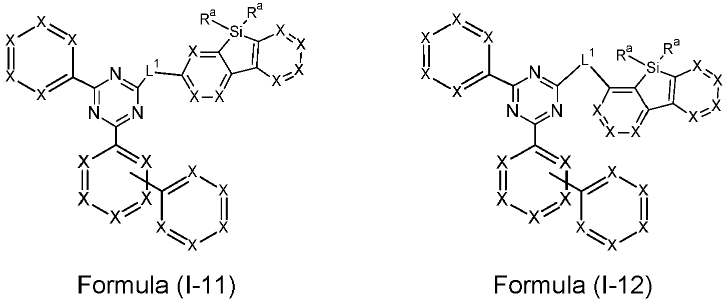 where the variables occurring are defined as above, wherein compounds of formula (I-9), (I-11) and (I-12) are preferred and compounds of formula (I-9) and (I-12) are especially preferred.

In another embodiment of the present invention, the inventive compound preferably conforms to one of formula (I-9a), (I-10a), (I-11a) and (1-12a) 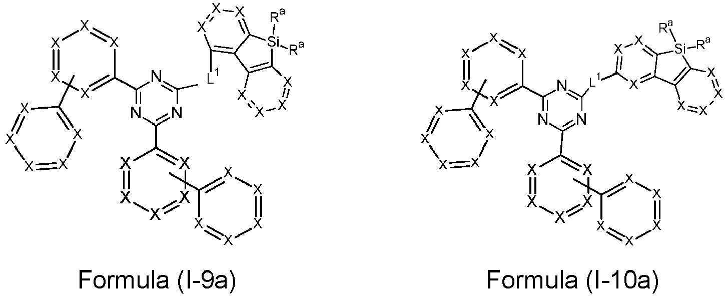 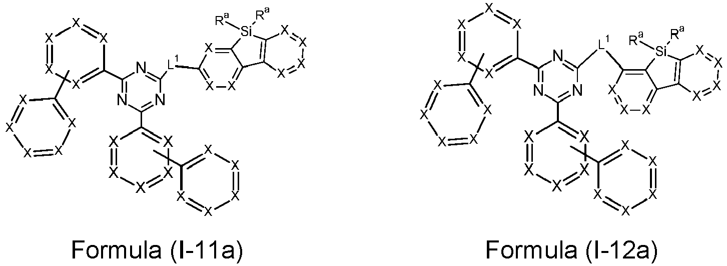 where the variables occurring are defined as above, wherein compounds of formula (I-9a), (I-11a) and (1-12a) are preferred and compounds of formula (I-9a) and (I-12a) are especially preferred.

In a further embodiment of the present invention, the inventive compound preferably conforms to one of formula (I-9b), (I-10b), (I-11b) and (1-12b) 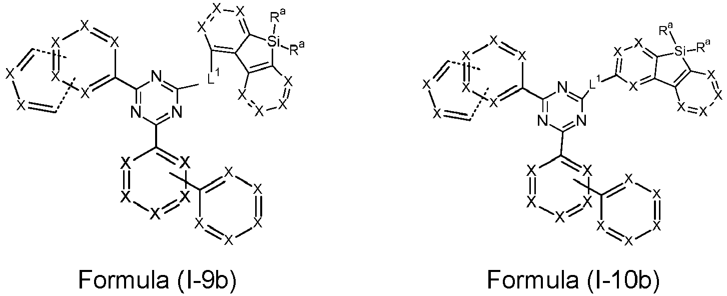 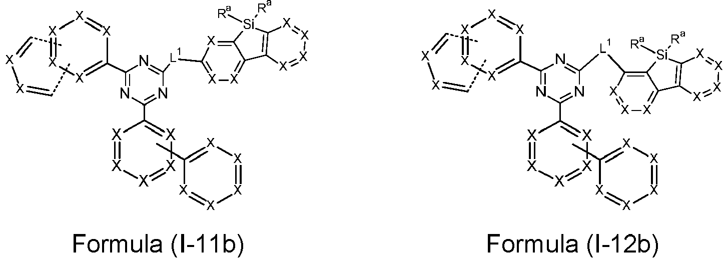 where the variables occurring are defined as above, the dotted lines define the bonding to the aromatic ring for forming a condensed ring, wherein compounds of formula (I-9b), (I-11b) and (I-12b) are preferred and compounds of formula (I-9b) and (I-12b) are especially preferred.

In the structures of formula (I-1), I-2), (I-3), (I-4), (I-5), (I-6), (I-7), (I-8), (I-5a), (I-6a), (I-7a), (I-8a), (I-9), (I-10), (I-11), (12), (I-9a), (I-10a), (I-11a), (12a), (I-9b), (1-10b), (I-11b) and (1-12b) preferably at most 6, preferably at most 4, more preferably at most 2 of the groups X represent a nitrogen atom. More preferably, the compounds of structures of formula (I-1), I-2), (I-3), (I-4), (I-5), (I-6), (I-7), (I-8), (I-5a), (I-6a), (I-7a), (I-8a), (I-9), (I-10), (I-11), (12), (I-9a), (I-10a), (I-11a), (12a), (I-9b), (I-10b), (I-11b) and (I-12b) are characterized in that at most 6, preferably at most 4, more preferably at most 2 of the groups X represent a group being different to CH and/or CD.

In a further embodiment, preferred compounds of formula (I-1), I-2), (I-3), (I-4), (I-5), (I-6), (I-7), (I-8), (I-5a), (I-6a), (I-7a), (I-8a), (I-9), (I-10), (I-11), (12), (I-9a), (I-10a), (I-11a), (12a), (I-9b), (I-10b), (I-11b) and (I-12b) at least one of the groups X represent a nitrogen atom, more preferably exactly one of the groups X represent a nitrogen atom.

In an embodiment of the present invention, the inventive compound preferably conforms to one of formula (I-13), (I-14), (I-15) and (I-16) 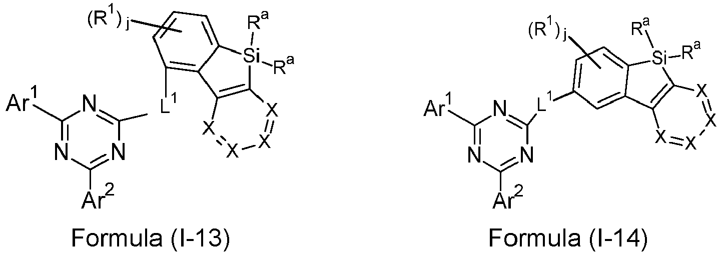 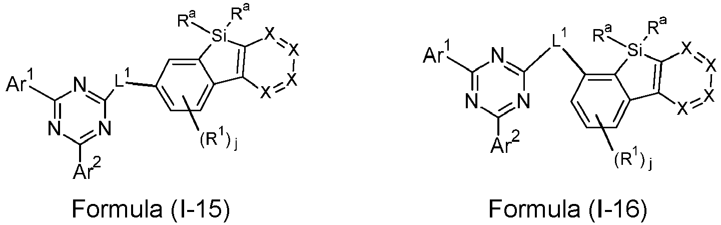 where the variables occurring are defined as above, the index j is 0, 1, 2 or 3, preferably 0, 1 or 2 and more preferably 0 or 1, wherein compounds of formula (I-13), (I-15) and (I-16) are preferred and compounds of formula (I-13) and (I-16) are especially preferred.

In another embodiment of the present invention, the inventive compound preferably conforms to one of formula (I-17), (I-18), (I-19) and (I-20) 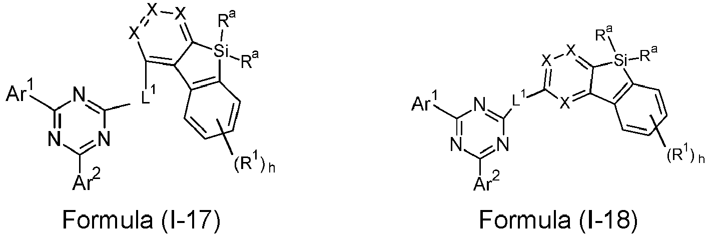 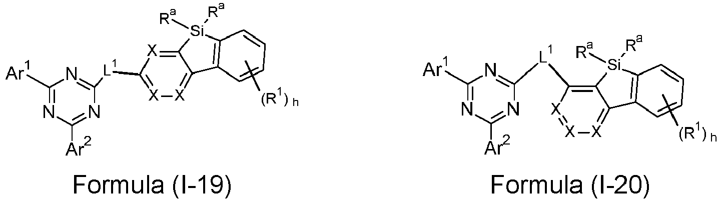 where the variables occurring are defined as above, the index h is 0, 1, 2, 3 or 4, preferably 0, 1 or 2 and more preferably 0 or 1 wherein compounds of formula (I-17), (I-19) and (I-20) are preferred and compounds of formula (I-17) and (I-20) are especially preferred.

In a further embodiment of the present invention, the inventive compound preferably conforms to one of formula (I-21), (I-22), (I-23) and (I-24) 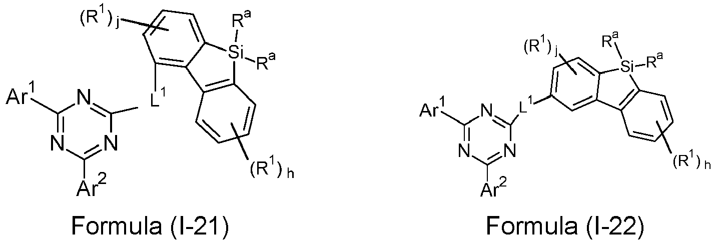 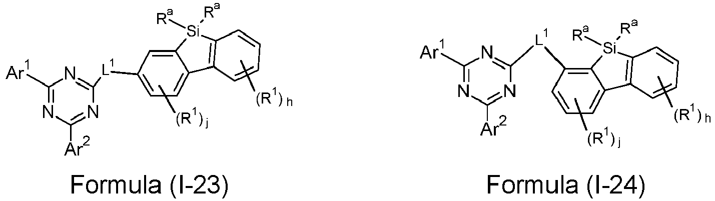 where the variables occurring are defined as above, the index j is 0, 1, 2 or 3, preferably 0, 1 or 2 and more preferably 0 or 1 and the index h is 0, 1, 2, 3 or 4, preferably 0, 1 or 2 and more preferably 0 or 1 wherein compounds of formula (I-21), (I-23) and (I-24) are preferred and compounds of formula (I-21) and (I-24) are especially preferred.

The preferred embodiments with regard to the groups Ar¹ and Ar² applies also to the compounds of Formula (I-13) to (I-24). Consequently the following structures are especially preferred.

In an embodiment of the present invention, the inventive compound preferably conforms to one of formula (I-25), (I-26), (I-27) and (I-28) 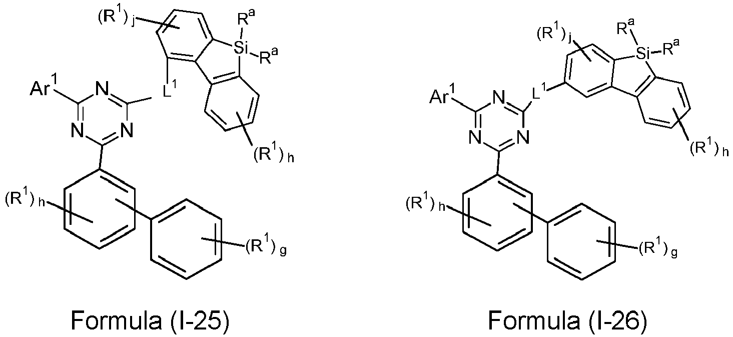 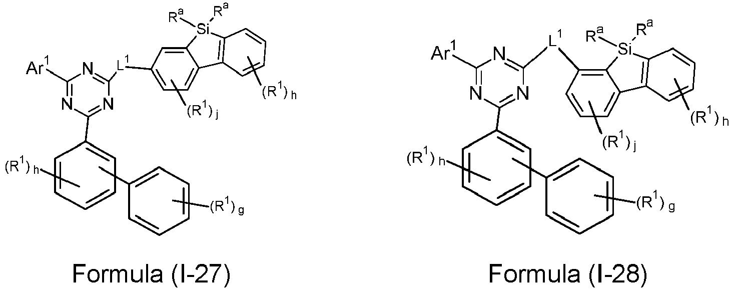 where the variables occurring are defined as above, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is 0, 1, 2, 3, 4 or 5, preferably 0, 1, 2 or 3 and more preferably 0 or 1, wherein compounds of formula (I-25), (I-27) and (I-28) are preferred and compounds of formula (I-25) and (I-28) are especially preferred.

In another embodiment of the present invention, the inventive compound preferably conforms to one of formula (I-25a), (I-26a), (I-27a) and (I-28a) 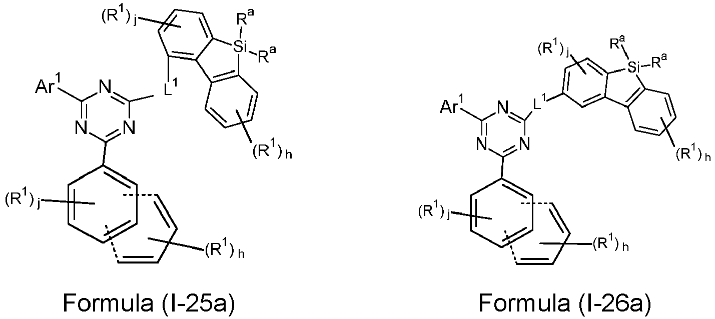 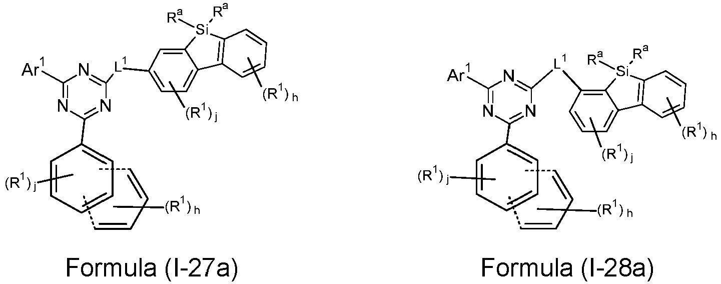 where the variables occurring are defined as above, the dotted lines define the bonding to the aromatic ring for forming a condensed ring, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1, wherein compounds of formula (I-25a), (I-27a) and (I-28) are preferred and compounds of formula (I-25a) and (I-28a) are especially preferred.

In a further embodiment of the present invention, the inventive compound preferably conforms to one of formula (I-29), (I-30), (I-31) and (I-32) 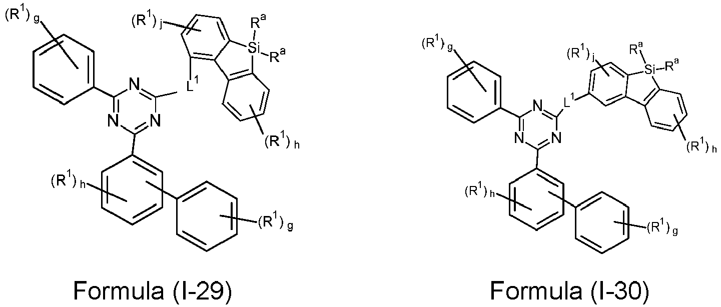 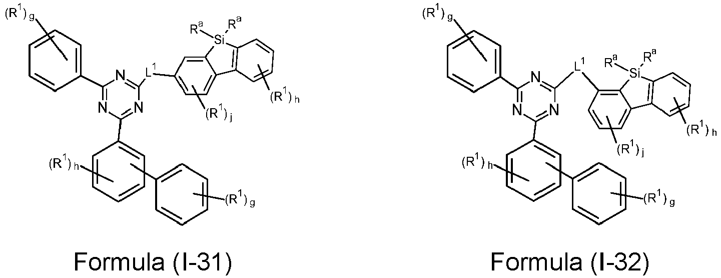 where the variables occurring are defined as above, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formula (I-29), (I-31) and (I-32) are preferred and compounds of formula (I-29) and (I-32) are especially preferred.

In an embodiment of the present invention, the inventive compound preferably conforms to one of formula (I-29a), (I-30a), (I-31a) and (I-32a) 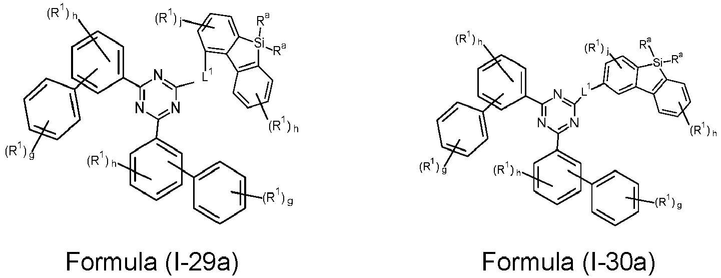 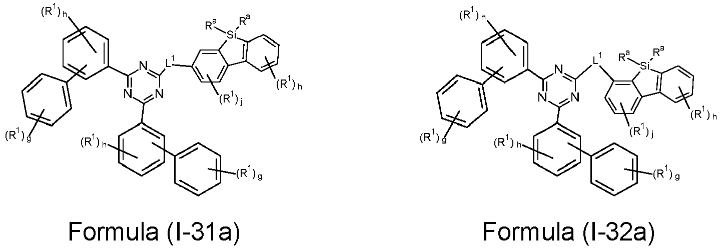 where the variables occurring are defined as above, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formula (I-29a), (I-31a) and (I-32a) are preferred and compounds of formula (I-29a) and (I-32a) are especially preferred.

In another embodiment of the present invention, the inventive compound preferably conforms to one of formula (I-29b), (I-30b), (I-31b) and (I-32b) 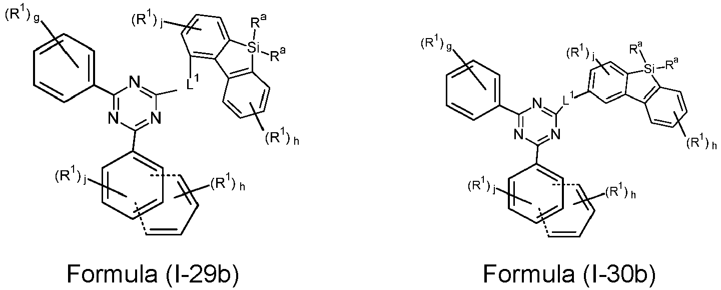 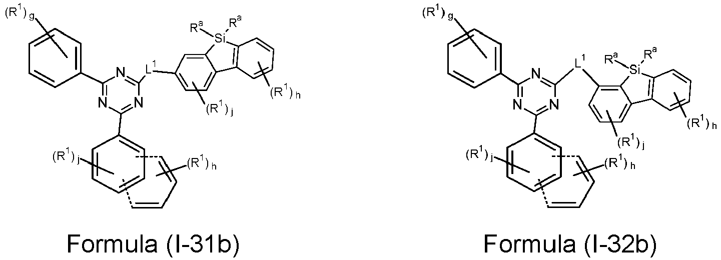 where the variables occurring are defined as above, the dotted lines define the bonding to the aromatic ring for forming a condensed ring, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formula (I-29b), (I-31b) and (I-32b) are preferred and compounds of formula (I-29b) and (I-32b) are especially preferred.

In a further embodiment of the present invention, the inventive compound preferably conforms to one of formula (I-29c), (I-30c), (I-31c) and (I-32c) 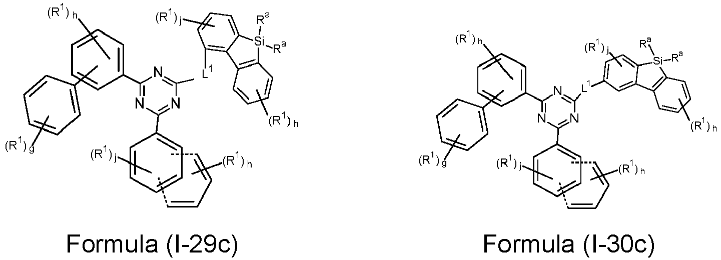 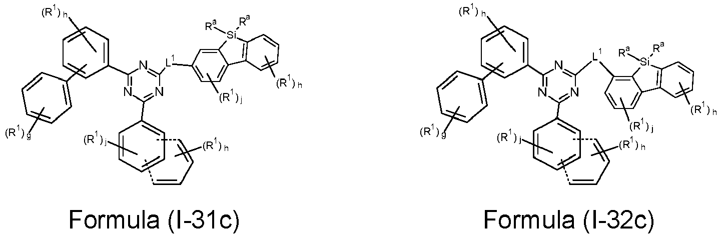 where the variables occurring are defined as above, the dotted lines define the bonding to the aromatic ring for forming a condensed ring, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formulae (I-29c), (I-31c) and (I-32c) are preferred and compounds of formulae (I-29c) and (I-32c) are especially preferred.

Preferably, the sum of the indices h, j and g in the structures of formulae (I-13) to (I-32b) is at most 3, preferably at most 2 and more preferably at most 1.

Regarding the compounds of formulae (I-1) to (I-32c), the compounds having at least two aromatic rings in the residues Ar¹ and/or Ar² are preferred. More preferably, the compounds having at least two uncondensed aromatic rings are preferred over compounds having condensed rings. Consequently, structures of formulae (I-5) to (I-8) are preferred over structures of formulae (I-5a) to (I-8a). Additionally, structures of formulae (I-9) to (I-12a) are preferred over structures of formulae (I-9b) to (I-12b). Furthermore, structures of formulae (I-25) to (I-28) are preferred over structures of formulae (I-25a) to (I-28a). Additionally, structures of formulae (I-29) to (I-32a) are preferred over structures of formulae (I-29b) to (I-32c).

L¹ is preferably a bond or selected from divalent groups derived from phenyl, biphenyl, branched terphenyl, non-branched terphenyl, branched quaterphenyl, non-branched quaterphenyl, fluorenyl, naphthyl, anthracenyl, fluorenyl-phenylenyl, phenanthrenyl and triphenylyl, each of which may be substituted by one or more radicals R², preferably a bond or a group selected from phenyl or biphenyl each of which may be substituted by one or more radicals R². Particularly preferably, L¹ is a bond or a divalent group selected from para-phenylene, meta-phenylene, ortho-phenylene, para-biphenylene, meta-biphenylene, and ortho-biphenylene, each of which may be substituted by one or more radicals R².

Preferably, the group L¹ forms a continuous conjugation with the two aryl or heteroaryl groups to which the group L¹ is bound, as shown, e.g. in formulae (I-1) to (I-32), and/or (I-37) to (I-48). A continuous conjugation of the aromatic or heteroaromatic systems is formed as soon as direct bonds are formed between adjacent aromatic or heteroaromatic rings. A further linkage between the abovementioned conjugated groups, which takes place, for example, via an S, N or O atom or a carbonyl group, does not damage conjugation.

L¹ is preferably a bond or a group being selected from one of formulae (L¹-1) to (L¹-36), (L¹-53) to (L¹-60) and (L¹-71) to (L¹-108): 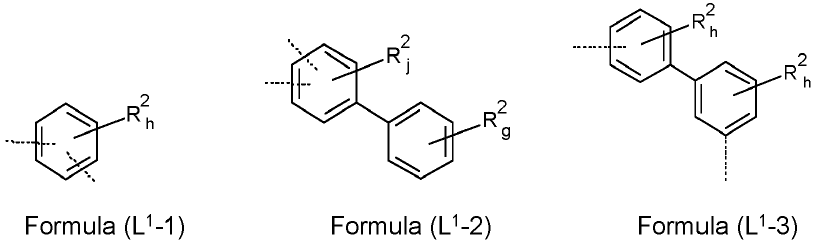 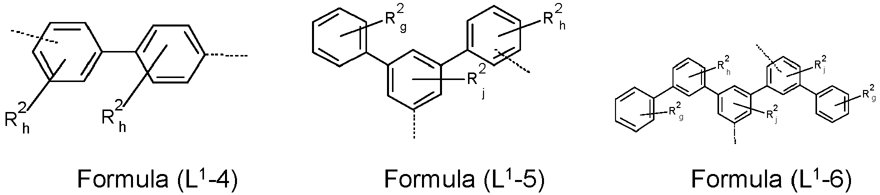 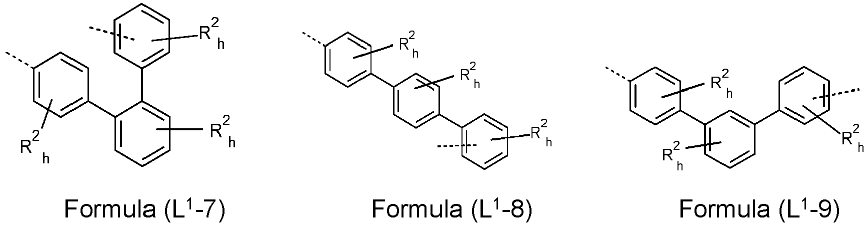 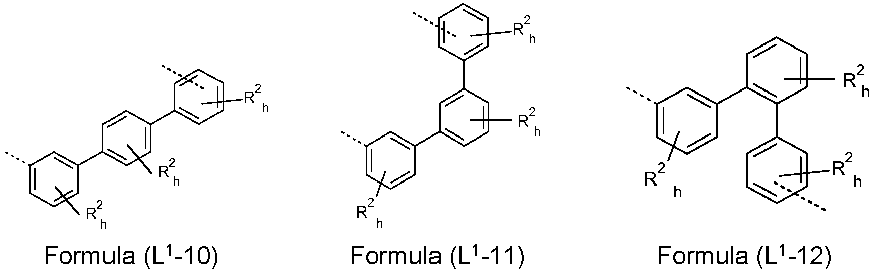 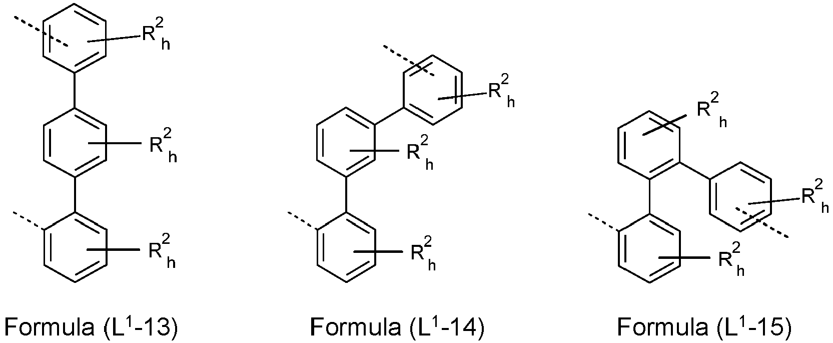 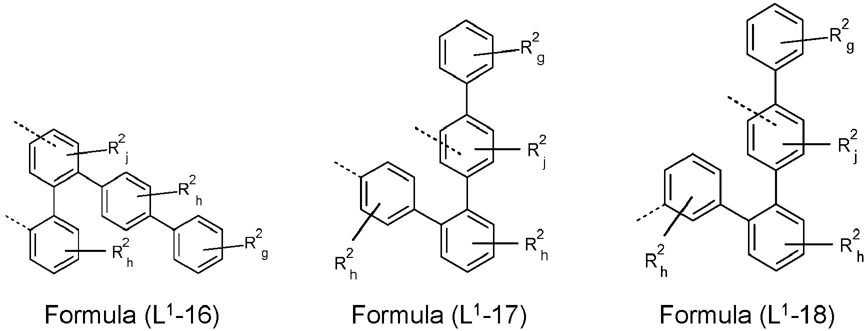 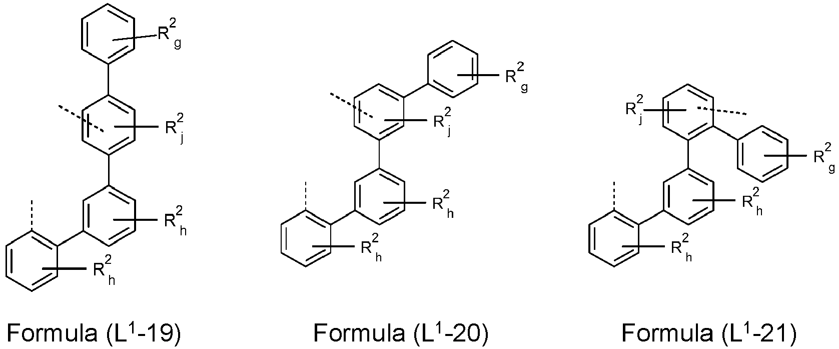 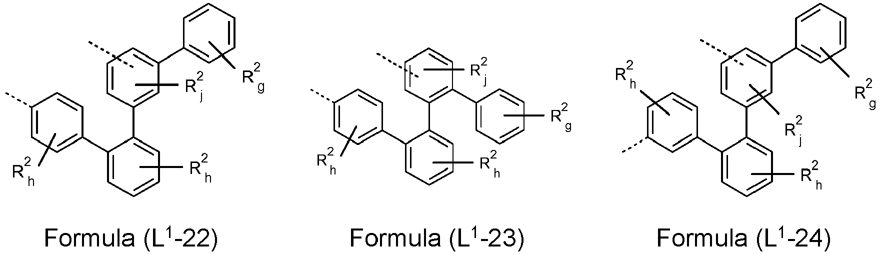 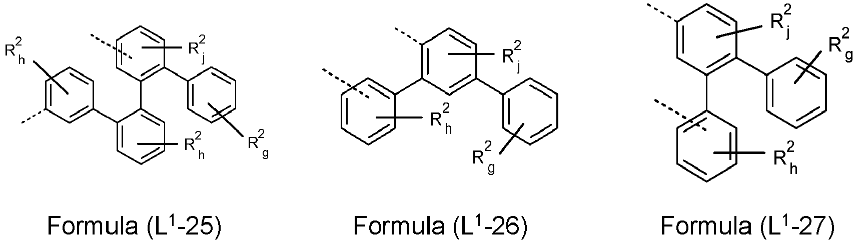 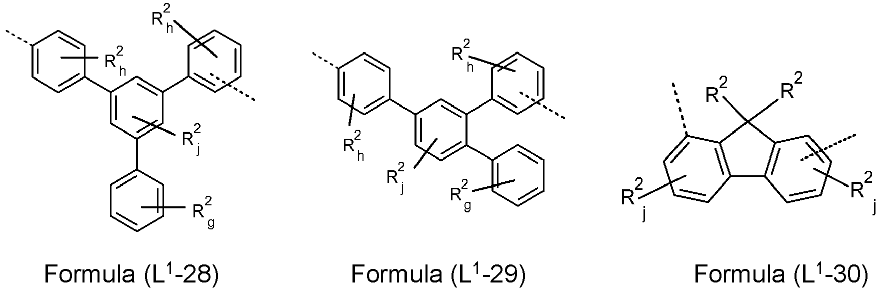 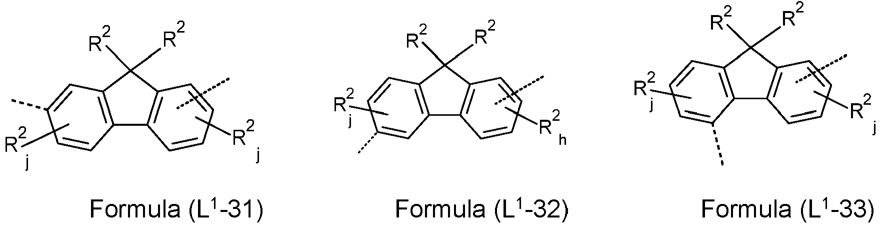 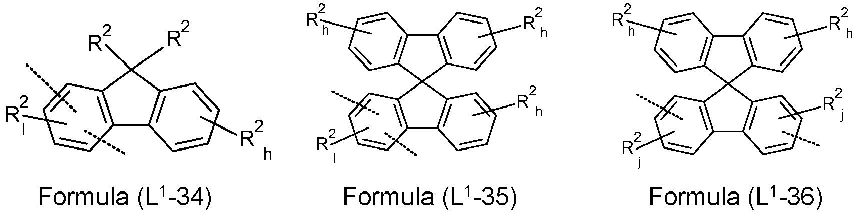 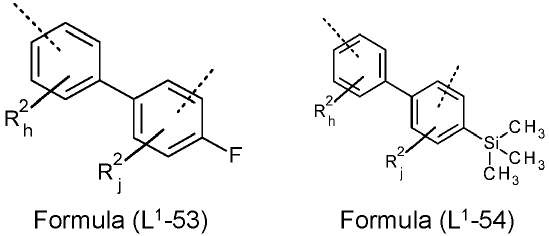 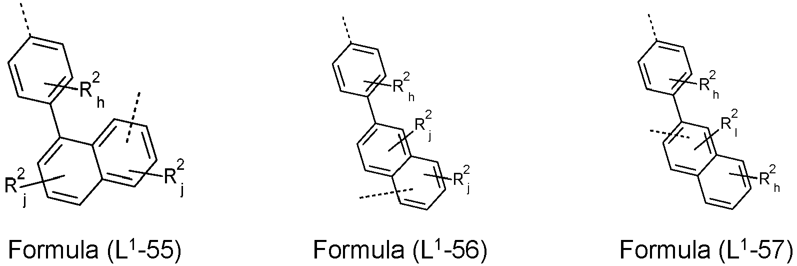 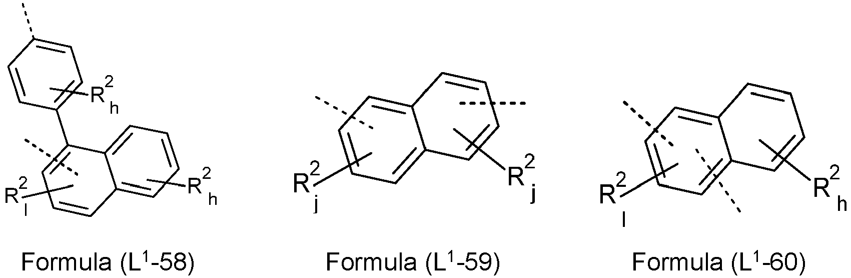 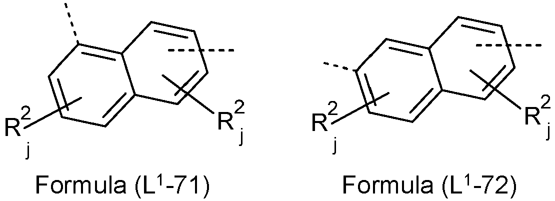 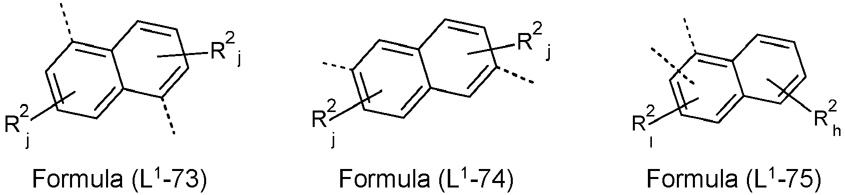 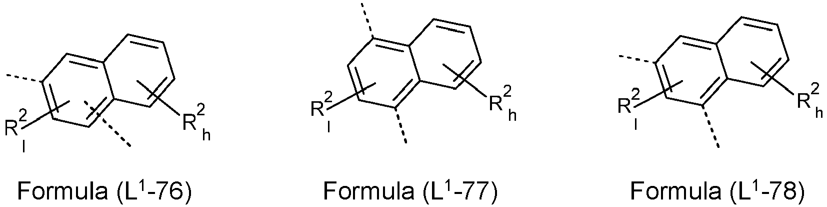 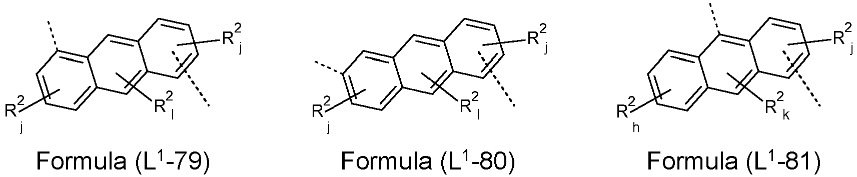 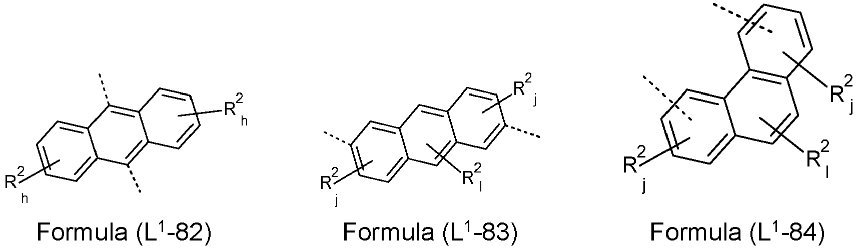 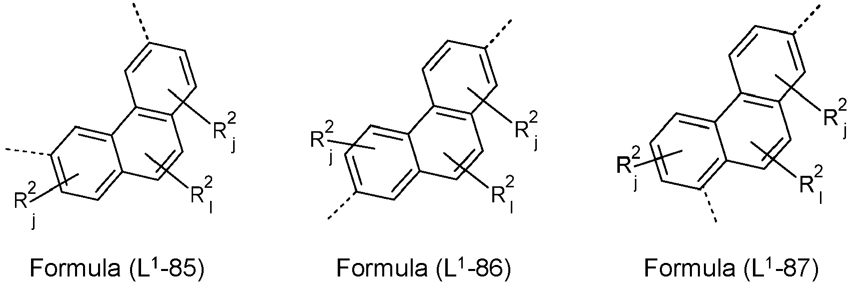 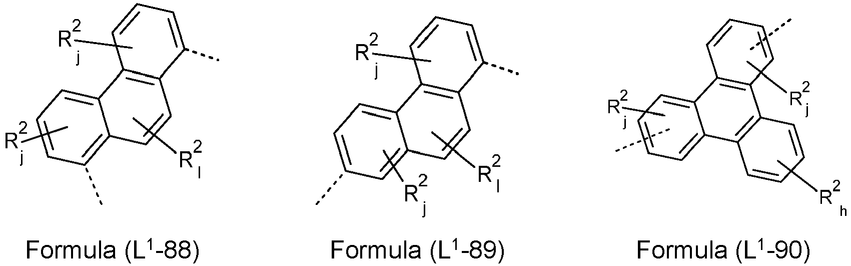 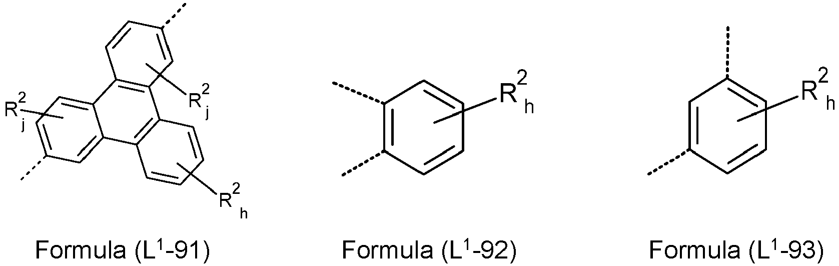 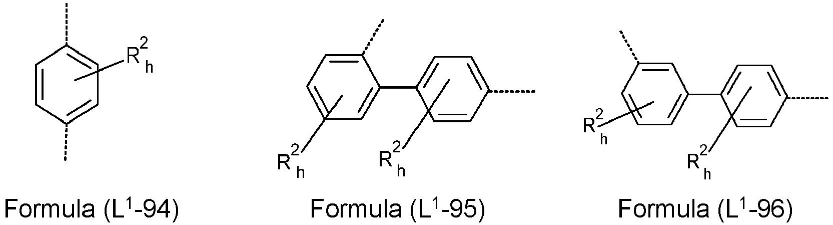 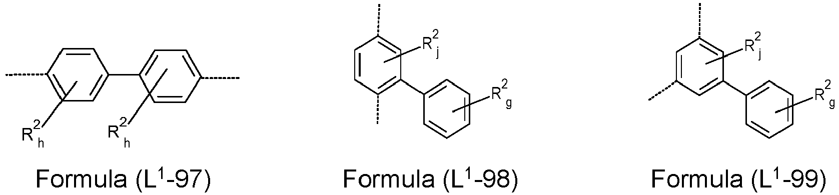 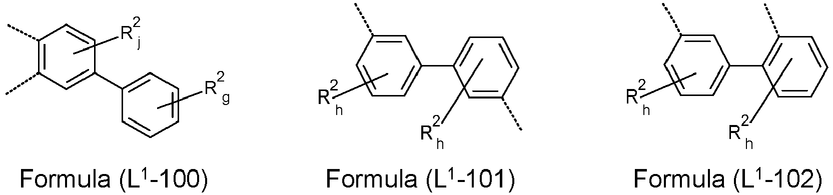 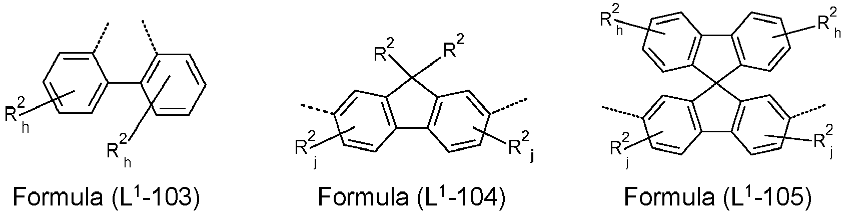 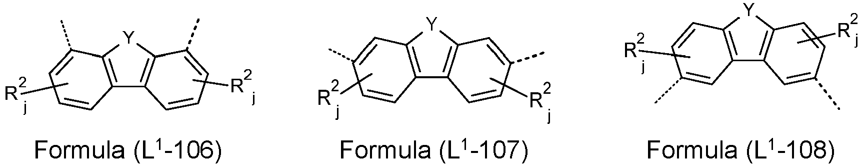 wherein the dotted lines represents the bondings to the neigbouring groups, the index k is, identically or differently at each occurrence, 0 or 1, the index I is, identically or differently at each occurrence, 0, 1 or 2, the index j is, identically or differently at each occurrence, 0, 1, 2 or 3; the index h is, identically or differently at each occurrence, 0, 1, 2, 3 oder 4, the index g is, identically or differently at each occurrence, 0, 1, 2, 3, 4 oder 5 and the symbol R² is defined as above.

Preferably, the sum of the indices I, g, h and j in the structures of formulae (L¹-1) to (L¹-36), (L¹-53) to (L¹-60) and (L¹-71) to (L¹-108) is at most 3, preferably at most 2 and more preferably at most 1.

According to a preferred embodiment, the group L¹ as mentioned above and below is a bond or selected from the structures (L¹-1) to (L¹-36), (L¹-53) to (L¹-60), (L¹-71) to (L¹-78) and (L¹-92) to (L¹-108), preferably is a bond or selected from the structures (L¹-1) to (L¹-36), (L¹-53), (L¹-54) and (L¹-92) to (L¹-103), most preferably a bond.

In a very preferred embodiment of the present invention, the inventive compound preferably conforms to one of formulae (I-33), (I-34), (I-35) and (I-36) 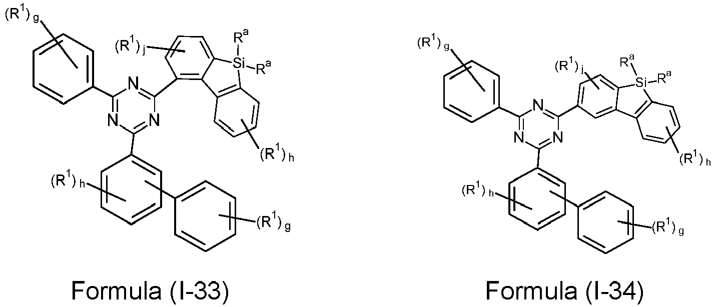 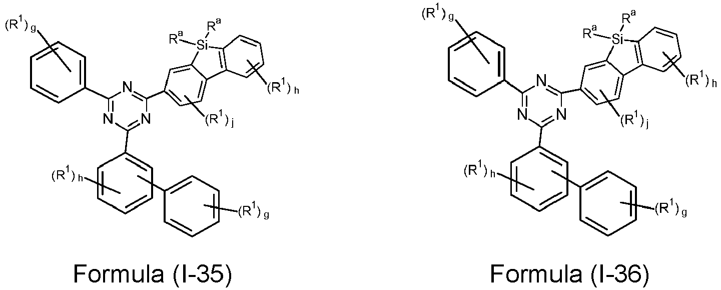 where the variables occurring are defined as above, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formulae (I-33), (I-35) and (I-36) are preferred and compounds of formulae (I-33) and (I-36) are especially preferred.

Preferably, the sum of the indices g, h and j in the structures of formulae (I-33), (I-34), (I-35) and (I-36) is at most 3, preferably at most 2 and more preferably at most 1.

R^{a} is preferably selected, at each occurrence, from F, straight-chain alkyl groups having 1 to 20 C atoms, branched or cyclic alkyl groups having 3 to 20 C atoms, aromatic ring systems having 6 to 40 aromatic ring atoms, and heteroaromatic ring systems having 5 to 40 aromatic ring atoms; where two or more radicals R^{a} may be connected to each other to form a ring; and where the said alkyl groups and the said aromatic and heteroaromatic ring systems may in each case be substituted by one or more radicals R². If two or more radicals R^{a} are connected to each other to form a ring, this ring is preferably a sila-cycloalkyl ring with the silicium atom to which the two radicals R^{a} bond as the spiro atom, where the sila-cycloalkyl ring is preferably selected from sila-cyclopropyl, sila-cyclobutyl, sila-cyclopentyl, and sila-cyclohexyl, most preferably from sila-cyclopentyl and sila-cyclohexyl. Alternatively and equally preferably, if two or more radicals R^{a} are connected to each other to form a ring, a sila-spirobifluorene is formed as the compound of formulae (I-1), (I-2), (I-3) or (I-4), with the silicium atom to which the two radicals R^{a} bond as the central silicium atom of the sila-spirobifluorene.

More preferably, R^{a} is at each occurrence, identically or differently, selected from straight-chain alkyl groups having 1 to 10 C atoms, branched or cyclic alkyl groups having 3 to 10 C atoms, aromatic ring systems having 6 to 24 aromatic ring atoms, and heteroaromatic ring systems having 5 to 24 aromatic ring atoms, where the said alkyl groups and the said aromatic and heteroaromatic ring systems may in each case be substituted by one or more radicals R². Most preferably, R^{a} is selected, identically or differently on each occurrence, from methyl, ethyl, propyl, butyl, pentyl, phenyl, biphenyl, terphenyl, fluorenyl, and naphthyl, each of which may be substituted by one or more radicals R², but is preferably unsubstituted.

In a further embodiment, at least one of the residues R^{a} is preferably selected from phenyl, biphenyl, branched terphenyl, non-branched terphenyl, branched quaterphenyl, non-branched quaterphenyl, fluorenyl, naphthyl, anthracenyl, pyridyl, quinolinyl, dibenzofuranyl, dibenzothiophenyl, carbazolyl, fluorenyl-phenylenyl, dibenzofuranyl-phenylenyl, dibenzothiophenyl-phenylenyl, phenanthrenyl and triphenylyl, each of which may be substituted by one or more radicals R².

In another embodiment, at least one of the residues R^{a} is selected from straight-chain alkyl or alkoxy groups having 1 to 12 C atoms, branched or cyclic alkyl or alkoxy groups having 3 to 12 C atoms, alkenyl or alkynyl groups having 2 to 12 C atoms, where two or more radicals R^{a} may be connected to each other to form a ring; where the said alkyl, alkoxy, alkenyl and alkynyl groups may in each case be substituted by one or more radicals R², and where one or more CH₂ groups in the said alkyl, alkoxy, alkenyl and alkynyl groups may in each case be replaced by -R²C=CR²-, -C≡C-, Si(R²)₂, C=O, C=NR², -C(=O)O-, -C(=O)NR²-, NR², P(=O)(R²), -O-, -S-, SO or SO₂, preferably R^{a} is selected from straight-chain alkyl groups having 1 to 10 C atoms, branched or cyclic alkyl groups having 3 to 12 C atoms, more preferably R^{a} is selected from methyl, ethyl, propyl or butyl.

In yet another embodiment, both residues R^{a} are preferably identical.

Moreover, in a specific embodiment both residues R^{a} are preferably different, more preferably one R^{a} is a residue selected from phenyl, biphenyl, branched terphenyl, non-branched terphenyl, branched quaterphenyl, non-branched quaterphenyl, fluorenyl, naphthyl, anthracenyl, pyridyl, quinolinyl, dibenzofuranyl, dibenzothiophenyl, carbazolyl, fluorenyl-phenylenyl, dibenzofuranyl-phenylenyl, dibenzothiophenyl-phenylenyl, phenanthrenyl and triphenylyl, each of which may be substituted by one or more radicals R² and one a residue is selected from straight-chain alkyl or alkoxy groups having 1 to 12 C atoms, branched or cyclic alkyl or alkoxy groups having 3 to 12 C atoms, alkenyl or alkynyl groups having 2 to 12 C atoms, where two or more radicals R^{a} may be connected to each other to form a ring; where the said alkyl, alkoxy, alkenyl and alkynyl groups may in each case be substituted by one or more radicals R², and where one or more CH₂ groups in the said alkyl, alkoxy, alkenyl and alkynyl groups may in each case be replaced by -R²C=CR²-, -C=C-, Si(R²)₂, C=O, C=NR², -C(=O)O-, -C(=O)NR²-, NR², P(=O)(R²), -O-, -S-, SO or SO₂, preferably R^{a} is selected from straight-chain alkyl groups having 1 to 10 C atoms, branched or cyclic alkyl groups having 3 to 12 C atoms, more preferably R^{a} is selected from methyl, ethyl, propyl or butyl.

In an embodiment of the present invention, the inventive compound preferably conforms to one of formulae (I-41), (I-42), (I-43) and (I-44) 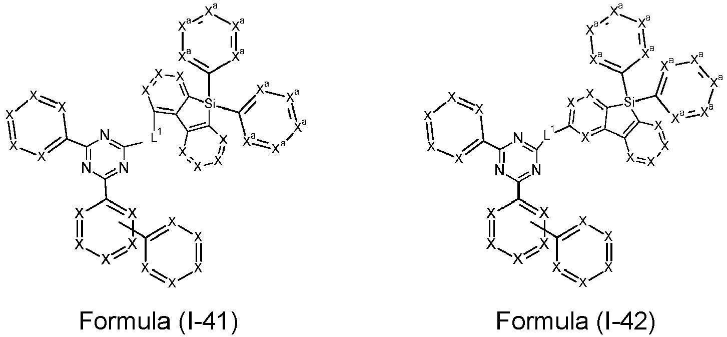 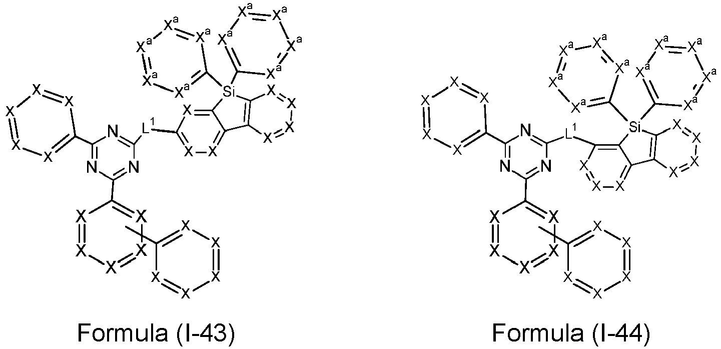 where the variables occurring are defined as above and X^{a} is N or CR², preferably CR², wherein compounds of formulae (I-41), (I-43) and (I-44) are preferred and compounds of formulae (I-41) and (I-44) are especially preferred.

In the structures of formulae (I-41), (I-42), (I-43) and (I-44) preferably at most 6, preferably at most 4, more preferably at most 2 of the groups X and X^{a} represent a nitrogen atom. More preferably, the compounds of structures of formulae (I-41), (I-42), (I-43) and (I-44) are characterized in that at most 6, preferably at most 4, more preferably at most 2 of the groups X and X^{a} represent a group being different to CH and/or CD.

In another embodiment of the present invention, the inventive compound preferably conforms to one of formulae (I-45), (I-46), (I-47) and (I-48) 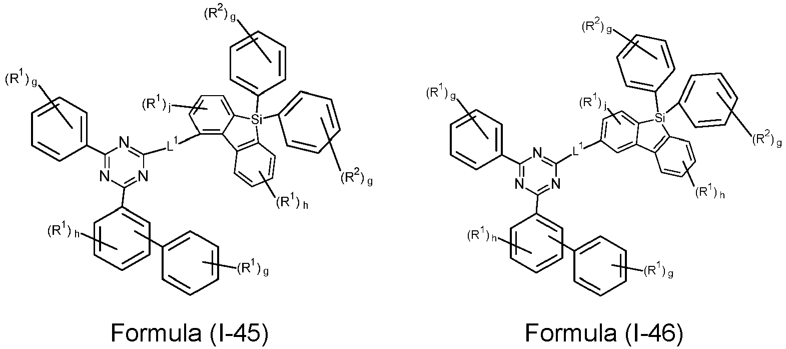 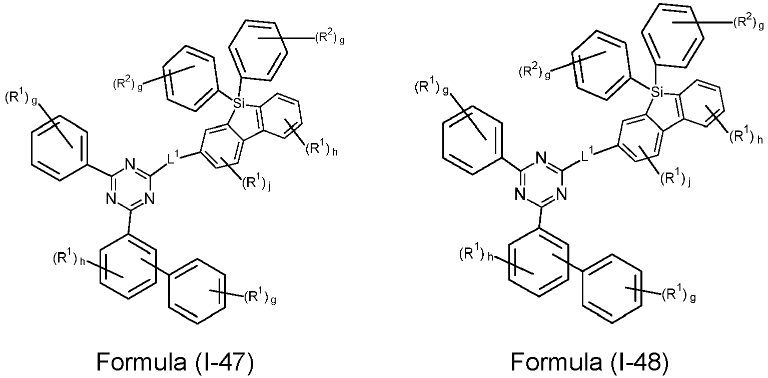 where the variables occurring are defined as above, the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formulae (I-45), (I-47) and (I-48) are preferred and compounds of formulae (I-45) and (I-48) are especially preferred.

In a further embodiment of the present invention, the inventive compound preferably conforms to one of formulae (I-49), (I-50), (I-51) and (I-52) 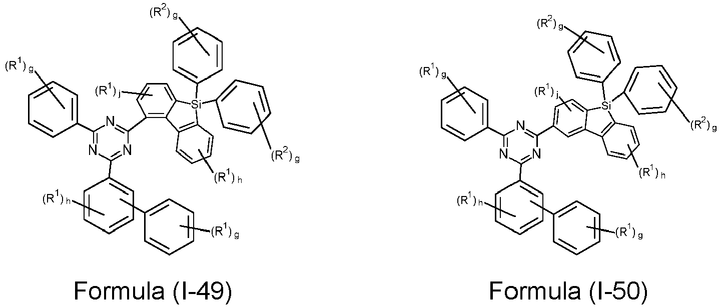 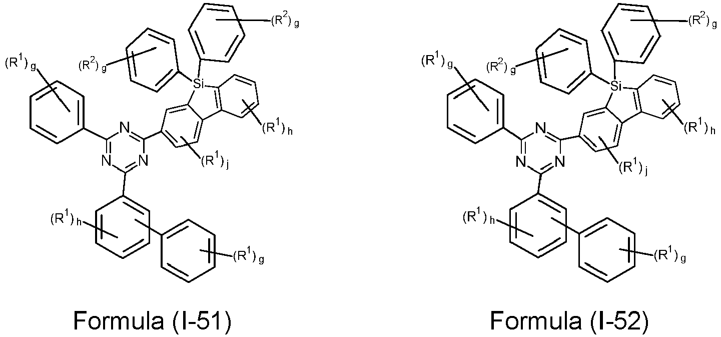 where the variables occurring are defined as above, , the index j is 0, 1, 2 or 3, preferably 0, 1 or 2 and more preferably 0 or 1, and the index h is, identically or differently at each occurrence, 0, 1, 2, 3 or 4, preferably 0, 1 or 2 and more preferably 0 or 1 and the index g is, identically or differently at each occurrence, 0, 1, 2, 3, 4 or 5, preferably 0, 1, 2 or 3 and more preferably 0 or 1, wherein compounds of formulae (I-49), (I-51) and (I-52) are preferred and compounds of formulae (I-49) and (I-52) are especially preferred.

Preferably, the sum of the indices g, h and j in the structures of formulae (I-45) to (I-52) is at most 3, preferably at most 2 and more preferably at most 1.

R¹ preferably is, identically or differently on each occurrence, selected from H, D, F, CN, straight-chain alkyl groups having 1 to 20 C atoms, branched or cyclic alkyl groups having 3 to 20 C atoms, aromatic ring systems having 6 to 40 aromatic ring atoms,; where two or more radicals R¹ may be connected to each other to form a ring; and where the said alkyl groups and the said aromatic ring systems may in each case be substituted by one or more radicals R². Most preferably, R¹ is H.

In a further embodiment R¹ is on each occurrence, identically or differently, preferably selected from straight-chain alkyl groups having 1 to 10 C atoms, branched or cyclic alkyl groups having 3 to 10 C atoms, aromatic ring systems having 6 to 24 aromatic ring atoms, where the said alkyl groups and the said aromatic ring systems may in each case be substituted by one or more radicals R².

in the struktures according to formulae ( (I-1) to (I-52) at least one group R^{a} and/or R¹ is preferably represented by a group selected from formulae (R¹-1) to (R¹- 92) with the proviso that formulae (R¹-41) to (R¹- 44), (R¹-58) to (R¹- 61), (R¹-83) and (R¹-87) to (R¹- 92) are excluded for R¹: 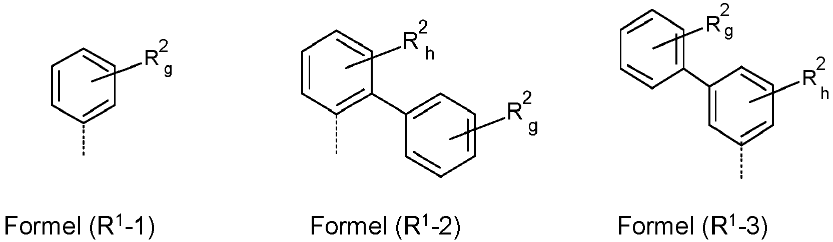 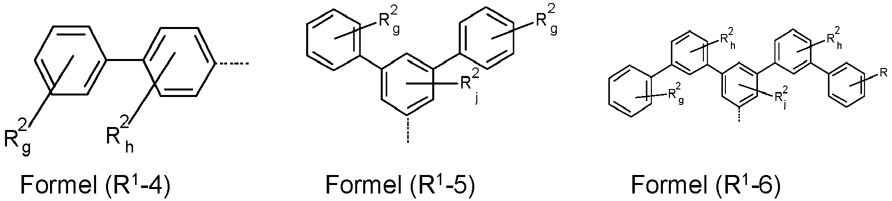 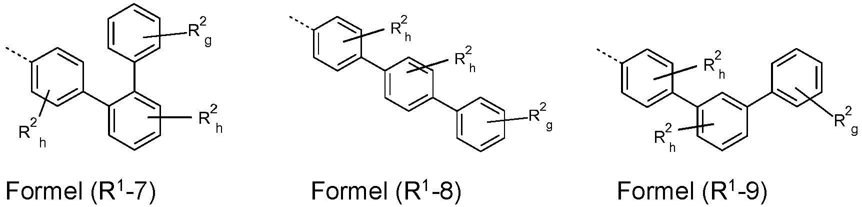 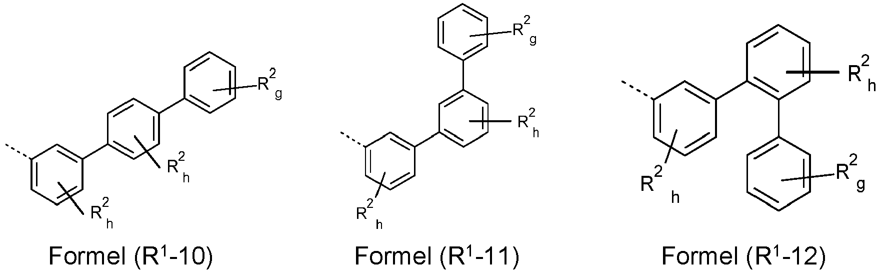 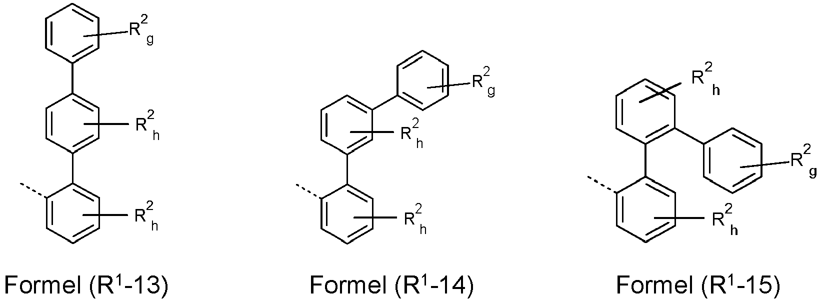 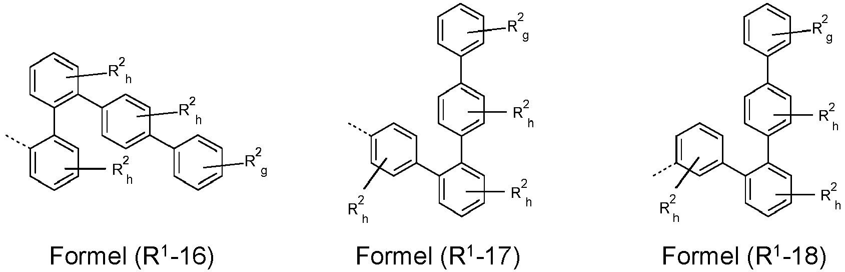 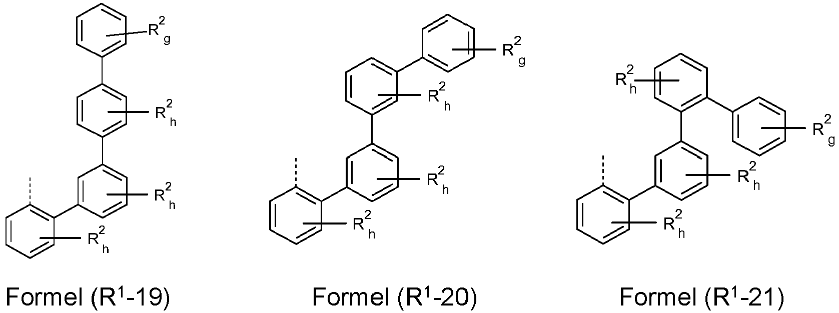 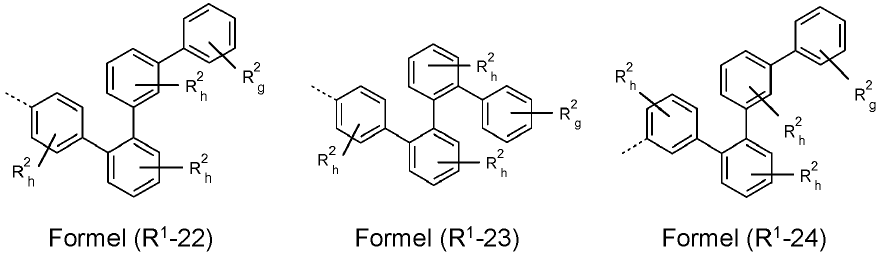 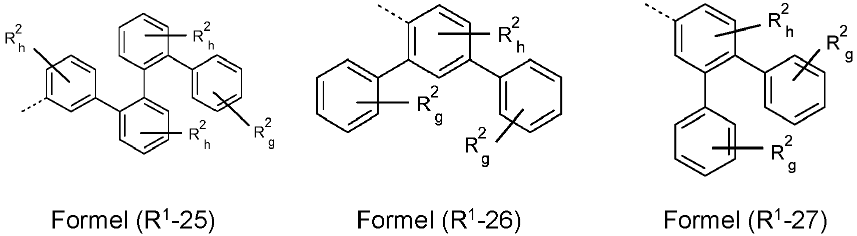 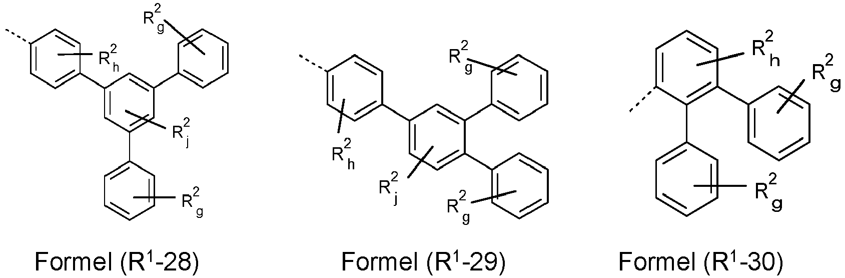 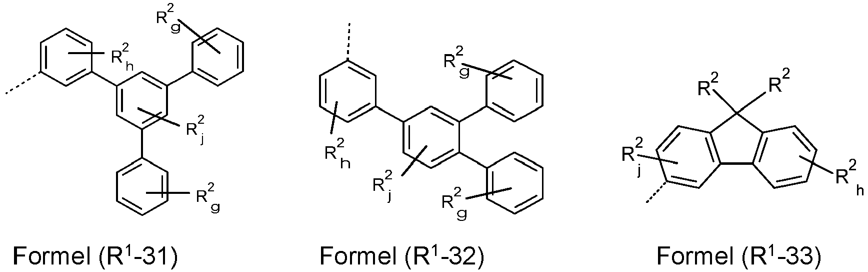 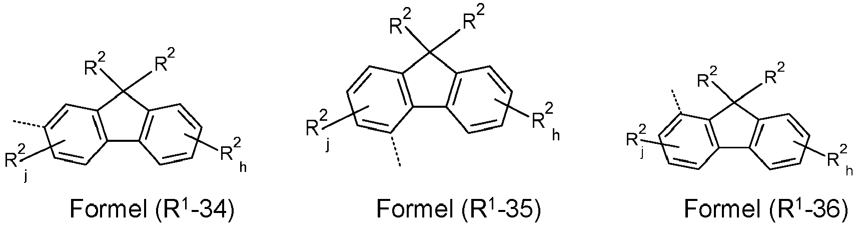 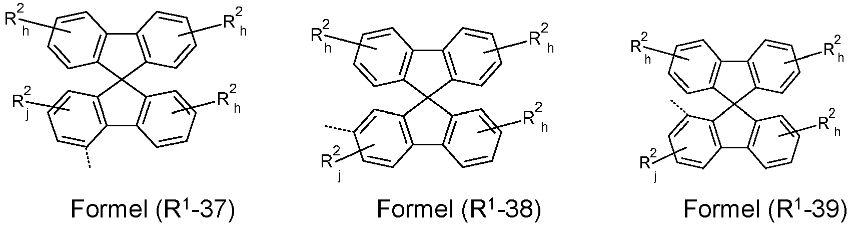 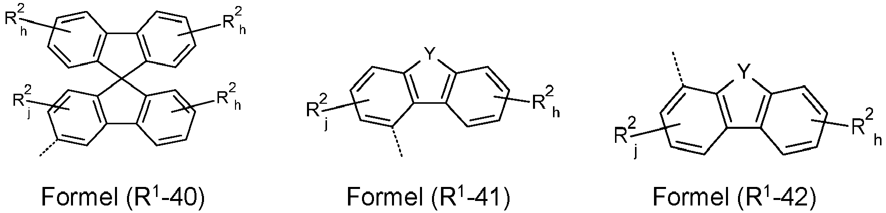 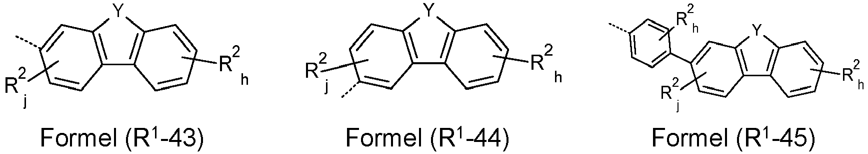 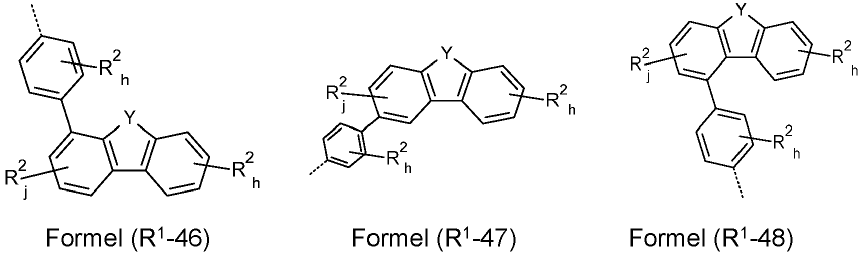 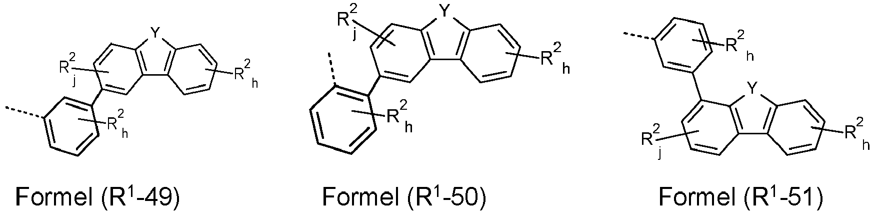 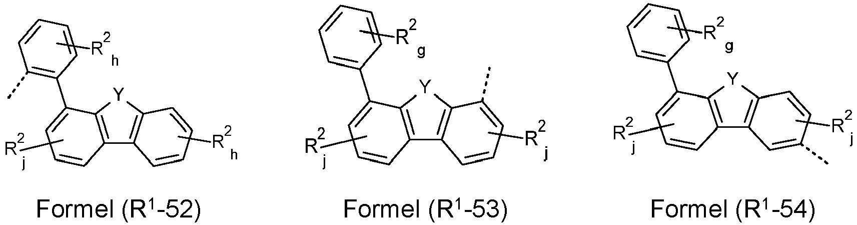 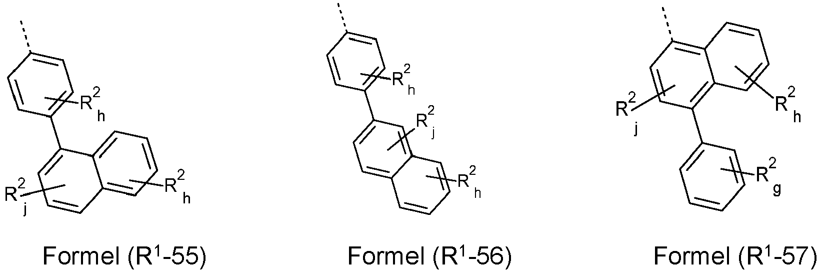 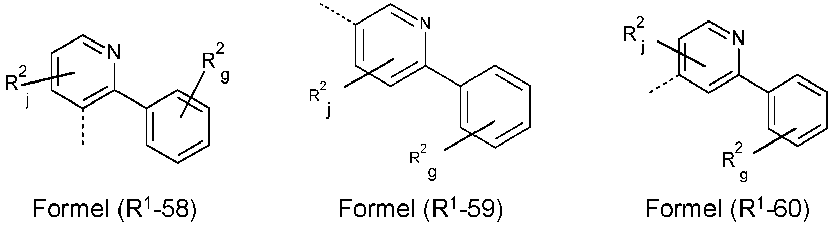 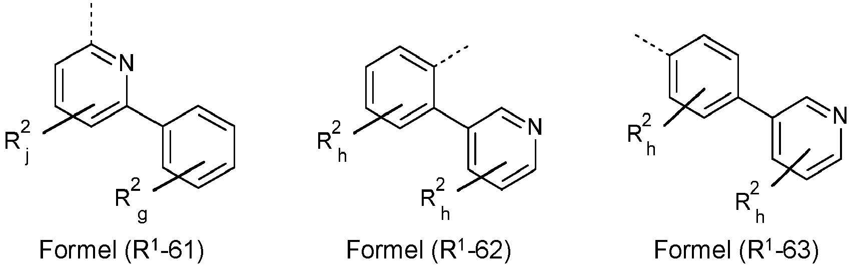 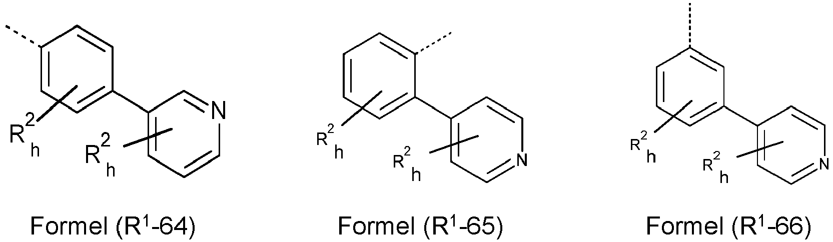 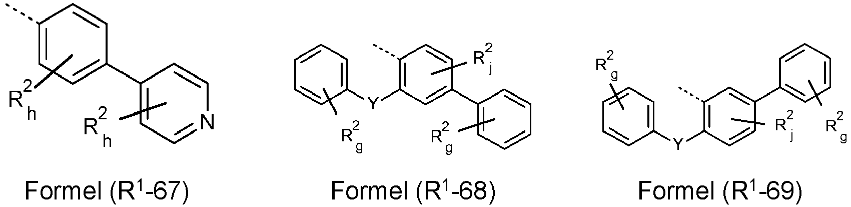 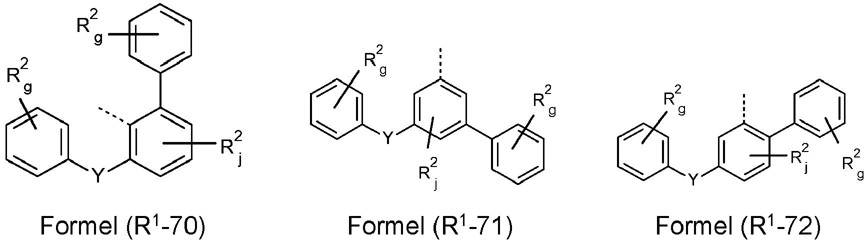 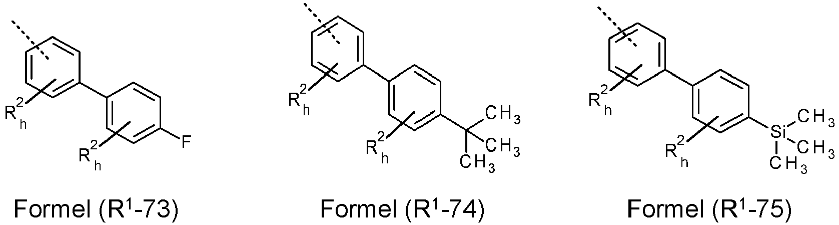 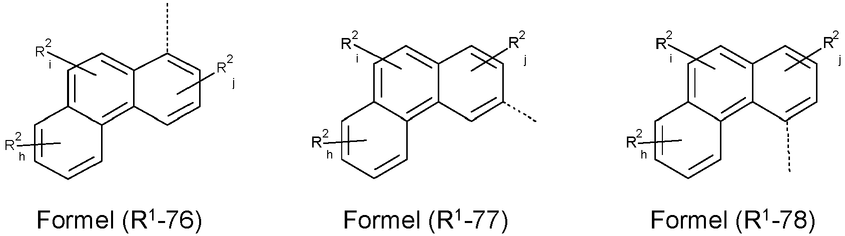 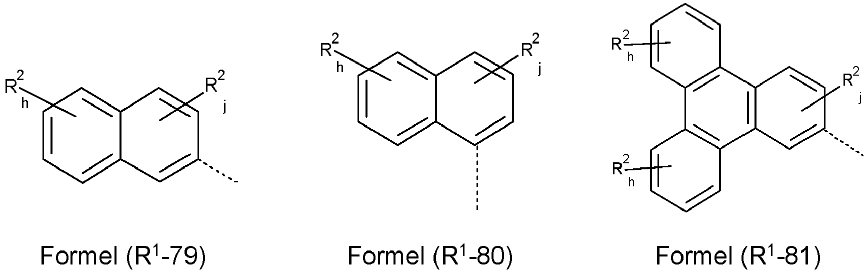 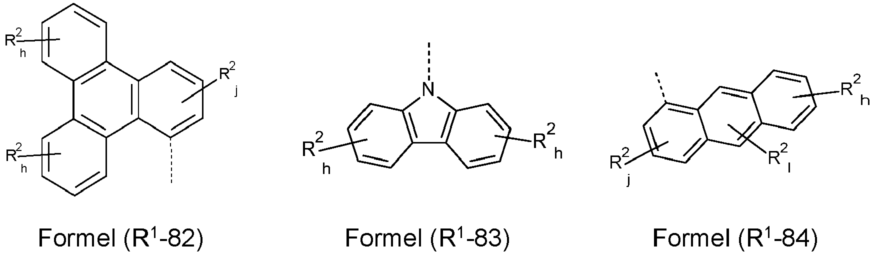 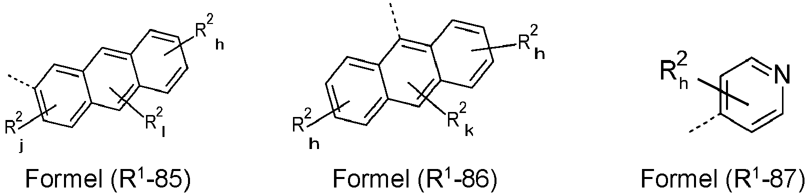 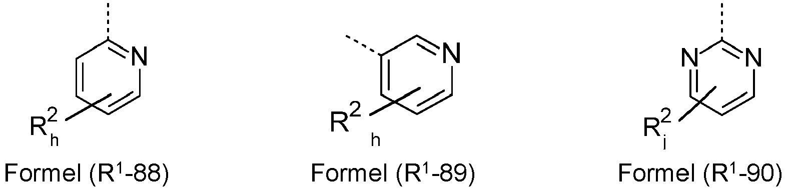 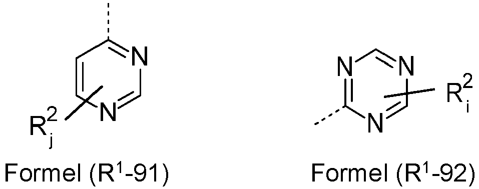 wherein the symbols have the following denotation:
- Y: is O, S or NR², preferably O oder S;
- k: is, identically or differently at each occurrence, 0 or 1;
- i: is, identically or differently at each occurrence, 0, 1 or 2;
- j: is, identically or differently at each occurrence, 0, 1, 2 or 3;
- h: is, identically or differently at each occurrence, 0, 1, 2, 3 or 4;
- g: is, identically or differently at each occurrence, 0, 1, 2, 3, 4 or 5; the dotted lines represents the bondings to the neigbouring groups; and
- R²: is as defined as above.

Preferably, the sum of the indices g, h, j, i and k in the structures of formulae (R¹-1) to (R¹-92) is at most 3, preferably at most 2 and more preferably at most 1.

The groups Ar¹ and Ar² as mentioned above and below may comprise residues R¹ as substituents. Preferably, the groups Ar¹ and Ar² as mentioned above are derived from structures of formulae (R¹-1) to (R¹-92) as mentioned above but having residues R¹ instead of R². The preferences as mentioned with regard to the structures of formulae (R¹-1) to (R¹-92) applies in an appropriate manner for the groups Ar¹ and Ar² as mentioned above and below.

R² preferably is, identically or differently on each occurrence, selected from H, D, F, CN, straight-chain alkyl groups having 1 to 20 C atoms, branched or cyclic alkyl groups having 3 to 20 C atoms, aromatic ring systems having 6 to 40 aromatic ring atoms, and heteroaromatic ring systems having 5 to 40 aromatic ring atoms; where two or more radicals R² may be connected to each other to form a ring; and where the said alkyl groups and the said aromatic and heteroaromatic ring systems may in each case be substituted by one or more radicals R³, but are preferably unsubstituted.

R² preferably is, identically or differently on each occurrence, selected from H, D, F, CN, straight-chain alkyl groups having 1 to 10 C atoms, branched or cyclic alkyl groups having 3 to 10 C atoms, aromatic ring systems having 6 to 24 aromatic ring atoms, and heteroaromatic ring systems having 5 to 24 aromatic ring atoms; where two or more radicals R² may be connected to each other to form a ring; and where the said alkyl groups and the said aromatic and heteroaromatic ring systems may in each case be substituted by one or more radicals R³, but are preferably unsubstituted. Most preferably, R² is H.

As mentioned above and below, two or more groups R^{a}, R¹, R², and/or R³ may form a ring. If two radicals, which can be selected in particular from R¹, R², R³, and / or R^{a}, form a ring with one another, this can be mono- or polycyclic, aliphatic, heteroaliphatic, aromatic or heteroaromatic. The residues which form a ring system with one another can be adjacent, i.e. that these radicals are attached to the same carbon atom or to carbon atoms which are directly bonded to one another, or they can be distant from one another.

In a preferred embodiment, two or more groups R^{a}, R¹, R², and/or R³ do not form an aromatic or heteroaromatic ring, especially in the structures of formulae (I-1) to (I-52), (L¹-1) to (L¹-36), (L¹-53) to (L¹-60), (L¹-71) to (L¹-108) and/or (R¹-1) to (R¹-92). In a preferred embodiment, two or more groups R^{a}, R¹, R², and/or R³ do not form a ring, especially in the structures of formulae (I-1) to (I-52), (L¹-1) to (L¹-36), (L¹-53) to (L¹-60), (L¹-71) to (L¹-108) and/or (R¹-1) to (R¹-92).

The compounds according to Formulae (I-1), (I-2), (I-3) or (I-4) having a substitution of the silafluorene group at 1-, 2- or 4-position are preferred over compounds having a substitution in 3 position of the silafluorene group.

In an embodiment of the present invention, compounds according to formulae (I-1), I-2), (I-3), (I-4) are preferred wherein at most 6, preferably at most 4, more preferably at most 2 of the groups X represent a group being different to CH and/or CD and wherein R^{a} is identical having the following features and/or residues:

| Ar¹, Ar² | R^{a} | L1 | preferably |
|---|---|---|---|
| R¹-1 to R¹-40, R¹-45 to R¹-57, R¹-62 to R¹-82, R¹-84 to R¹-86 | R¹-1 to R¹-92 | bond or L¹-1 to L¹-36, L¹-53 to L¹-60, L¹-71 to L¹-108 | L¹-1 to L¹-36, L¹-53 to L¹-60 |
| R¹-1 to R¹-4 | R¹-1 to R¹-92 | bond or L¹-1 to L¹-6 | bond |
| R¹-1 to R¹-40, R¹-45 to R¹-57, R¹-62 to R¹-82, R¹-84 to R¹-86 | R¹-1 to R¹-4, preferably R¹-1 | bond or L¹-1 to L¹-36, L¹-53 to L¹-60, L¹-71 to L¹-108 | L¹-1 to L¹-36, L¹-53 to L¹-60 |
| R¹-1 to R¹-4 | R¹-1 to R¹-4, preferably R¹-1 | bond or L¹-1 to L¹-6 | bond |

In an embodiment of the present invention, compounds according to formulae (I-1), I-2), (I-3), (I-4) are preferred wherein at most 6, preferably at most 4, more preferably at most 2 of the groups X represent a group being different to CH and/or CD and wherein R^{a} is identical having the following features and/or residues:

| Ar¹, Ar² | R^{a} (other) | L1 | preferably |
|---|---|---|---|
| R¹-1 to R¹-40, R¹-45 to R¹-57, R¹-62 to R¹-82. R¹-84 to R¹-86 | Alkyl group having 1 to 20 C-atoms | bond or L¹-1 to L¹-36, L¹-53 to L¹-60, L¹-71 to L¹-108 | L¹-1 to L¹-36, L¹-53 to L¹-60 |
| R¹-1 to R¹-4 | Alkyl group having 1 to 20 C-atoms | bond or L¹-1 to L¹-6 | bond |
| R¹-1 to R¹-40, R¹-45 to R¹-57, R¹-62 to R¹-82, R¹-84 to R¹-86 | Alkyl group having 1 to 4 C-atoms | bond or L¹-1 to L¹-36, L¹-53 to L¹-60, L¹-71 to L¹-108 | L¹-1 to L¹-36, L¹-53 to L¹-60 |
| R¹-1 to R¹-4 | Alkyl group having 1 to 4 C-atoms | bond or L¹-1 to L¹-6 | bond |

In an embodiment of the present invention, compounds according to formula (I-1), I-2), (I-3), (I-4) are preferred wherein at most 6, preferably at most 4, more preferably at most 2 of the groups X represent a group being different to CH and/or CD and wherein R^{a} is different and one R^{a} is an alkyl group having 1 to 20 C-atoms, preferably 1 to 4 C-atoms having the following features and/or residues:

| Ar¹, Ar² | R^{a} | L1 | preferably |
|---|---|---|---|
| R¹-1 to R¹-40, R¹-45 to R¹-57, R¹-62 to R¹-82, R¹-84 to R¹-86 | R¹-1 to R¹-92 | bond or L¹-1 to L¹-36, L¹-53 to L¹-60, L¹-71 to L¹-108 | L¹-1 to L¹-36, L¹-53 to L¹-60 |
| R¹-1 to R¹-4 | R¹-1 to R¹-92 | bond or L¹-1 to L¹-6 | bond |
| R¹-1 to R¹-40, R¹-45 to R¹-57, R¹-62 to R¹-82, R¹-84 to R¹-86 | R¹-1 to R¹-4, preferably R¹-1 | bond or L¹-1 to L¹-36, L¹-53 to L¹-60, L¹-71 to L¹-108 | L¹-1 to L¹-36, L¹-53 to L¹-60 |
| R¹-1 to R¹-4 | R¹-1 to R¹-4, preferably R¹-1 | bond or L¹-1 to L¹-6 | bond |

In an embodiment of the present invention, compounds according to formulae, (I-1), I-2), (I-3), (I-4) are preferred wherein at most 4, preferably at most 2, more preferably at most 1 of the groups X represent a group being different to CH and/or CD having the following features and/or residues:

| Ar¹ | Ar² | R^{a} | L¹ |
|---|---|---|---|
| R¹-1 to R¹-40, R¹-45 to R¹-57, R¹-62 to R¹-82, R¹-84 to R¹-86 | R¹-1 to R¹-40, R¹-45 to R¹-57, R¹-62 to R¹-82, R¹-84 to R¹-86 | R¹-1 to R¹-92 or Alkyl group having 1 to 20 C-atoms | bond or L¹-1 to L¹-36; L¹-53 to L¹-60, L¹-71 to L¹-108 |
| R¹-1 | R¹-1 | R¹-1 to R¹-92 or Alkyl group having 1 to 20 C-atoms | bond |
| R¹-1 | R¹-1 | R¹-1 to R¹-92 or Alkyl group having 1 to 20 C-atoms | L¹-1 |
| R¹-1 | R¹-1 | R¹-1 to R¹-92 or Alkyl group having 1 to 20 C-atoms | L¹-2 |
| R¹-1 | R¹-1 | R¹-1 to R¹-92 or Alkyl group having 1 to 20 C-atoms | L¹-3 |
| R¹-1 | R¹-1 | R¹-1 to R¹-92 or Alkyl group having 1 to 20 C-atoms | L¹-4 |
| R¹-2 | R¹-1 | R¹-1 to R¹-92 or Alkyl group having 1 to 20 C-atoms | bond |
| R¹-2 | R¹-1 | R¹-1 to R¹-92 or Alkyl group having 1 to 20 C-atoms | L¹-1 |
| R¹-2 | R¹-1 | R¹-1 to R¹-92 or Alkyl group having 1 to 20 C-atoms | L¹-2 |
| R¹-2 | R¹-1 | R¹-1 to R¹-92 or Alkyl group having 1 to 20 C-atoms | L¹-3 |
| R¹-2 | R¹-1 | R¹-1 to R¹-92 or Alkyl group having 1 to 20 C-atoms | L¹-4 |
| R¹-3 | R¹-1 | R¹-1 to R¹-92 or Alkyl group having 1 to 20 C-atoms | bond |
| R¹-3 | R¹-1 | R¹-1 to R¹-92 or Alkyl group having 1 to 20 C-atoms | L¹-1 |
| R¹-3 | R¹-1 | R¹-1 to R¹-92 or Alkyl group having 1 to 20 C-atoms | L¹-2 |
| R¹-3 | R¹-1 | R¹-1 to R¹-92 or Alkyl group having 1 to 20 C-atoms | L¹-3 |
| R¹-3 | R¹-1 | R¹-1 to R¹-92 or Alkyl group having 1 to 20 C-atoms | L¹-4 |
| R¹-4 | R¹-1 | R¹-1 to R¹-92 or Alkyl group having 1 to 20 C-atoms | bond |
| R¹-4 | R¹-1 | R¹-1 to R¹-92 or Alkyl group having 1 to 20 C-atoms | L¹-1 |
| R¹-4 | R¹-1 | R¹-1 to R¹-92 or Alkyl group having 1 to 20 C-atoms | L¹-2 |
| R¹-4 | R¹-1 | R¹-1 to R¹-92 or Alkyl group having 1 to 20 C-atoms | L¹-3 |
| R¹-4 | R¹-1 | R¹-1 to R¹-92 or Alkyl group having 1 to 20 C-atoms | L¹-4 |
| R¹-1 | R¹-1 | R¹-1 | bond or L¹-1 to L¹-36, L¹-53 to L¹-60, L ¹-71 to L¹-108 |
| R¹-1 | R¹-1 | Both R¹-1 | bond or L¹-1 to L¹-36, L¹-53 to L¹-60, L ¹-71 to L¹-108 |
| R¹-1 | R¹-1 | one R¹-1 other Alkyl group having 1 to 20 C-atoms | bond or L¹-1 to L¹-36, L¹-53 to L¹-60, L ¹-71 to L¹-108 |
| R¹-1 to R¹-40, R¹-45 to R¹-57, R¹-62 to R¹-82, R¹-84 to R¹-86 | R¹-1 | R¹-1 | bond |
| R¹-1 to R¹-40, R¹-45 to R¹-57, R¹-62 to R¹-82, R¹-84 to R¹-86 | R¹-1 | R¹-1 | L¹-1 |
| R¹-1 to R¹-40, R¹-45 to R¹-57, R¹-62 to R¹-82, R¹-84 to R¹-86 | R¹-1 | R¹-1 | L¹-92 |
| R¹-1 to R¹-40, R¹-45 to R¹-57, R¹-62 to R¹-82, R¹-84 to R¹-86 | R¹-1 | R¹-1 | L¹-93 |
| R¹-1 to 40, R¹-45 to R¹-57, R¹-62 to R¹-82, R¹-84 to R¹-86 92 | R¹-1 | R¹-1 | L¹-94 |
| R¹-1 to R¹-40, R¹-45 to R¹-57, R¹-62 to R¹-82, R¹-84 to R¹-86 | R¹-1 | Alkyl group having 1 to 20 C-atoms | bond |
| R¹-1 to R¹-40, R¹-45 to R¹-57, R¹-62 to R¹-82, R¹-84 to R¹-86 | R¹-1 | Alkyl group having 1 to 20 C-atoms | L¹-1 |
| R¹-1 to R¹-40, R¹-45 to R¹-57, R¹-62 to R¹-82, R¹-84 to R¹-86 | R¹-1 | Alkyl group having 1 to 20 C-atoms | L¹-92 |
| R¹-1 to R¹-40, R¹-45 to R¹-57, R¹-62 to R¹-82, R¹-84 to R¹-86 | R¹-1 | Alkyl group having 1 to 20 C-atoms | L¹-93 |
| R¹-1 to R¹-40, R¹-45 to R¹-57, R¹-62 to R¹-82, R¹-84 to R¹-86 | R¹-1 | Alkyl group having 1 to 20 C-atoms | L¹-94 |
| R¹-1 to R¹-40, R¹-45 to R¹-57, R¹-62 to R¹-82, R¹-84 to R¹-86 | R¹-1 | one R¹-1 other Alkyl group having 1 to 20 C-atoms | bond |
| R¹-1 to R¹-40, R¹-45 to R¹-57, R¹-62 to R¹-82, R¹-84 to R¹-86 | R¹-1 | one R¹-1 other Alkyl group having 1 to 20 C-atoms | L¹-1 |
| R¹-1 to R¹-40, R¹-45 to R¹-57, R¹-62 to R¹-82, R¹-84 to R¹-86 | R¹-1 | one R¹-1 other Alkyl group having 1 to 20 C-atoms | L¹-92 |
| R¹-1 to R¹-40, R¹-45 to R¹-57, R¹-62 to R¹-82, R¹-84 to R¹-86 | R¹-1 | one R¹-1 other Alkyl group having 1 to 20 C-atoms | L¹-93 |
| R¹-1 to R¹-40, R¹-45 to R¹-57, R¹-62 to R¹-82, R¹-84 to R¹-86 | R¹-1 | one R¹-1 other Alkyl group having 1 to 20 C-atoms | L¹-94 |

Preferred compounds according to formulae (I-1), (I-2), (I-3) or (I-4) are shown in the following:

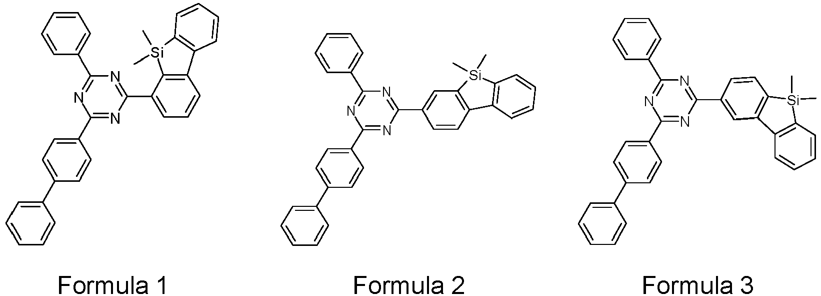

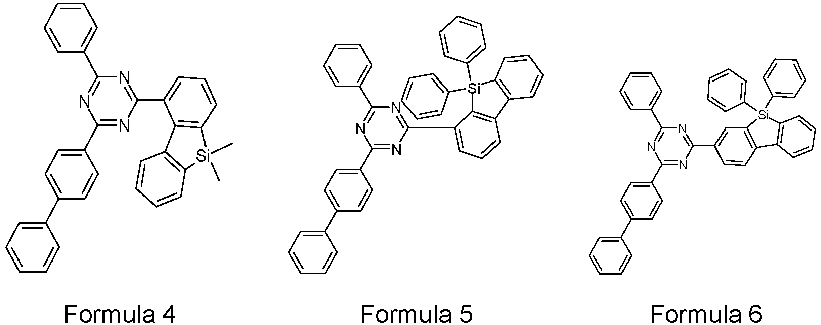

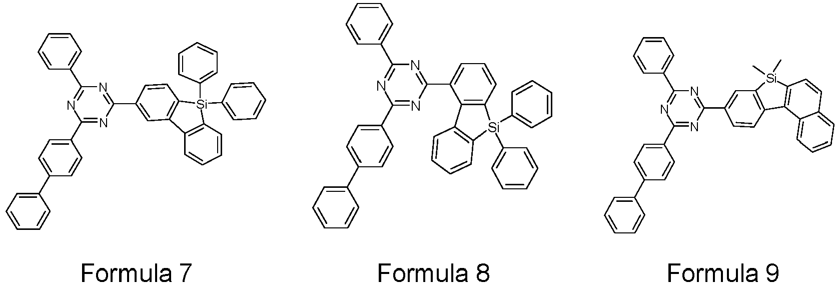

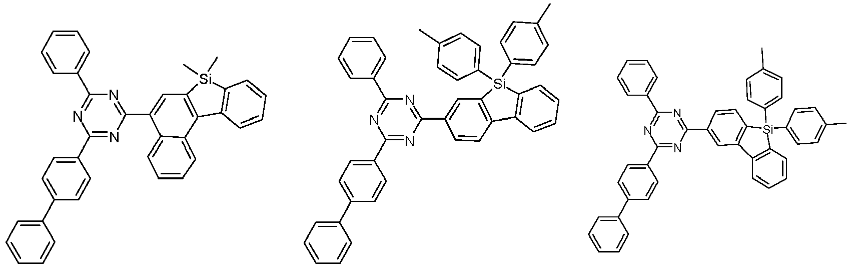

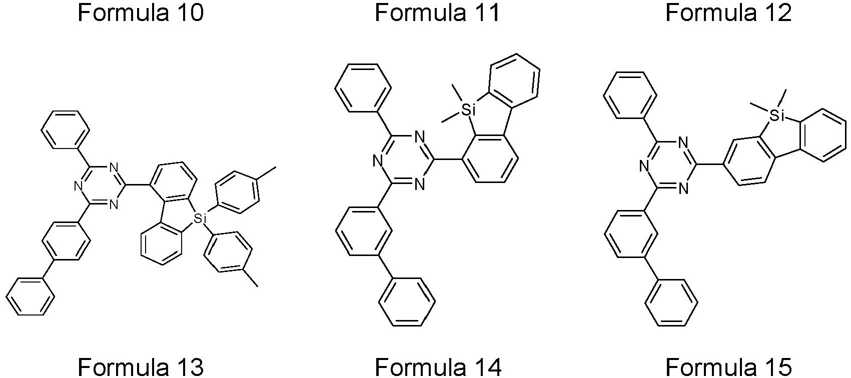

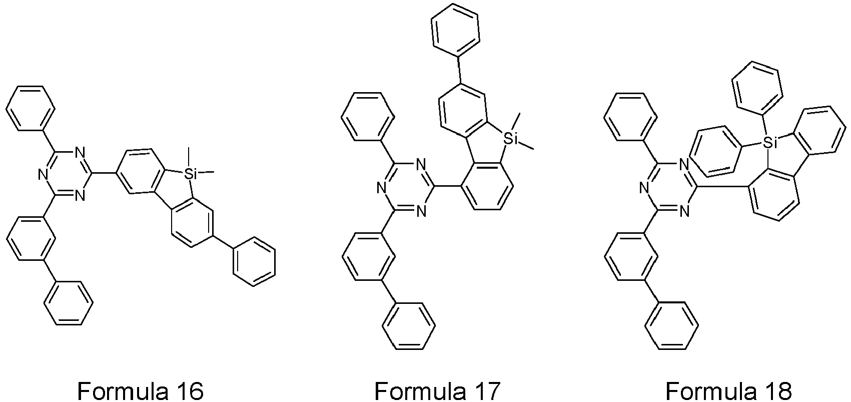

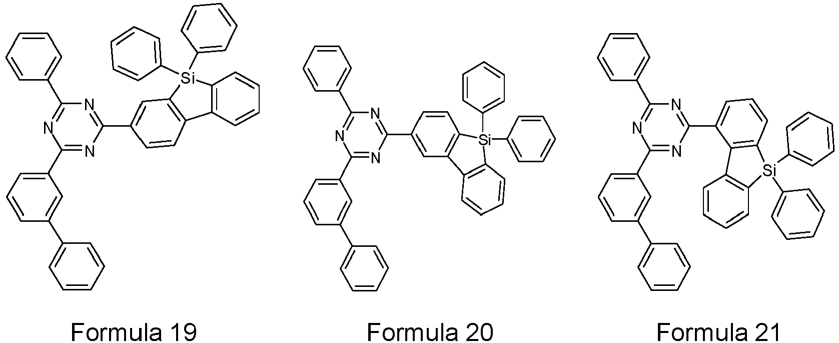

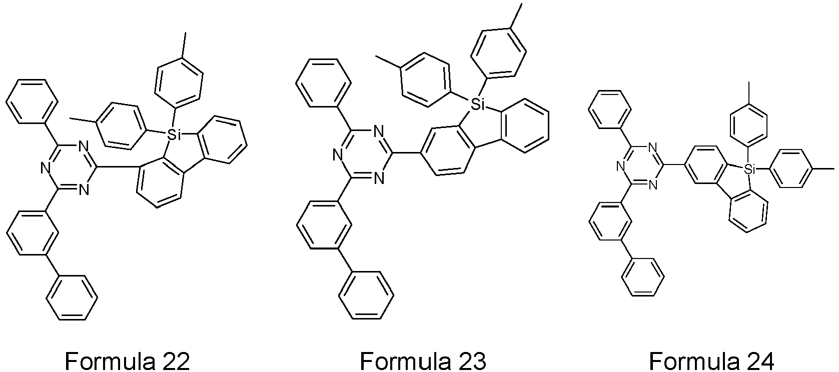

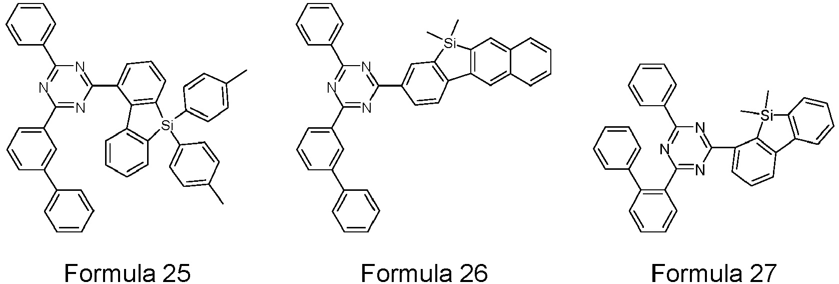

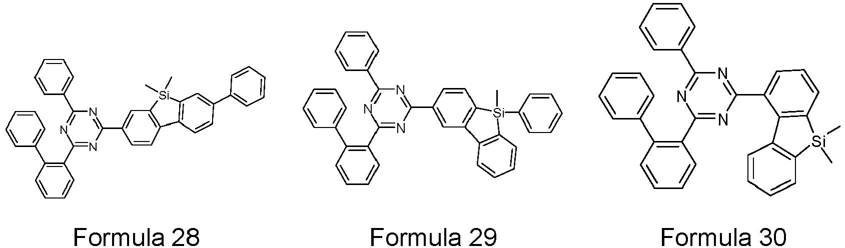

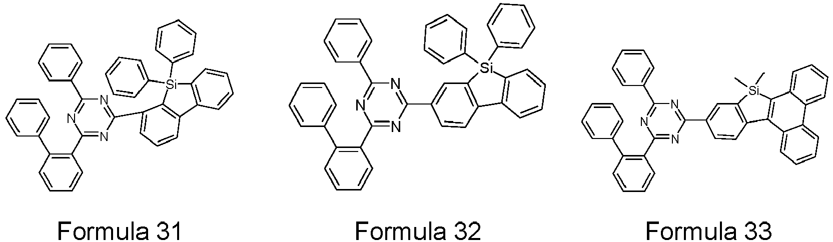

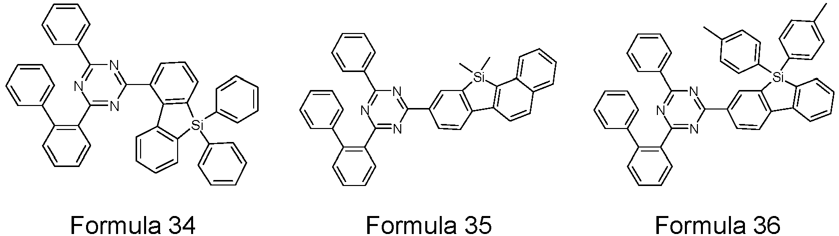

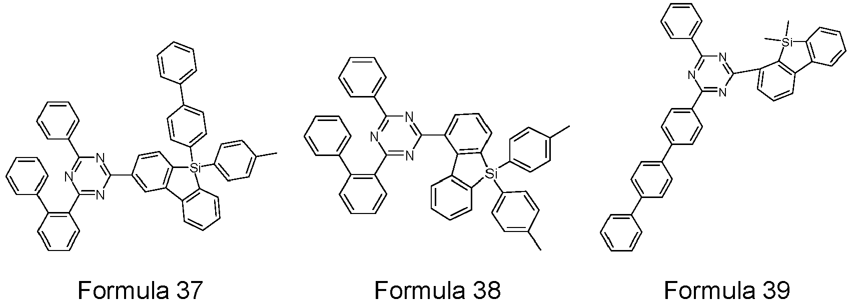

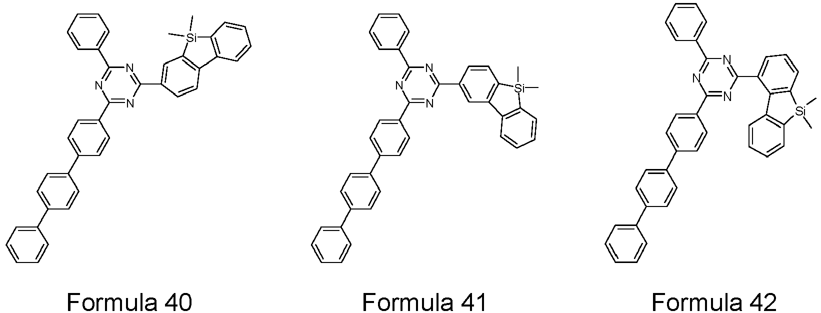

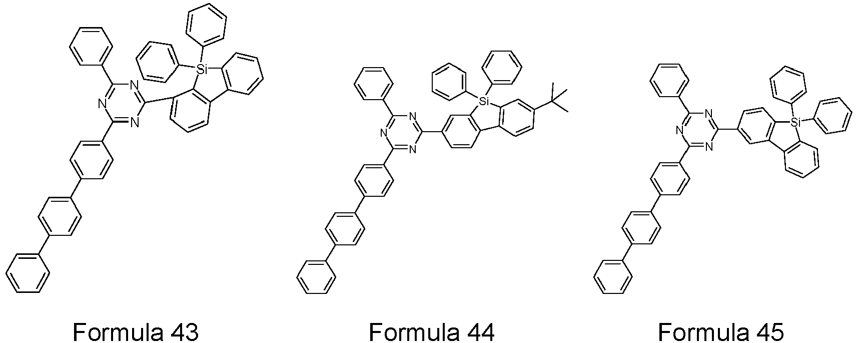

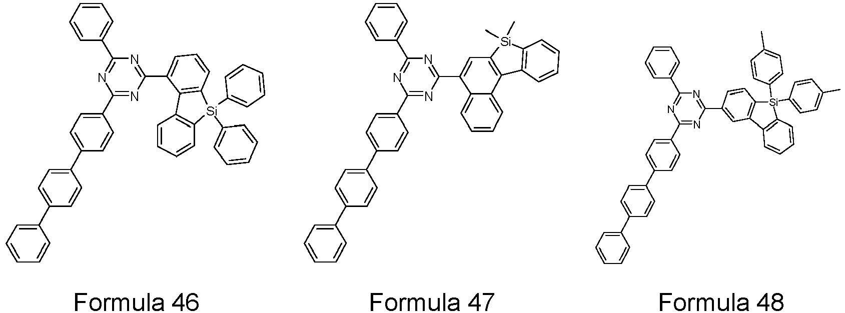

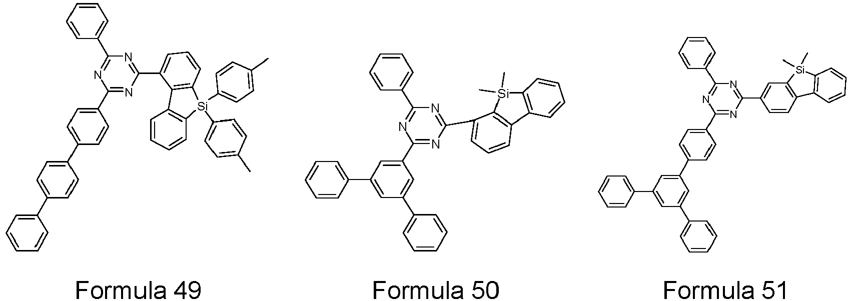

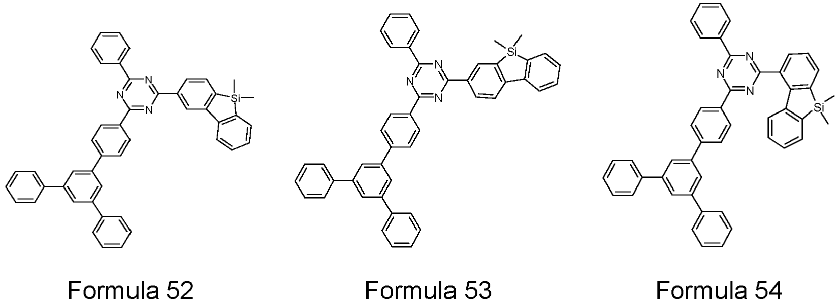

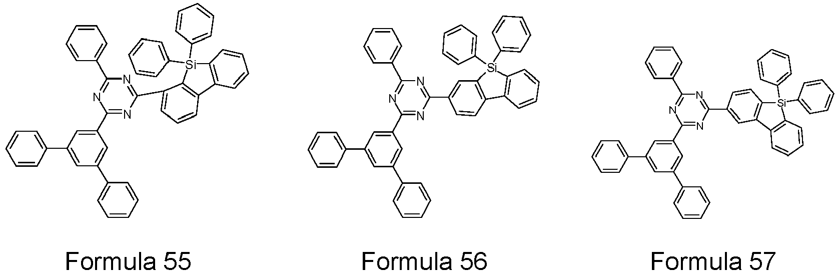

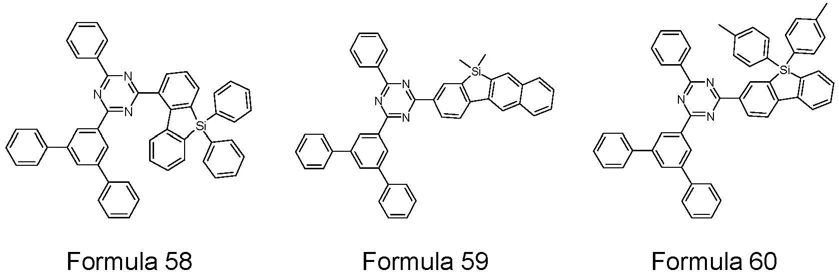

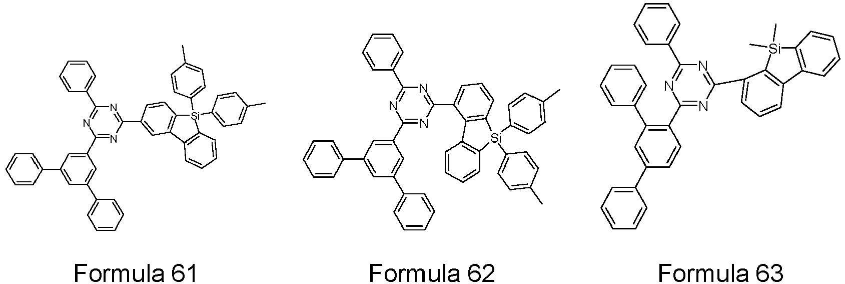

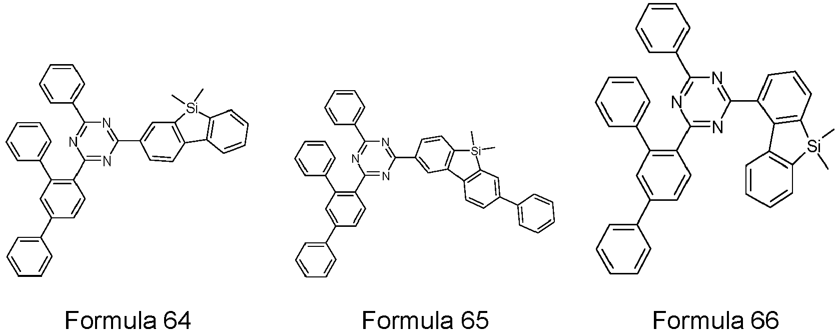

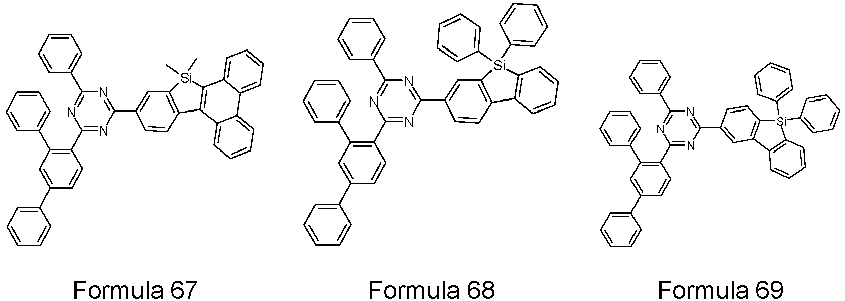

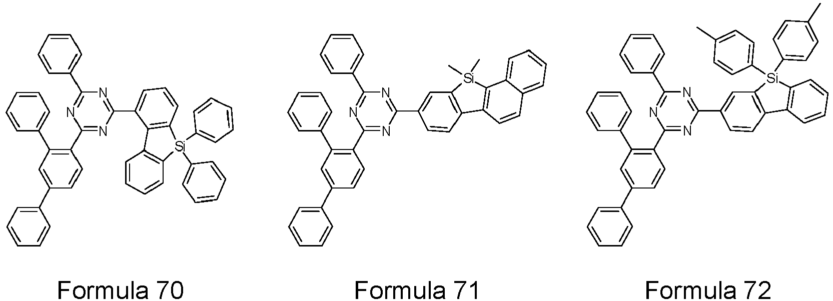

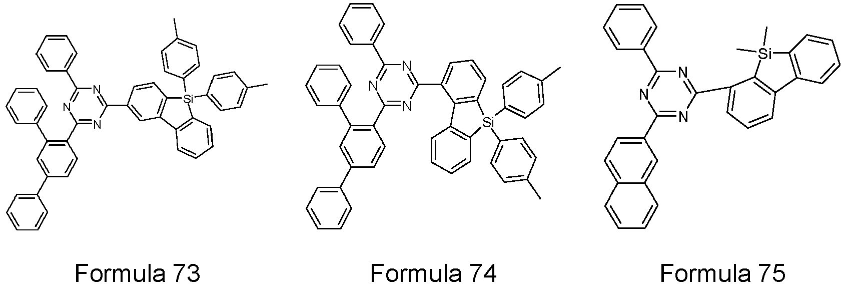

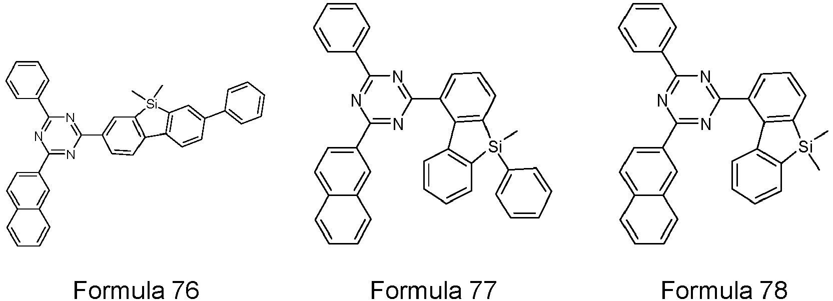

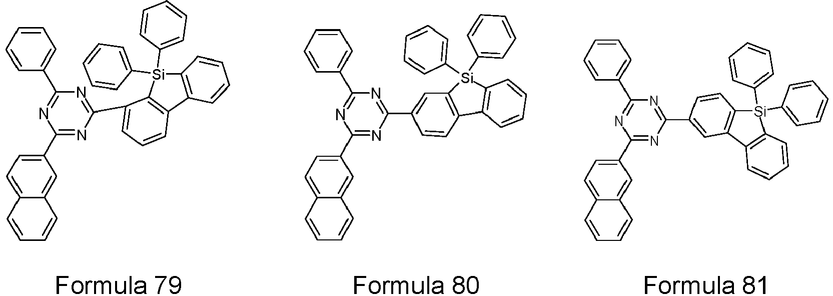

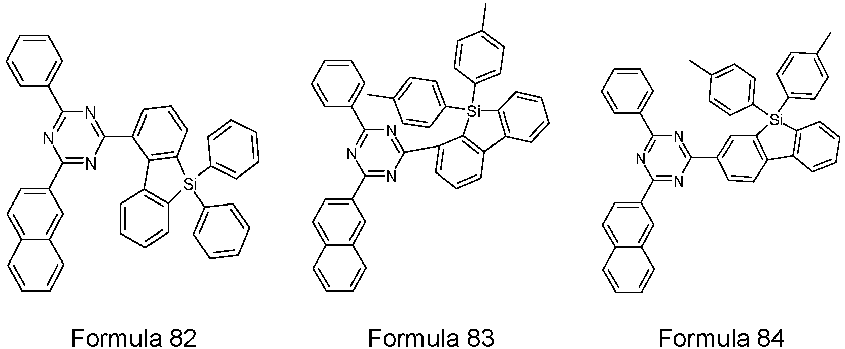

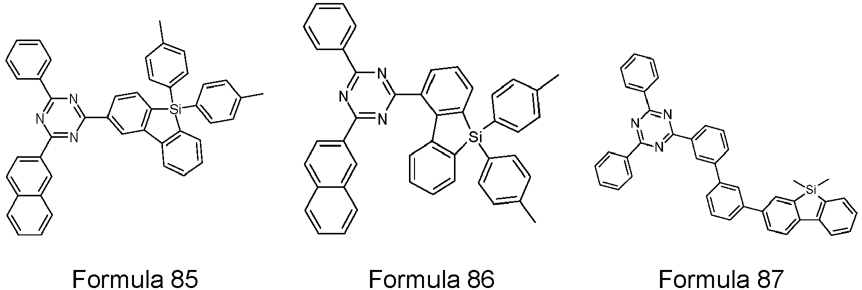

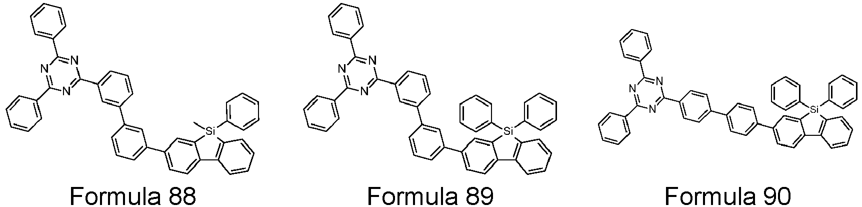

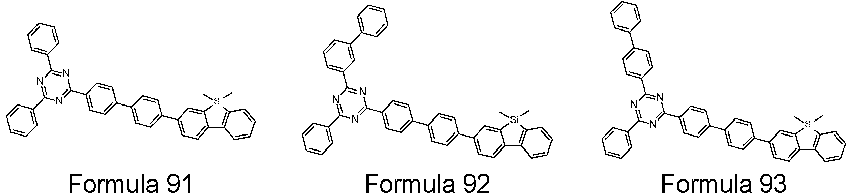

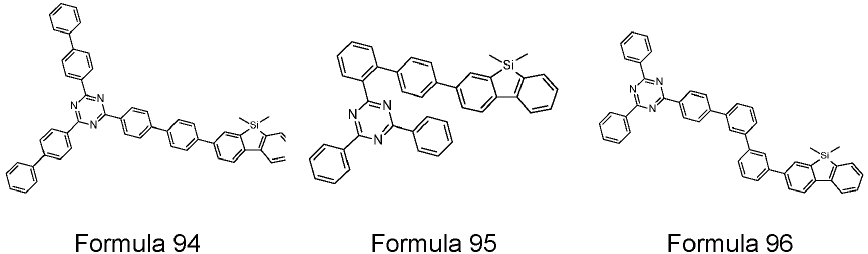

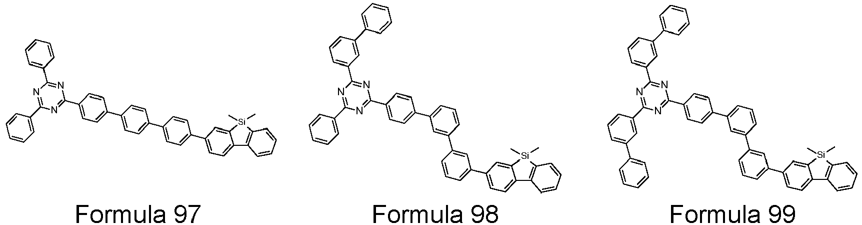

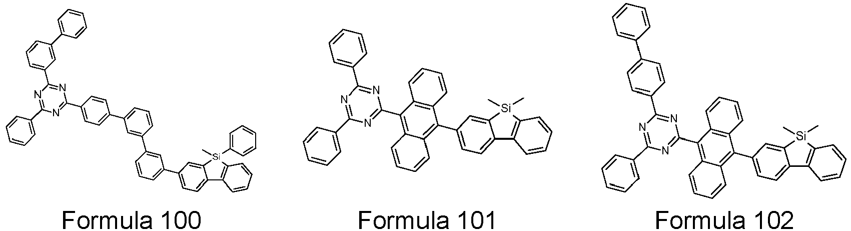

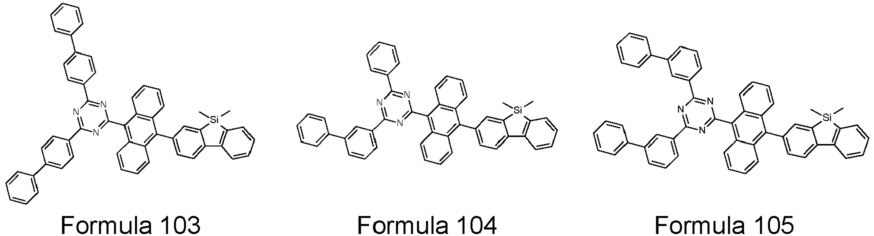

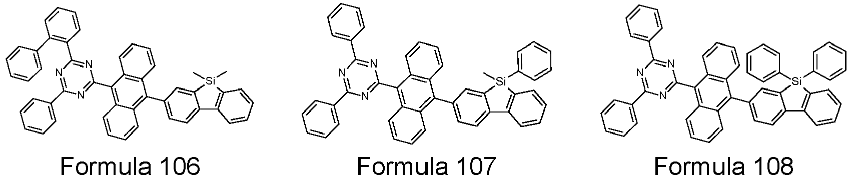

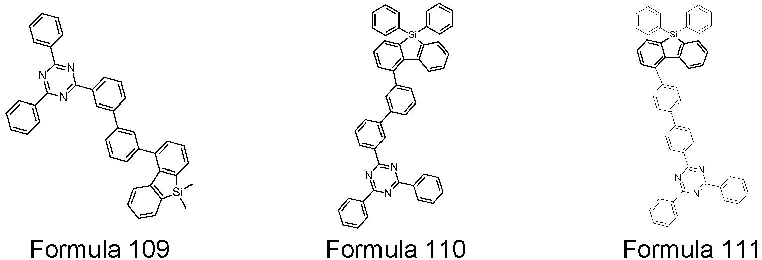

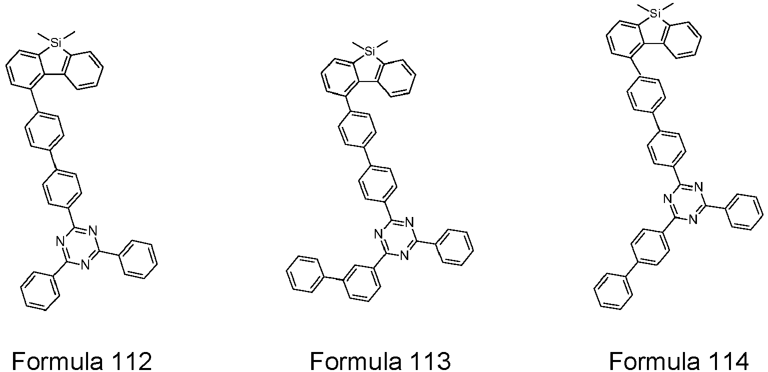

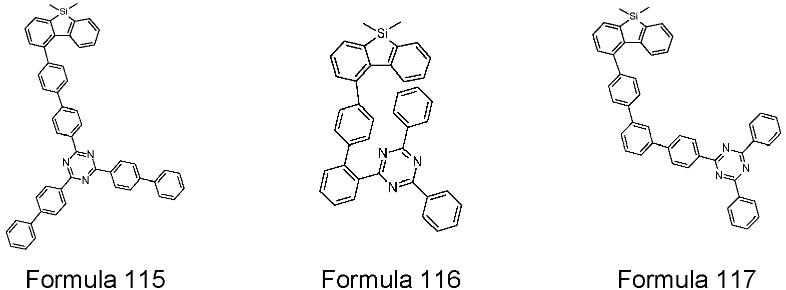

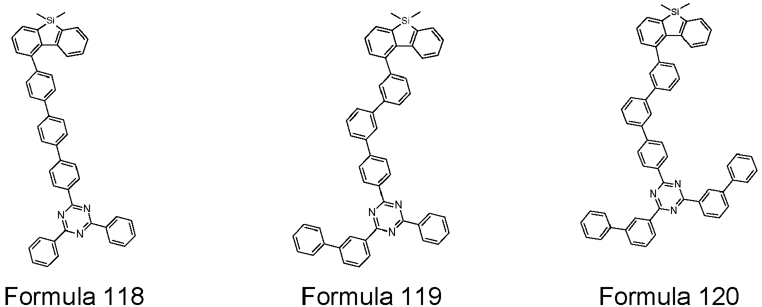

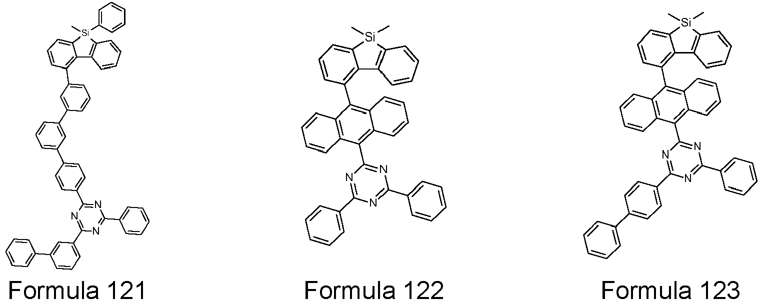

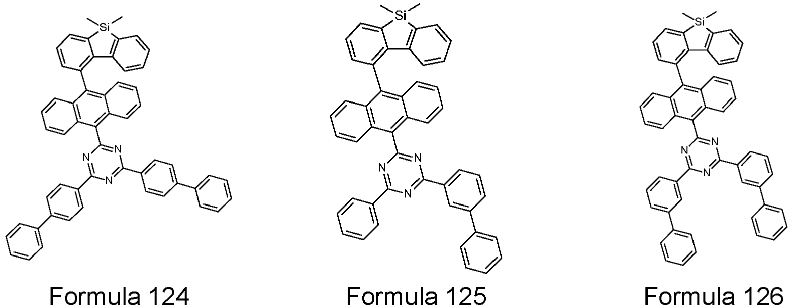

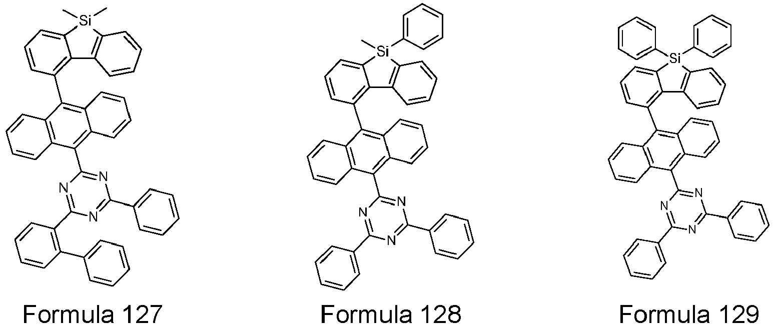

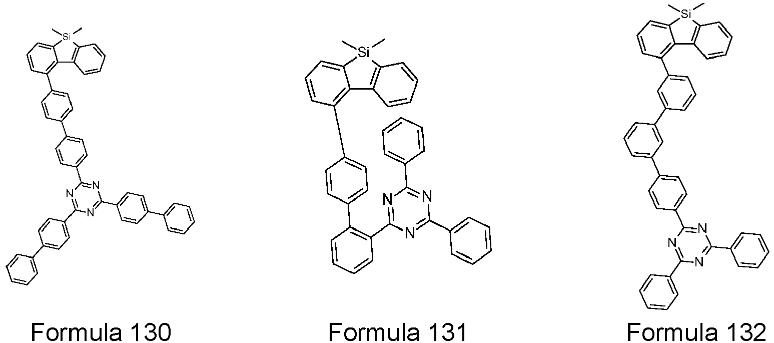

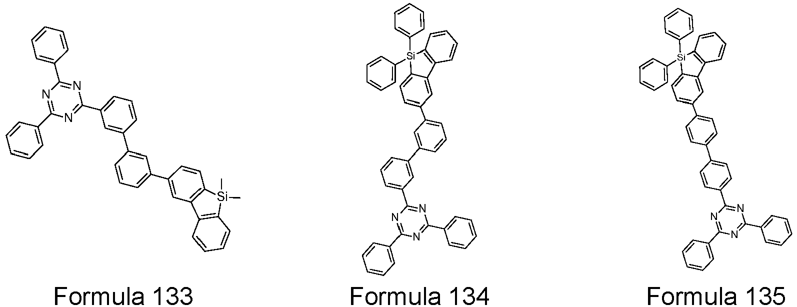

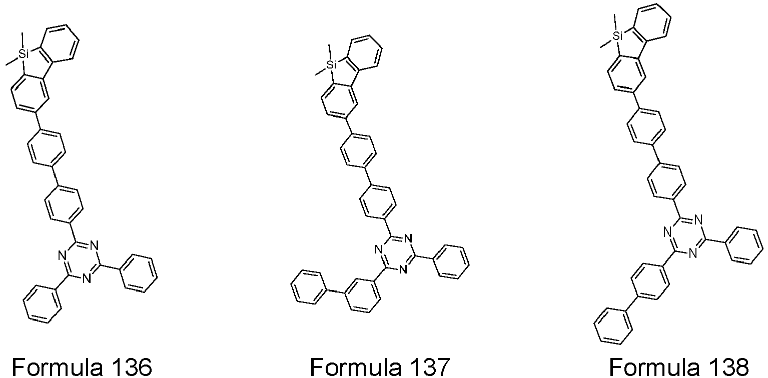

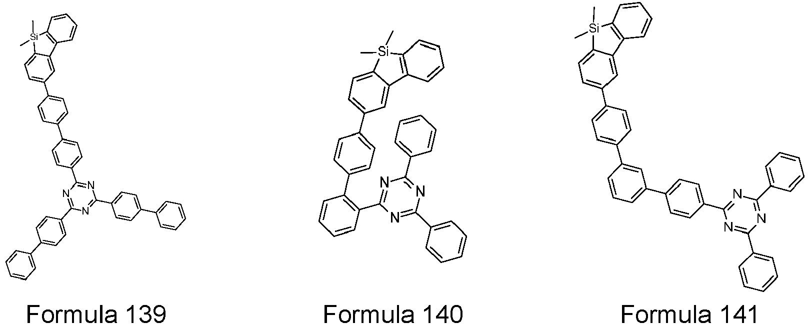

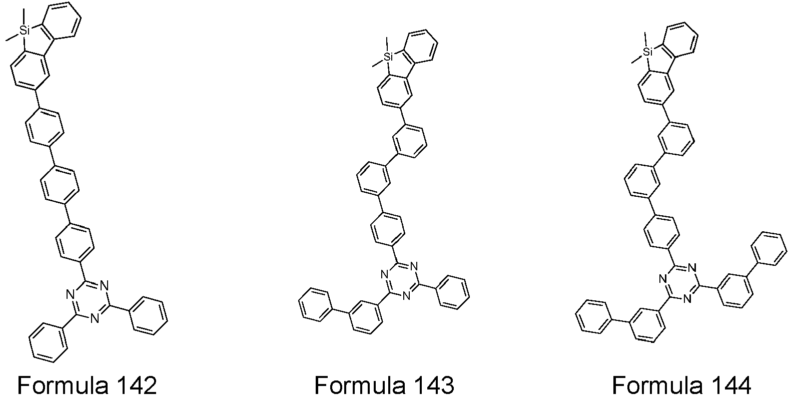

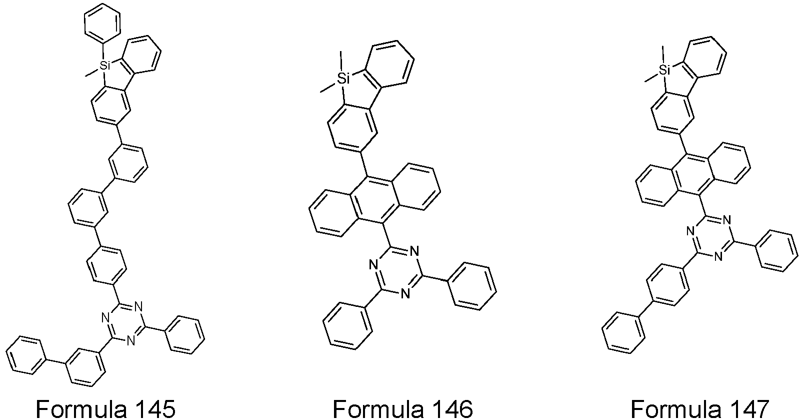

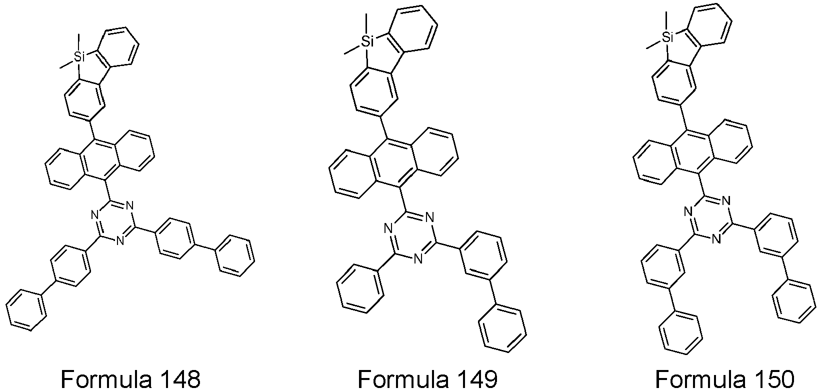

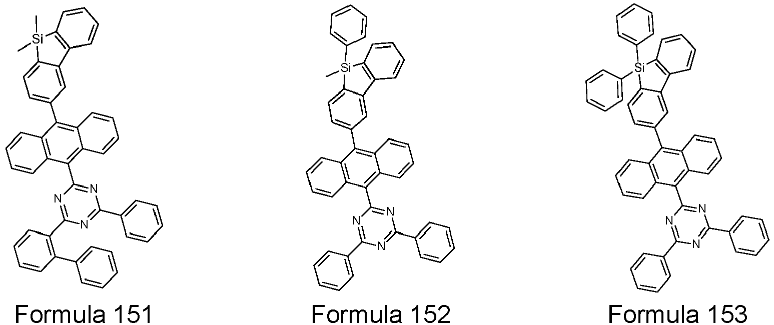

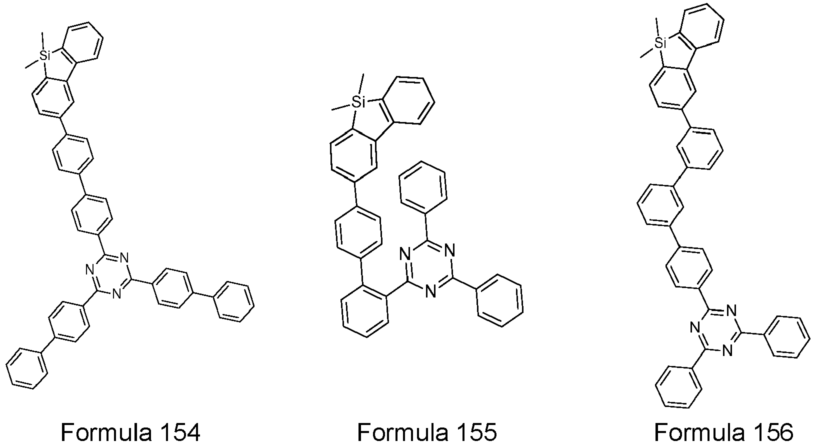

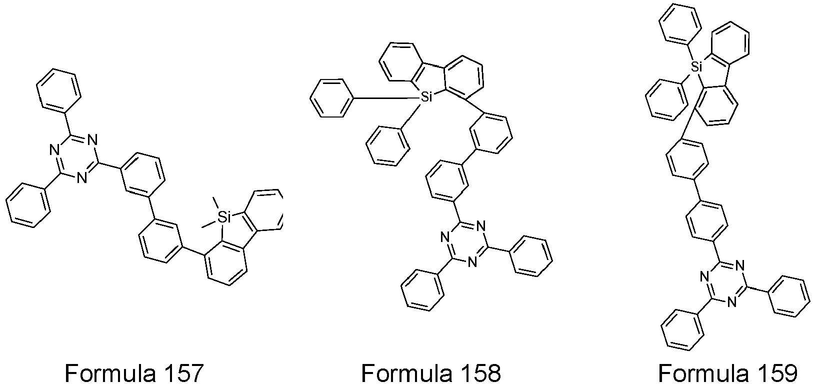

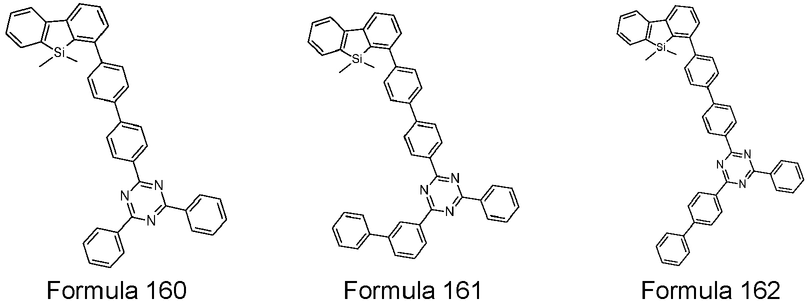

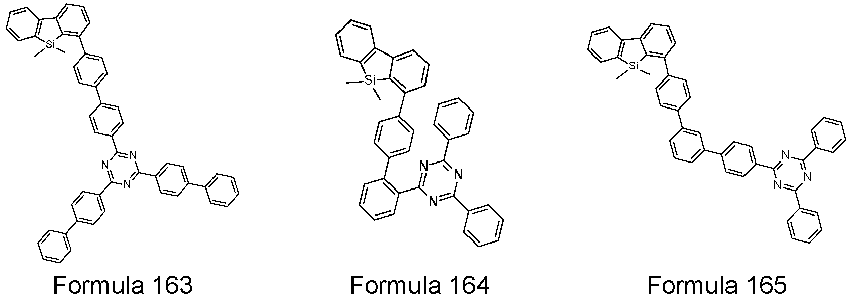

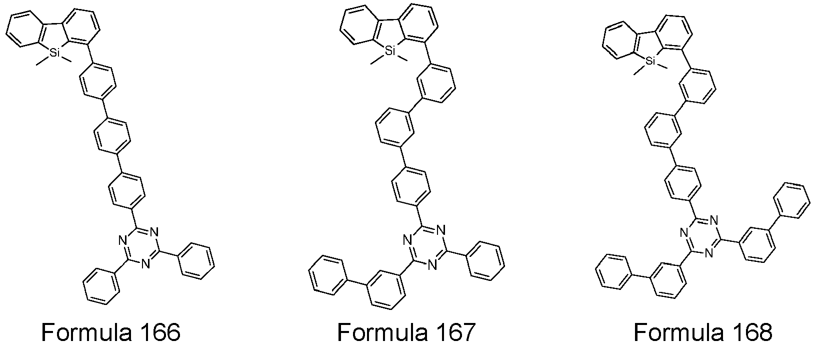

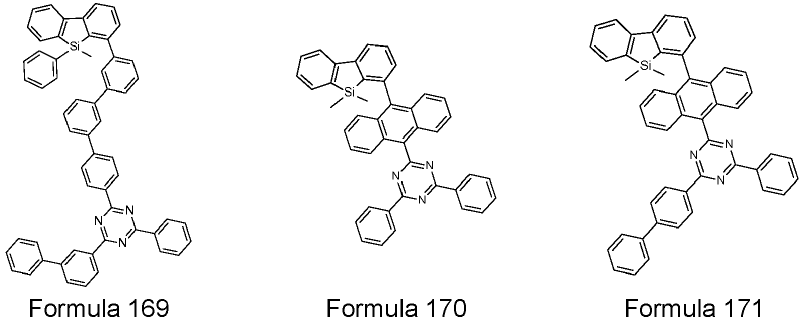

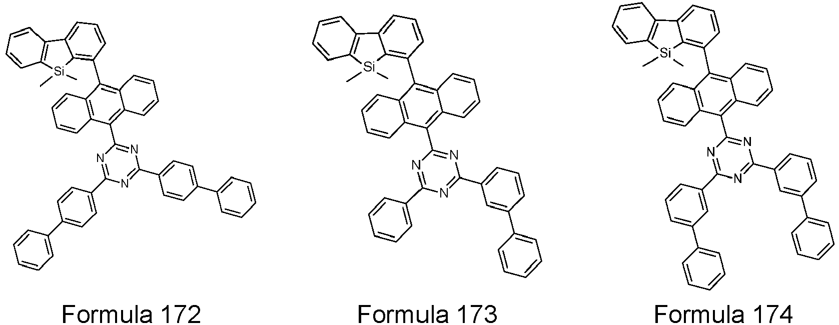

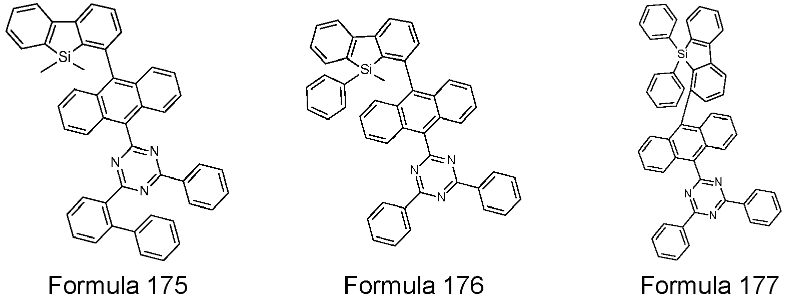

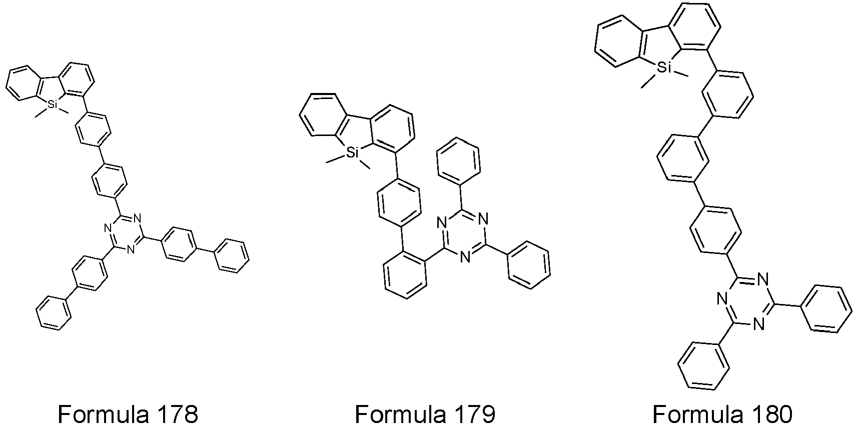

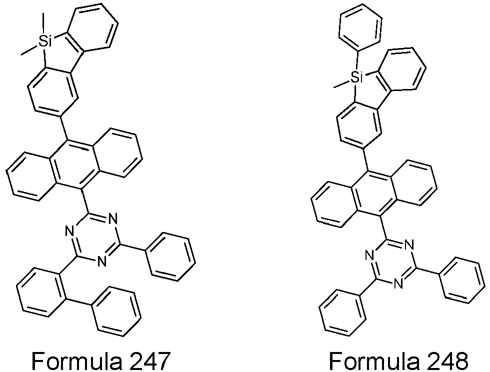

The compounds according to formulae (I-1), (I-2), (I-3) or (I-4) can be prepared by standard reactions of synthetic organic chemistry, such as transition metal catalyzed coupling reactions, preferably BUCHWALD, SUZUKI, YAMAMOTO, STILLE, HECK, NEGISHI, SONOGASHIRA and HIYAMA couplings.

A preferred procedure for synthesis of compounds according to formula (I-1) is shown in Scheme 1.

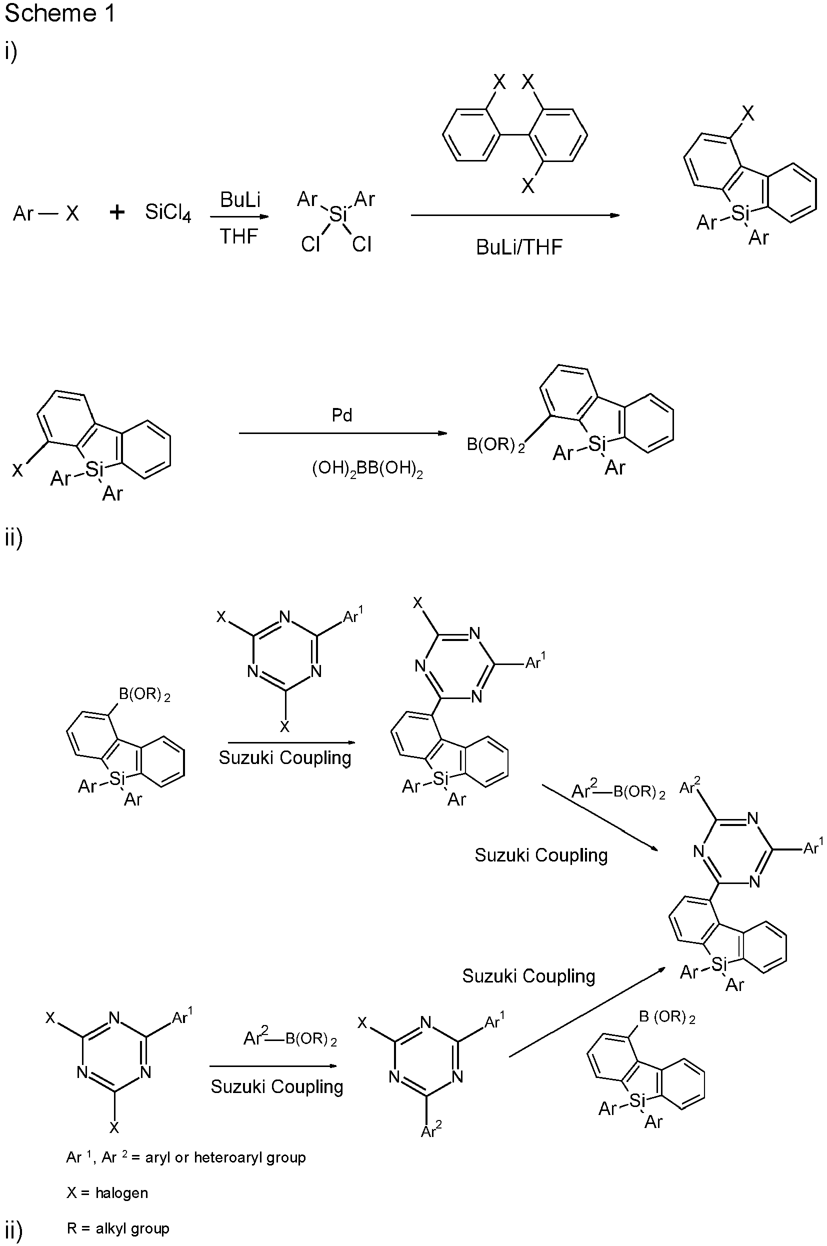

In a first step, a bis-chlorinated diarylsilane is prepared. This intermediate is then reacted with a trishalogenated biphenyl derivative, to yield a 4-halogenated silafluorene. Preferably, this step is performed by bis-lithiiation of the tris-halogenated biphenyl derivative with BuLi, followed by addition of the bis-chlorinated diarylsilane, to form the ring of the silafluorene. A silafluorene which is halogenated in the 4-position is formed in this step. The halogen atom in the 4-position is transformed to a organoboron species.

This compound is then coupled to a triazine group in a further Suzuki reaction.

In an alternative reaction, the 4-halogenated silafluorene is first coupled with an aryl group in a Suzuki reaction, and then undergoes a second Suzuki reaction with a triazine. By this method, silafluorene derivatives which have an triazine group which is coupled via an arylene linker in the 4-position of the silafluorene can be prepared.

A preferred procedure for synthesis of compounds according to formula (I-4) in which the amine group is attached to the 1-position of the sila-fluorenyl basic structure, is shown in Scheme 2.

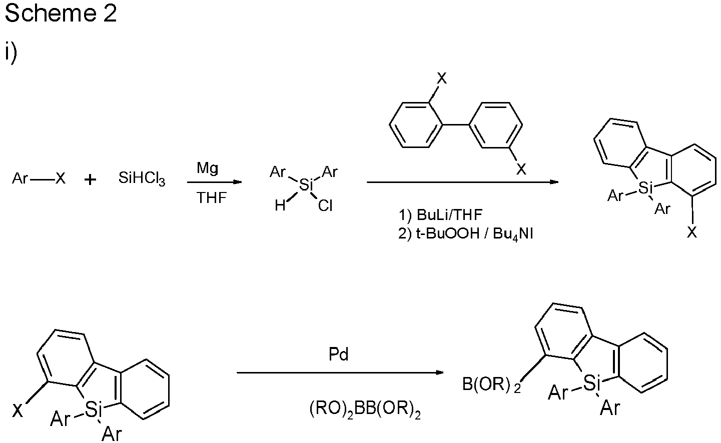

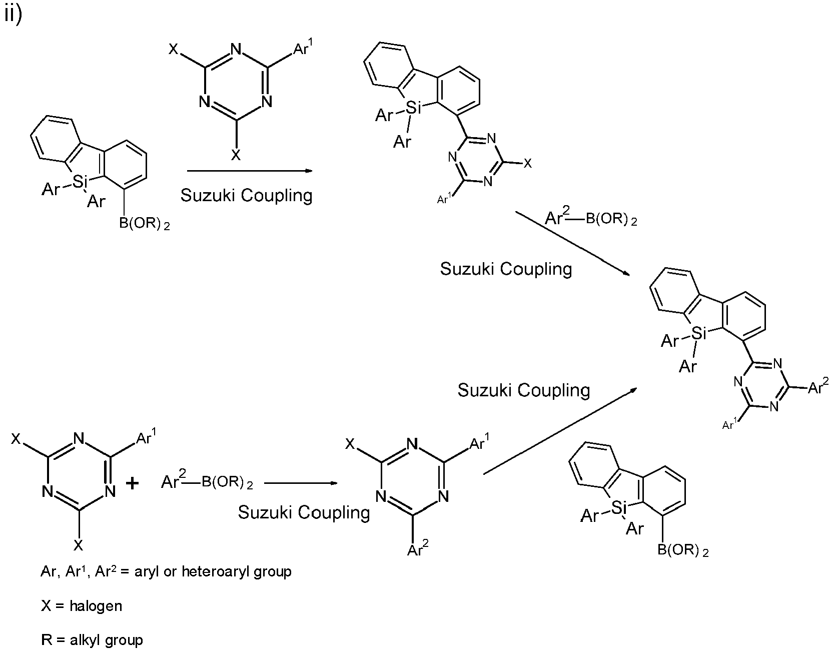

In a first step, a mono-chlorinated diarylsilane is prepared. This intermediate is then reacted with a bis-halogenated biphenyl derivative, to yield a 1-halogenated diphenylsilafluorene. Preferably, this step is performed by lithiiation of the bis-halogenated biphenyl derivative with BuLi, followed by addition of the mono-chlorinated diarylsilane, followed by ring closure reaction under treatment with hydroperoxide and tetrabutylammonium iodide. The halogen atom in the 1-position is transformed to a organoboron species. The organo boron group can preferably comprise a ring structure.

This compound is then coupled to a triazine group in a Suzuki reaction.

In an alternative reaction, the 1-halogenated silafluorene is first coupled with an aryl group in a Suzuki reaction, and then undergoes a second Suzuki reaction with a triazine. By this method, silafluorene derivatives which have an triazine group which is coupled via an arylene linker in the 1-position of the silafluorene can be prepared.

A further embodiment of the present invention is therefore a process for preparation of a compound according to formulae (I-1), (I-2), (I-3) and (I-4) characterized in that a mono- or dihalogenated silyl derivative is reacted with a halogenated biphenyl group to a silafluorene derivative.

Preferably, the silyl derivative is dihalogenated. Furthermore preferably, the biphenyl group is tris-halogenated. Furthermore preferably, the resulting silafluorene derivative has a halogen atom, preferably Cl, Br or I, in a position selected from 1-, 2-, 3- and 4-position, preferably 1-, 2- and 4-position, more preferably 1- and 4-position, where the 4-position is preferred over the 1-position.

Compounds having a substitution in 2- and/or 3-position can be obtained in a similar manner as mentioned above.

The compounds according to the invention described above, in particular compounds which are substituted by reactive leaving groups, such as fluorine, chlorine, bromine, iodine, tosylate, triflate, boronic acid or boronic acid ester, can be used as monomers for the preparation of corresponding oligomers, dendrimers or polymers. The oligomerisation or polymerisation here is preferably carried out via the halogen functionality or the boronic acid functionality.

The invention therefore furthermore relates to oligomers, polymers or dendrimers comprising one or more compounds of the formulae (I-1), (I-2), (I-3) or (I-4) where the bond(s) to the polymer, oligomer or dendrimer may be localised at any desired positions in formulae (I-1), (I-2), (I-3) or (I-4) substituted by R^{a}, R¹, R² or R³. Depending on the linking of the compound of the formulae (I-1), (I-2), (I-3) or (I-4) the compound is part of a side chain of the oligomer or polymer or part of the main chain. An oligomer in the sense of this invention is taken to mean a compound which is built up from at least three monomer units. A polymer in the sense of the invention is taken to mean a compound which is built up from at least ten monomer units. The polymers, oligomers or dendrimers according to the invention may be conjugated, partially conjugated or non-conjugated. The oligomers or polymers according to the invention may be linear, branched or dendritic. In the structures linked in a linear manner, the units of the formulae (I-1), (I-2), (I-3) or (I-4) may be linked directly to one another or linked to one another via a divalent group, for example via a substituted or unsubstituted alkylene group, via a heteroatom or via a divalent aromatic or heteroaromatic group. In branched and dendritic structures, three or more units of the formulae (I-1), (I-2), (I-3) or (I-4) may, for example, be linked via a trivalent or polyvalent group, for example via a trivalent or polyvalent aromatic or heteroaromatic group, to give a branched or dendritic oligomer or polymer. The same preferences as described above for compounds of the formulae (I-1), (I-2), (I-3) or (I-4) apply to the recurring units of the formula (I-1), (I-2), (I-3) or (I-4) in oligomers, dendrimers and polymers.

For the preparation of the oligomers or polymers, the monomers according to the invention are homopolymerised or copolymerised with further monomers. Suitable and preferred comonomers are selected from fluorenes (for example in accordance with EP 842208 or WO 00/22026), spirobifluorenes (for example in accordance with EP 707020, EP 894107 or WO 06/061181), para-phenylenes (for example in accordance with WO 92/18552), carbazoles (for example in accordance with WO 04/070772 or WO 04/113468), thiophenes (for example in accordance with EP 1028136), dihydrophenanthrenes (for example in accordance with WO 05/014689 or WO 07/006383), cis- and trans-indenofluorenes (for example in accordance with WO 04/041901 or WO 04/113412), ketones (for example in accordance with WO 05/040302), phenanthrenes (for example in accordance with WO 05/104264 or WO 07/017066) or also a plurality of these units. The polymers, oligomers and dendrimers usually also contain further units, for example emitting (fluorescent or phosphorescent) units, such as, for example, vinyltriarylamines (for example in accordance with WO 07/068325) or phosphorescent metal complexes (for example in accordance with WO 06/003000), and/or charge-transport units, in particular those based on triarylamines.

The polymers and oligomers according to the invention are generally prepared by polymerisation of one or more types of monomer, at least one monomer of which results in recurring units of the formulae (I-1), (I-2), (I-3) or (I-4) in the polymer. Suitable polymerisation reactions are known to the person skilled in the art and are described in the literature. Particularly suitable and preferred polymerisation reactions which result in C-C or C-N links are the following:
(A) SUZUKI polymerisation;
(B) YAMAMOTO polymerisation;
(C) STILLE polymerisation; and
(D) HARTWIG-BUCHWALD polymerisation
(E) GRIGNARD polymerisation.

The way in which the polymerisation can be carried out by these methods and the way in which the polymers can then be separated off from the reaction medium and purified is known to the person skilled in the art and is described in detail in the literature, for example in WO 2003/048225, WO 2004/037887 and WO 2004/037887.

The present invention thus also relates to a process for the preparation of the polymers, oligomers and dendrimers according to the invention, which is characterised in that they are prepared by SUZUKI polymerisation, YAMAMOTO polymerisation, STILLE polymerisation or HARTWIG-BUCHWALD polymerisation. The dendrimers according to the invention can be prepared by processes known to the person skilled in the art or analogously thereto. Suitable processes are described in the literature, such as, for example, in Frechet, Jean M. J.; Hawker, Craig J., "Hyperbranched polyphenylene and hyperbranched polyesters: new soluble, three-dimensional, reactive polymers", Reactive & Functional Polymers (1995), 26(1-3), 127-36; Janssen, H. M.; Meijer, E. W., "The synthesis and characterization of dendritic molecules", Materials Science and Technology (1999), 20 (Synthesis of Polymers), 403-458; Tomalia, Donald A., "Dendrimer molecules", Scientific American (1995), 272(5), 62-6; WO 02/067343 A1 and WO 2005/026144 A1.

The compounds according to the invention are suitable for use in an electronic device. An electronic device here is taken to mean a device which comprises at least one layer which comprises at least one organic compound. However, the component here may also comprise inorganic materials or also layers built up entirely from inorganic materials.

The present invention therefore furthermore relates to the use of the compounds according to the invention in an electronic device, in particular in an organic electroluminescent device.

The present invention still furthermore relates to an electronic device comprising at least one compound according to the invention. The preferences stated above likewise apply to the electronic devices.

The electronic device is preferably selected from the group consisting of organic electroluminescent devices (organic light-emitting diodes, OLEDs), organic integrated circuits (O-ICs), organic field-effect transistors (O-FETs), organic thin-film transistors (O-TFTs), organic light-emitting transistors (O-LETs), organic solar cells (O-SCs), organic dye-sensitised solar cells (ODSSCs), organic optical detectors, organic photoreceptors, organic field-quench devices (O-FQDs), light-emitting electrochemical cells (LECs), organic laser diodes (O-lasers) and organic plasmon emitting devices, but preferably organic electroluminescent devices (OLEDs).

The organic electroluminescent devices and the light-emitting electrochemical cells can be employed for various applications, for example for monochromatic or polychromatic displays, for lighting applications or for medical and/or cosmetic applications, for example in phototherapy.

The organic electroluminescent device comprises a cathode, an anode and at least one emitting layer. Apart from these layers, it may also comprise further layers, for example in each case one or more hole-injection layers, hole-transport layers, hole-blocking layers, electron-transport layers, electron-injection layers, exciton-blocking layers, electron-blocking layers and/or charge-generation layers. Interlayers, which have, for example, an exciton-blocking function, may likewise be introduced between two emitting layers. However, it should be pointed out that each of these layers does not necessarily have to be present.

The organic electroluminescent device here may comprise one emitting layer or a plurality of emitting layers. If a plurality of emission layers is present, these preferably have in total a plurality of emission maxima between 380 nm and 750 nm, resulting overall in white emission, i.e. various emitting compounds which are able to fluoresce or phosphoresce are used in the emitting layers. Particular preference is given to systems having three emitting layers, where the three layers exhibit blue, green and orange or red emission (for the basic structure see, for example, WO 2005/011013). It is possible here for all emitting layers to be fluorescent or for all emitting layers to be phosphorescent or for one or more emitting layers to be fluorescent and one or more other layers to be phosphorescent.

The compound according to the invention in accordance with the embodiments indicated above can be employed here in different layers, depending on the precise structure. Preference is given to an organic electroluminescent device comprising a compound of the formulae (I-1), (I-2), (I-3) or (I-4) or the preferred embodiments as electron-transport material in a electron-transport or electron-injection or hole-blocking layer or as matrix material for fluorescent or phosphorescent emitters, in particular for phosphorescent emitters. The preferred embodiments indicated above also apply to the use of the materials in organic electronic devices.

In a preferred embodiment of the invention, the compound of the formulae (I-1), (I-2), (I-3) or (I-4) or the preferred embodiments is employed as electron-transport or electron-injection material in a electron-transport or electron-injection layer. The emitting layer here can be fluorescent or phosphorescent. A electron-injection layer in the sense of the present invention is a layer which is directly adjacent to the cathode. A electron-transport layer in the sense of the present invention is a layer which is located between a electron-injection layer and an emitting layer.

In still a further preferred embodiment of the invention, the compound of the formulae (I-1), (I-2), (I-3) or (I-4) or the preferred embodiments is employed in an host material in emissive layer. An host material is taken to mean a layer which is directly adjacent to an emitting material in emitting layer.

The compound of the formulae (I-1), (I-2), (I-3) or (I-4) or the preferred embodiments is particularly preferably employed in a electron-transport or hole-blocking layer.

If the compound of the formulae (I-1), (I-2), (I-3) or (I-4) is employed as a electron-transport material in a electron-transport layer, a electron-injection layer or an hole-blocking layer, then the compound of formulae (I-1), (I-2), (I-3) or (I-4) can be used in such a layer as a single material, i.e. in a proportion of 100%, or the compound of formulae (I-1), (I-2), (I-3) or (I-4) can be used in combination with one or more further compounds in such a layer. Preferably, those further compounds are selected from typical electron transport compounds which are known in the art.

According to a preferred embodiment, the organic layer comprising the compound of formulae (I-1), (I-2), (I-3) or (I-4) additionally comprises one or more p-dopants. Preferred p-dopant for the present invention are organic compounds that can accept electrons (electron acceptors) and can oxidize one or more of the other compounds present in the mixture.

Particularly preferred embodiments of p-dopants are described in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709, US 2010/0096600, WO 2012/095143 and DE 102012209523.

Particularly preferred as p-dopants are quinodimethane compounds, azaindenofluorendione, azaphenalene, azatriphenylene, I₂, metal halides, preferably transition metal halides, metal oxides, preferably metal oxides containing at least one transition metal or a metal of the 3rd main group and transition metal complexes, preferably complexes of Cu, Co, Ni , Pd and Pt with ligands containing at least one oxygen atom as binding site. Also preferred are transition metal oxides as dopants, preferably oxides of rhenium, molybdenum and tungsten, particularly preferably Re₂O₇, MoOs, WOs and ReOs.

The p-dopants are preferably distributed substantially uniformly in the p-doped layers. This can be achieved for example by co-evaporation of the p-dopant and of the hole-transport material matrix.

Particularly preferred p-dopants are selected from the compounds (D-1) to (D-13):

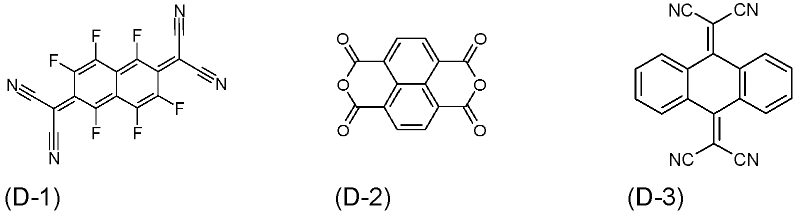

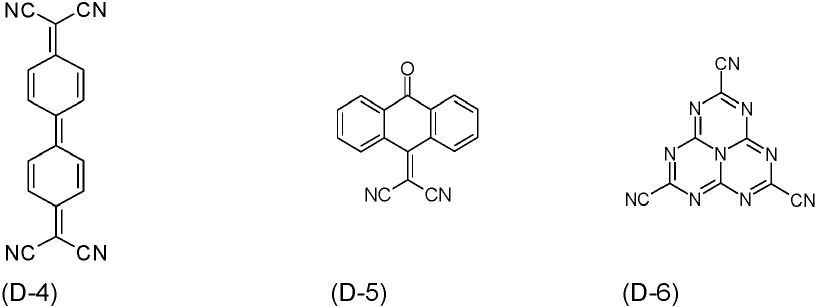

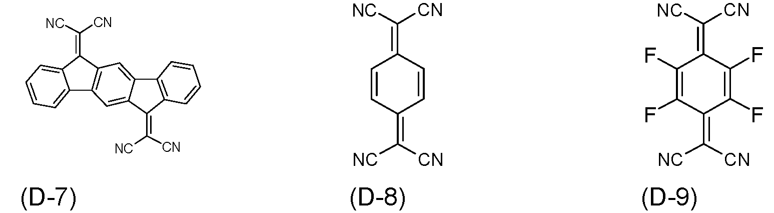

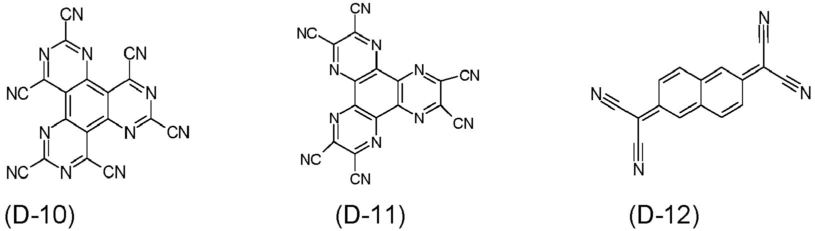

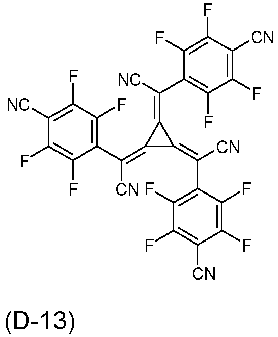

In an embodiment of the invention, the compound of the formula (I-1), (I-2), (I-3) or (I-4) or the preferred embodiments is used in a hole-transport or - injection layer in combination with a layer which comprises a hexaazatri-phenylene derivative, in particular hexacyanohexaazatriphenylene (for example in accordance with EP 1175470). Thus, for example, preference is given to a combination which looks as follows: anode - hexaazatri-phenylene derivative - hole-transport layer, where the hole-transport layer comprises one or more compounds of the formulae (I-1), (I-2), (I-3) or (I-4)or the preferred embodiments. It is likewise possible in this structure to use a plurality of successive hole-transport layers, where at least one hole-transport layer comprises at least one compound of the formulae (I-1), (I-2), (I-3) or (I-4) or the preferred embodiments. A further preferred combination looks as follows: anode - hole-transport layer - hexaaza-triphenylene derivative - hole-transport layer, where at least one of the two hole-transport layers comprises one or more compounds of the formulae (I-1), (I-2), (I-3) or (I-4) or the preferred embodiments. It is likewise possible in this structure to use a plurality of successive hole-transport layers instead of one hole-transport layer, where at least one hole-transport layer comprises at least one compound of the formulae (I-1, (I-2), (I-3) or (I-4)) or the preferred embodiments.

Preferably, the inventive OLED comprises two or more different electron-transporting layers. The compound of the formulae (I-1), (I-2), (I-3) or (I-4) may be used here in one or more of or in all the electron-transporting layers. According to a preferred embodiment, the compound of the formulae (I-1), (I-2), (I-3) or (I-4) is used in exactly one electron-transporting layer, and other compounds, preferably heteroaromatic compounds, are used in the further hole-transporting layers present.

In a further preferred embodiment of the invention, the compound of the formulae (I-1), (I-2), (I-3) or (I-4) or the preferred embodiments is employed as matrix material for a fluorescent or phosphorescent compound, in particular for a phosphorescent compound, in an emitting layer. The organic electroluminescent device here may comprise one emitting layer or a plurality of emitting layers, where at least one emitting layer comprises at least one compound according to the invention as matrix material.

If the compound of the formulae (I-1), (I-2), (I-3) or (I-4) or the preferred embodiments is employed as matrix material for an emitting compound in an emitting layer, it is preferably employed in combination with one or more phosphorescent materials (triplet emitters). Phosphorescence in the sense of this invention is taken to mean the luminescence from an excited state having a spin multiplicity > 1, in particular from an excited triplet state. For the purposes of this application, all luminescent complexes containing transition metals or lanthanoids, in particular all luminescent iridium, platinum and copper complexes, are to be regarded as phosphorescent compounds.

The mixture comprising the matrix material, which comprises the compound of the formula (I-1), (I-2), (I-3) or (I-4) or the preferred embodiments, and the emitting compound comprises between 99.9 and 1% by volume, preferably between 99 and 10% by volume, particularly preferably between 97 and 60% by volume, in particular between 95 and 80% by volume, of the matrix material, based on the entire mixture comprising emitter and matrix material. Correspondingly, the mixture comprises between 0.1 and 99% by volume, preferably between 1 and 90% by volume, particularly preferably between 3 and 40% by volume, in particular between 5 and 20% by volume, of the emitter, based on the entire mixture comprising emitter and matrix material.

A particularly preferred embodiment of the present invention is the use of the compound of the formulae (I-1), (I-2), (I-3) or (I-4) or the preferred embodiments as matrix material for a phosphorescent emitter in combination with a further matrix material. Particularly suitable matrix materials which can be employed in combination with the compounds of the formulae (I-1), (I-2), (I-3) or (I-4) are the ones mentioned below as preferred triplet matrix materials.

It is furthermore possible to use the compound of the formula (I-1), (I-2), (I-3) or (I-4) or the preferred embodiments both in a electron-transport layers or hole-blocking layer and as matrix in an emitting layer.

In the further layers of the organic electroluminescent device according to the invention, it is possible to use all materials as usually employed in accordance with the prior art. The person skilled in the art will therefore be able, without inventive step, to employ all materials known for organic electroluminescent devices in combination with the compounds of the formulae (I-1), (I-2), (I-3) or (I-4) according to the invention or the preferred embodiments.

Preferred embodiments of the different functional materials in the electronic device are listed hereinafter.

Suitable phosphorescent compounds (= triplet emitters) are, in particular, compounds which emit light, preferably in the visible region, on suitable excitation and in addition contain at least one atom having an atomic number greater than 20, preferably greater than 38 and less than 84, particularly preferably greater than 56 and less than 80, in particular a metal having this atomic number. The phosphorescent emitters used are preferably compounds which contain copper, molybdenum, tungsten, rhenium, ruthenium, osmium, rhodium, iridium, palladium, platinum, silver, gold or europium, in particular compounds which contain iridium, platinum or copper. Examples of the emitters described above are revealed by the applications WO 2000/70655, WO 2001/41512, WO 2002/02714, WO 2002/15645, EP 1191613, EP 1191612, EP 1191614, WO 2005/033244, WO 2005/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/157339 or WO 2012/007086. In general, all phosphorescent complexes as used in accordance with the prior art for phosphorescent OLEDs and as are known to the person skilled in the art in the area of organic electroluminescence are suitable, and the person skilled in the art will be able to use further phosphorescent complexes without inventive step.

Preferred phosphorescent emitting compounds are those mentioned above, and those listed in the following table.

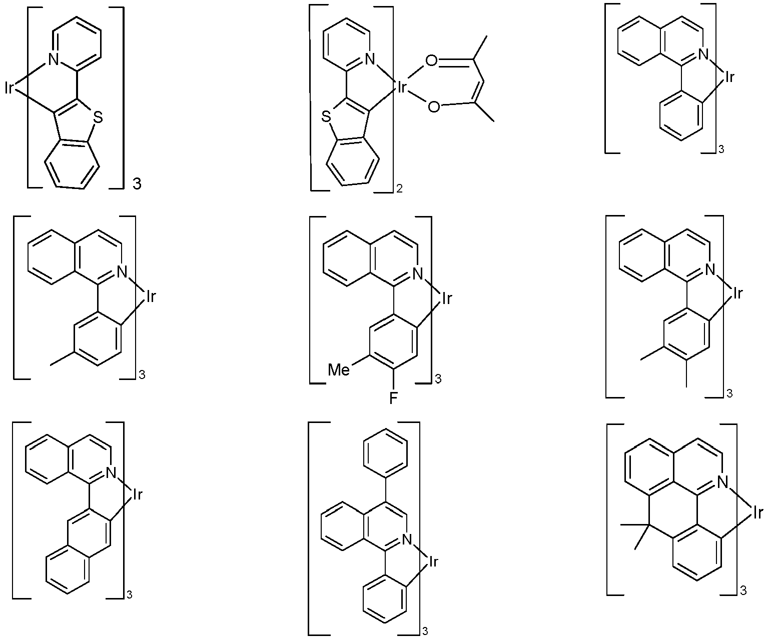

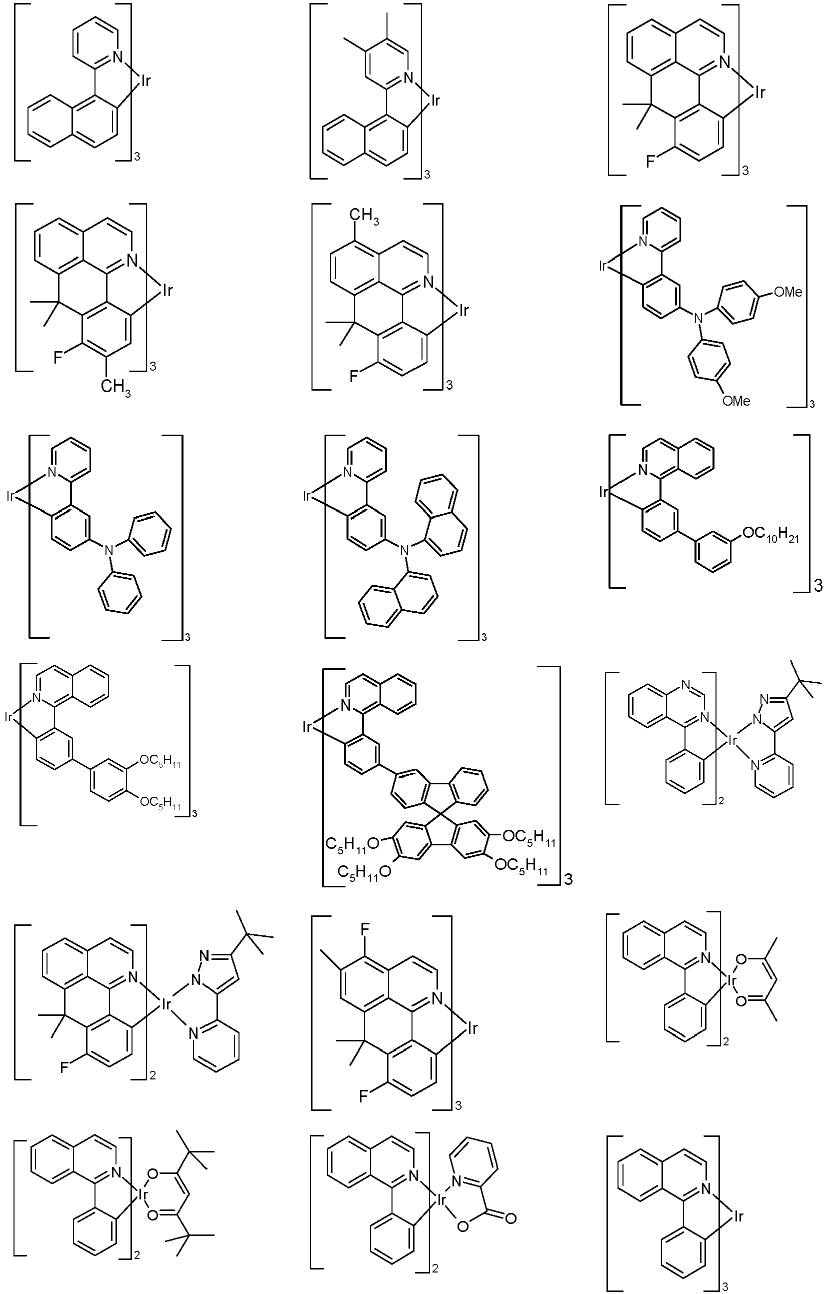

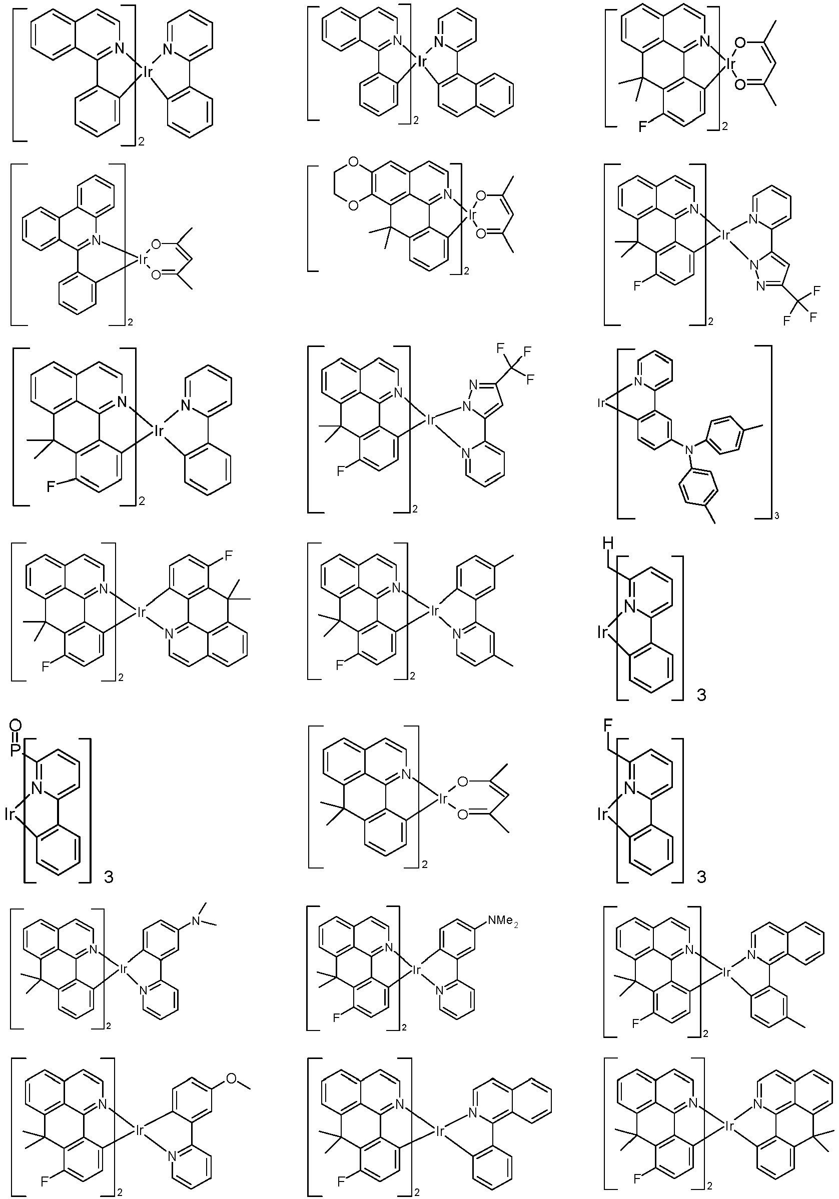

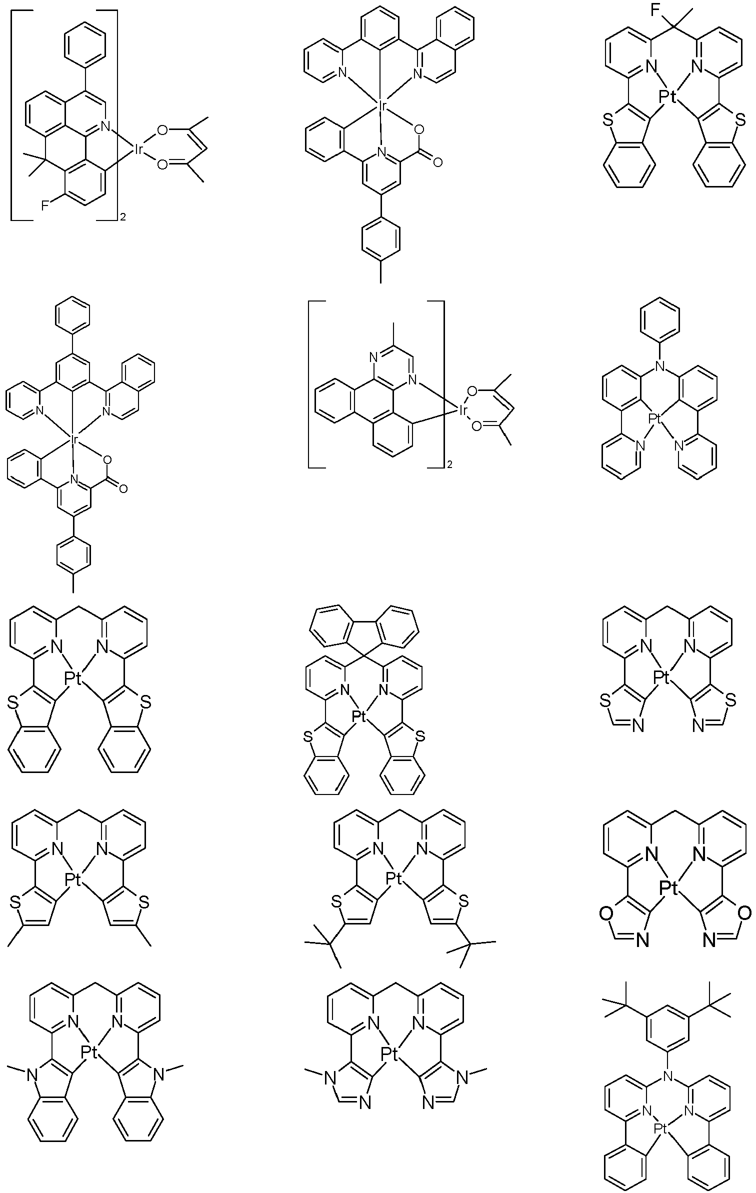

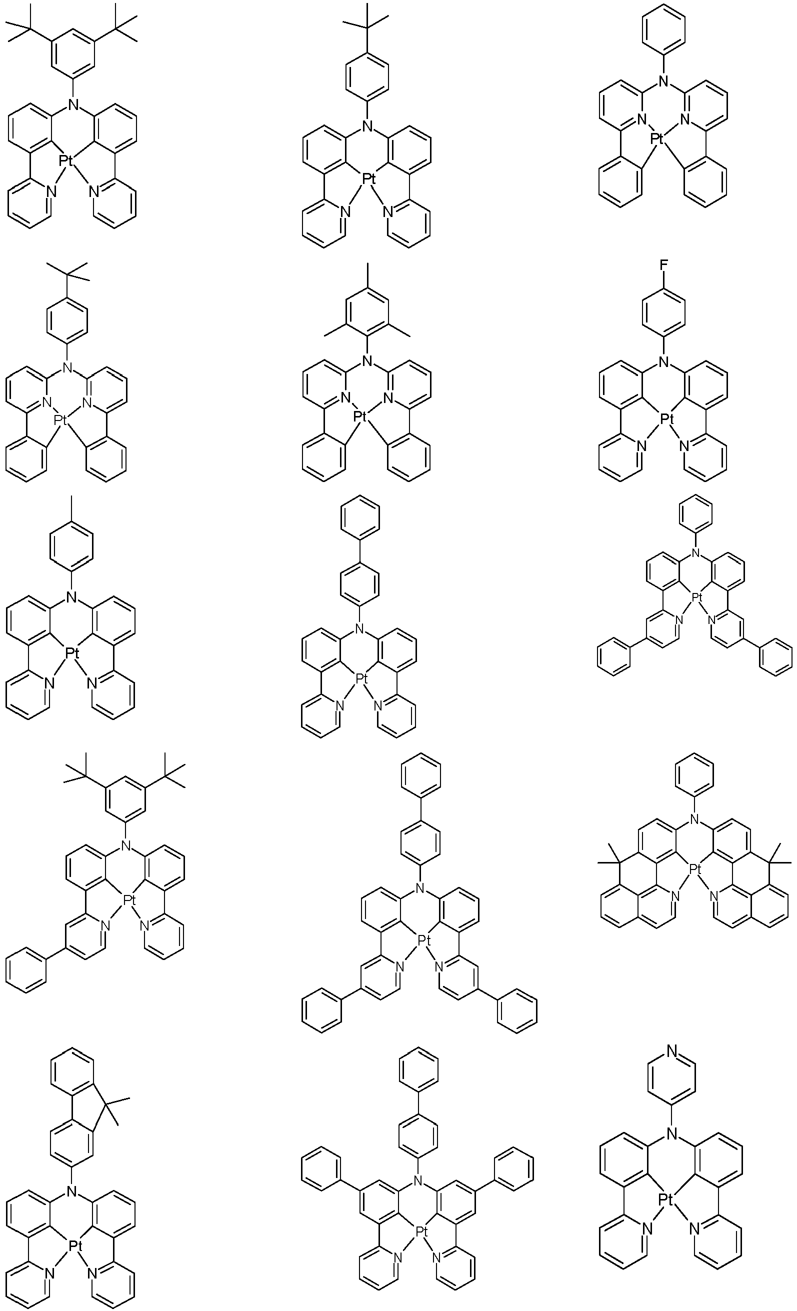

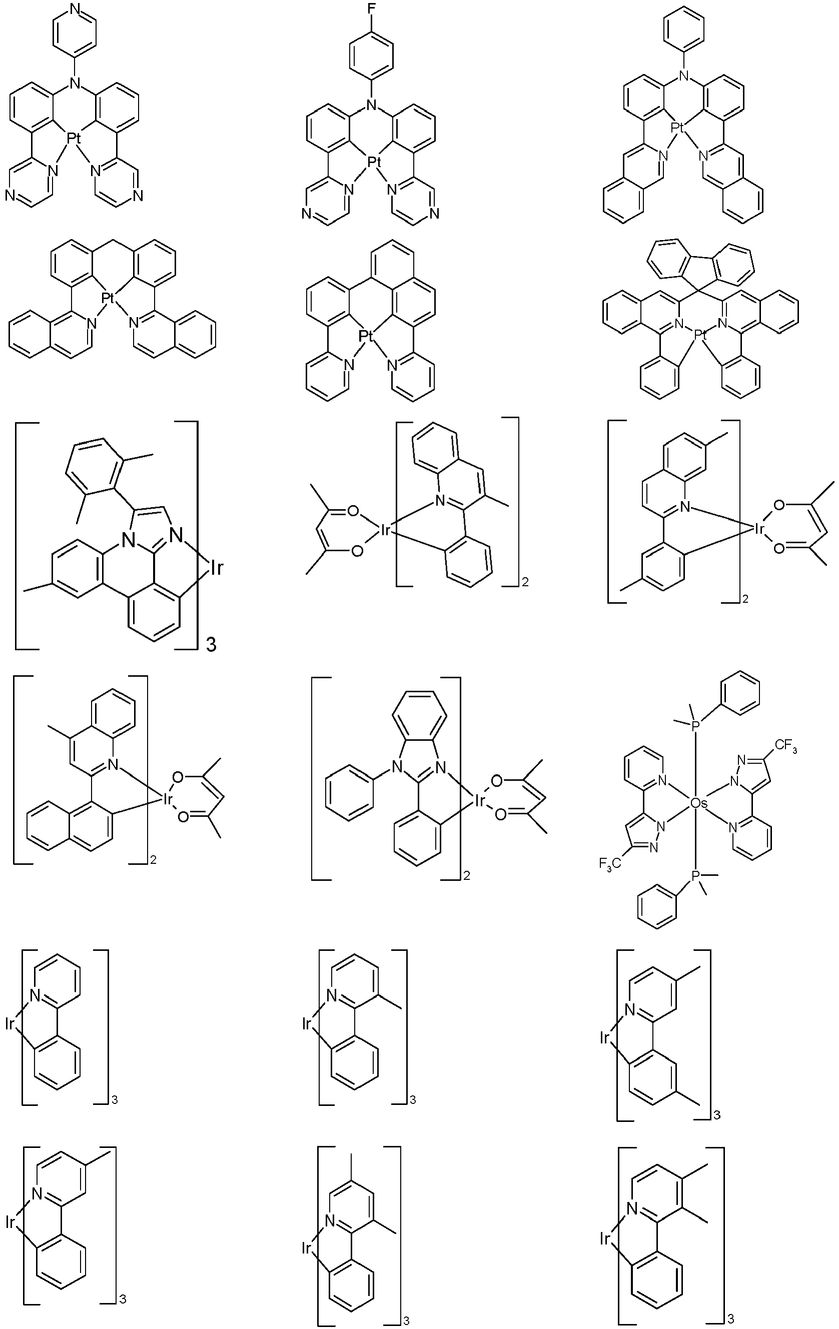

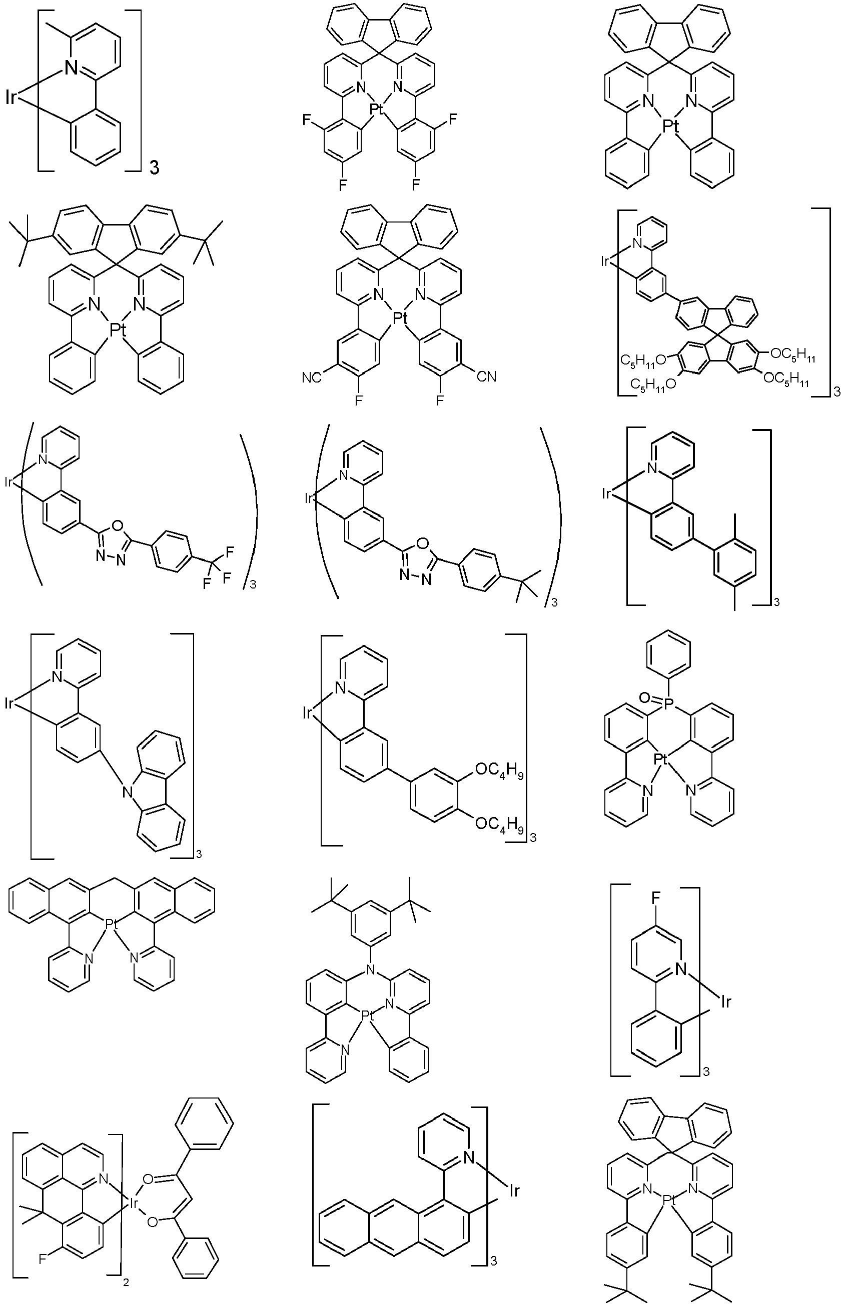

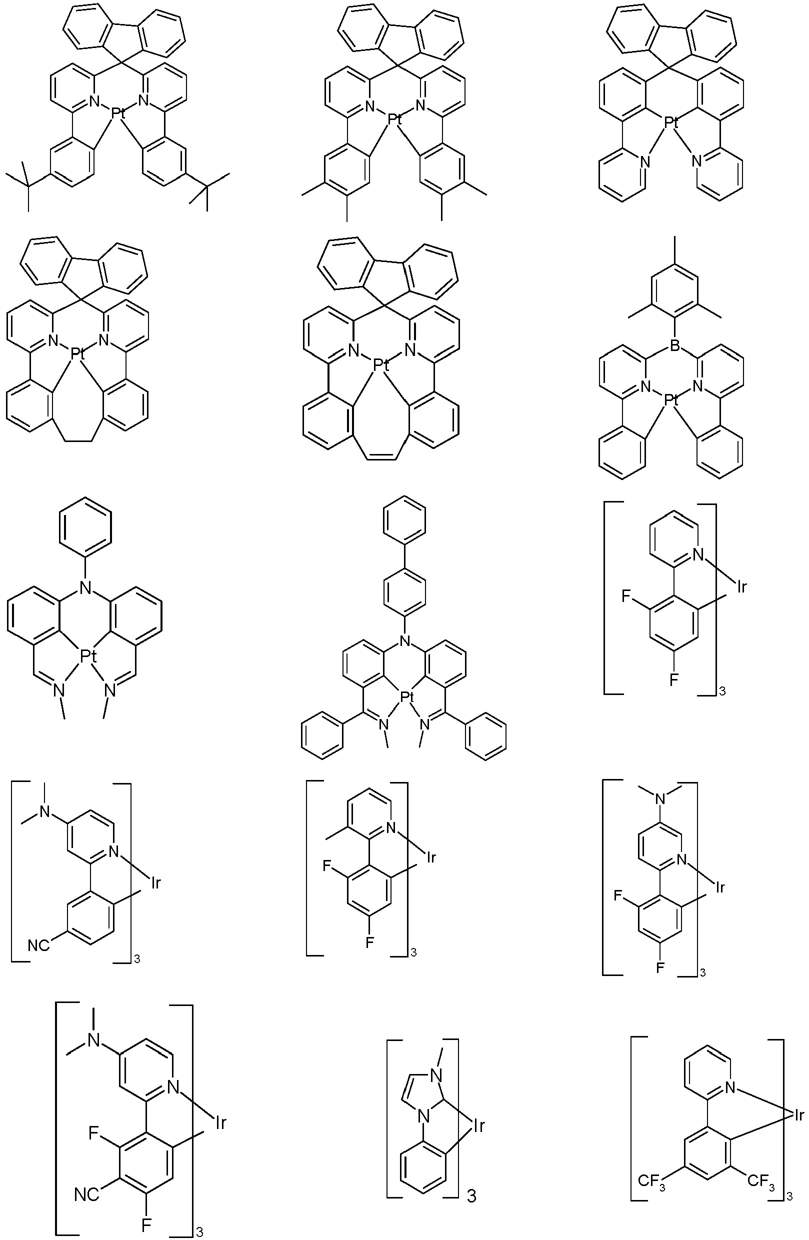

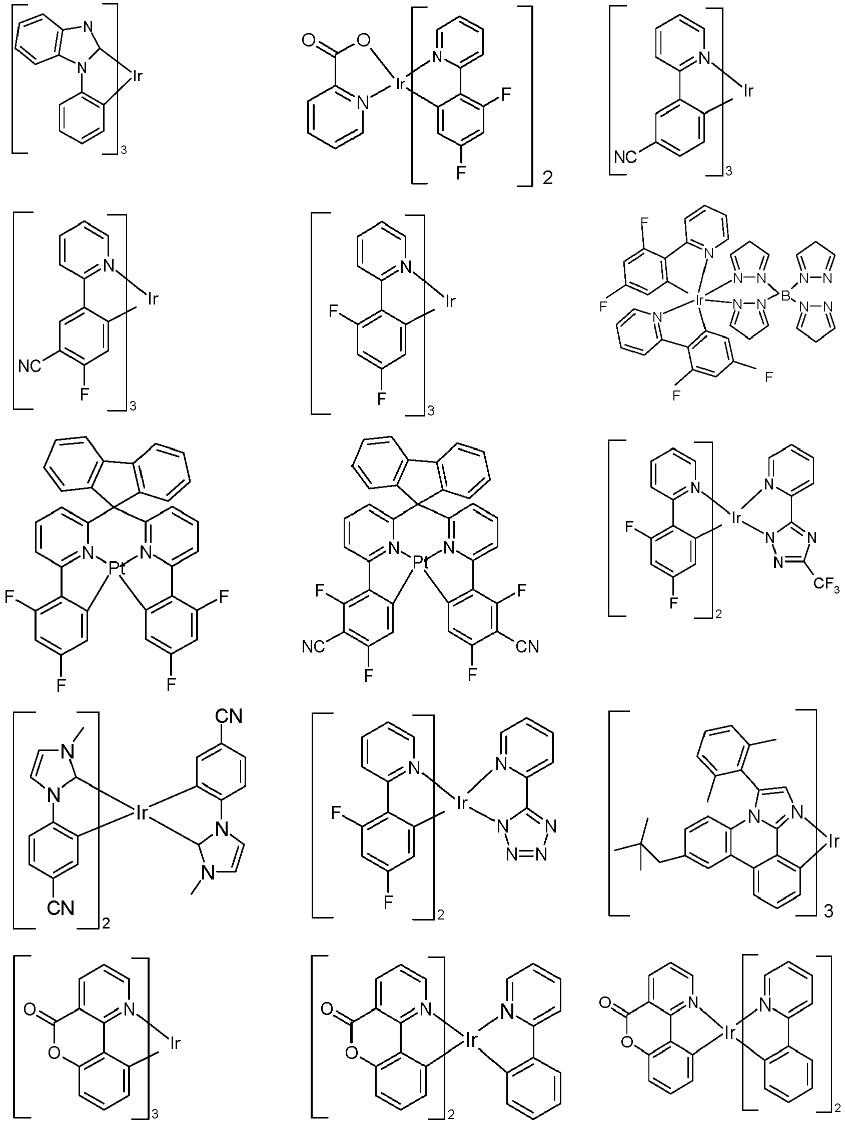

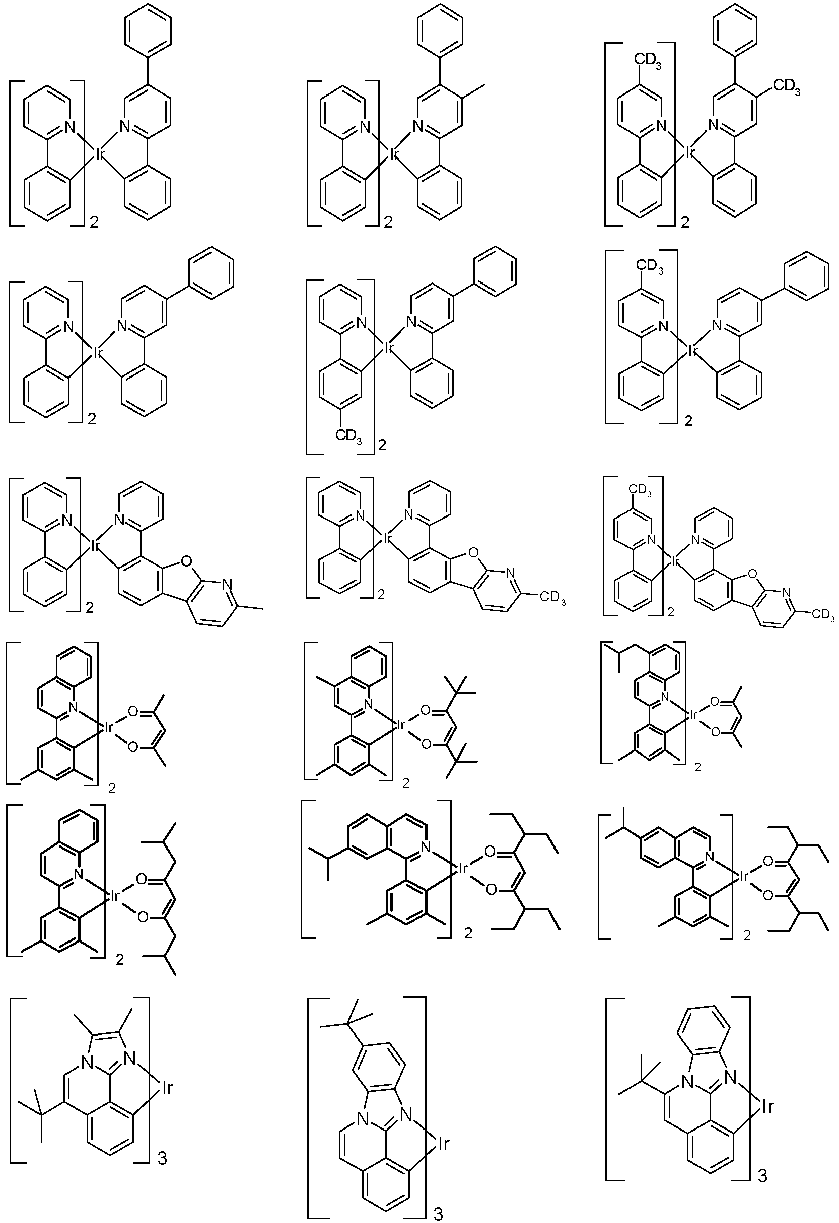

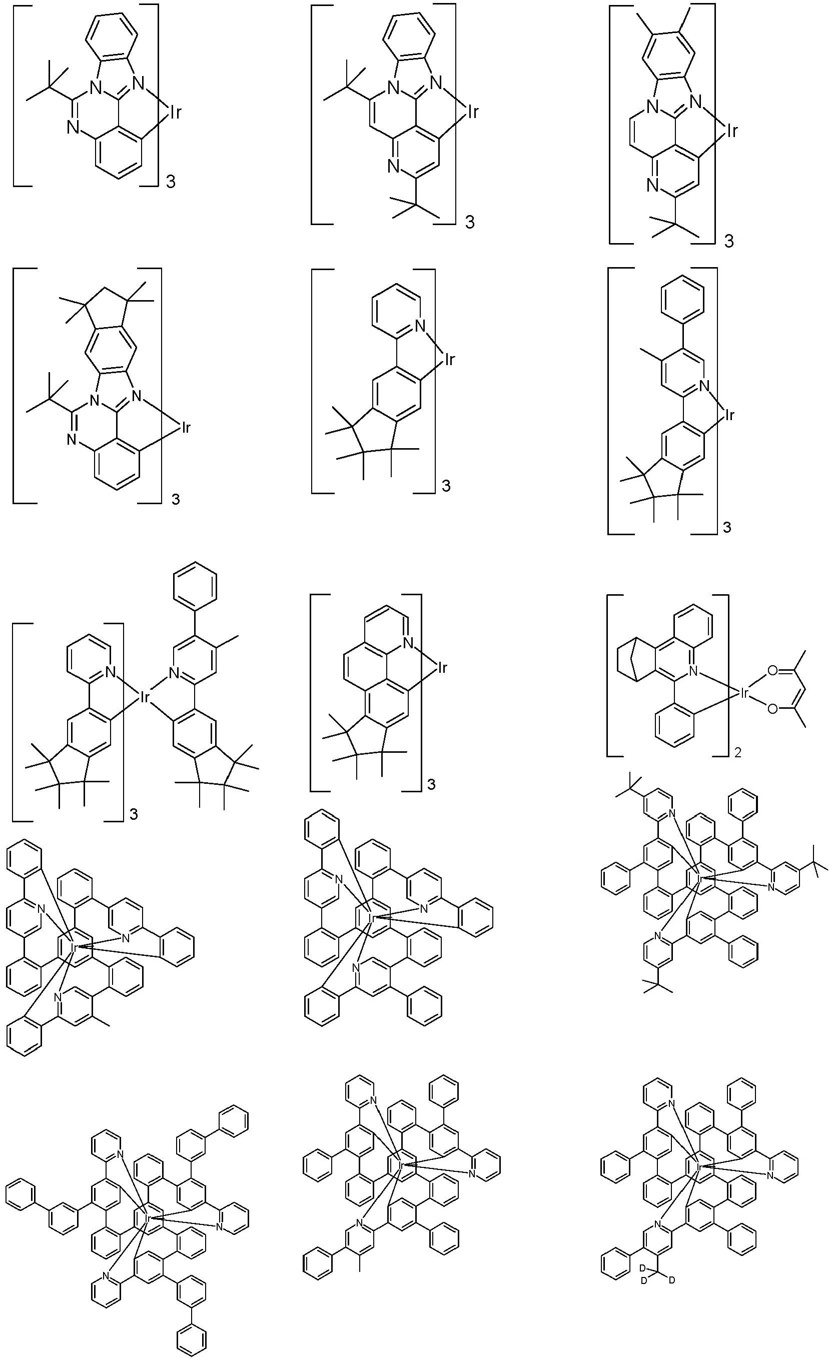

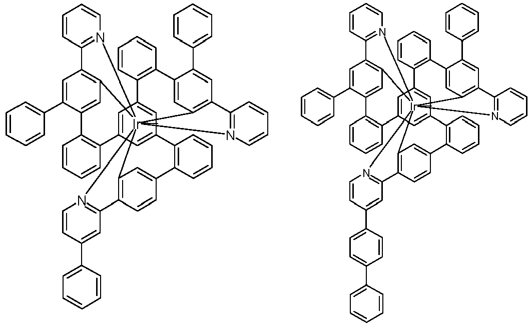

Preferred fluorescent emitting compounds are selected from the class of the arylamines. An arylamine or an aromatic amine in the context of this invention is understood to mean a compound containing three substituted or unsubstituted aromatic or heteroaromatic ring systems bonded directly to the nitrogen. Preferably, at least one of these aromatic or heteroaromatic ring systems is a fused ring system, more preferably having at least 14 aromatic ring atoms. Preferred examples of these are aromatic anthra-ceneamines, aromatic anthracenediamines, aromatic pyreneamines, aromatic pyrenediamines, aromatic chryseneamines or aromatic chrysenediamines. An aromatic anthraceneamine is understood to mean a compound in which a diarylamino group is bonded directly to an anthracene group, preferably in the 9 position. An aromatic anthracene-diamine is understood to mean a compound in which two diarylamino groups are bonded directly to an anthracene group, preferably in the 9,10 positions. Aromatic pyreneamines, pyrenediamines, chryseneamines and chrysenediamines are defined analogously, where the diarylamino groups in the pyrene are bonded preferably in the 1 position or 1,6 positions. Further preferred emitting compounds are indenofluoreneamines or -diamines, for example according to WO 2006/108497 or WO 2006/122630, benzoindenofluoreneamines or -diamines, for example according to WO 2008/006449, and dibenzoindenofluoreneamines or - diamines, for example according to WO 2007/140847, and the indenofluorene derivatives having fused aryl groups disclosed in WO 2010/012328. Likewise preferred are the pyrenearylamines disclosed in WO 2012/048780 and in WO 2013/185871. Likewise preferred are the benzoindenofluoreneamines disclosed in WO 2014/037077, the benzo-fluoreneamines disclosed in WO 2014/106522 and the extended benzo-indenofluorenes disclosed in WO 2014/111269.

Useful matrix materials, preferably for fluorescent emitting compounds, include materials of various substance classes. Preferred matrix materials are selected from the classes of the oligoarylenes (e.g. 2,2',7,7'-tetra-phenylspirobifluorene according to EP 676461 or dinaphthylanthracene), especially of the oligoarylenes containing fused aromatic groups, the oligoarylenevinylenes (e.g. DPVBi or spiro-DPVBi according to EP 676461), the polypodal metal complexes (for example according to WO 2004/081017), the hole-conducting compounds (for example according to WO 2004/058911), the electron-conducting compounds, especially ketones, phosphine oxides, sulphoxides, etc. (for example according to WO 2005/084081 and WO 2005/084082), the atropisomers (for example according to WO 2006/048268), the boronic acid derivatives (for example according to WO 2006/117052) or the benzanthracenes (for example according to WO 2008/145239). Particularly preferred matrix materials are selected from the classes of the oligoarylenes comprising naphthalene, anthracene, benzanthracene and/or pyrene or atropisomers of these compounds, the oligoarylenevinylenes, the ketones, the phosphine oxides and the sulphoxides. Very particularly preferred matrix materials are selected from the classes of the oligoarylenes comprising, anthracene, benzanthracene, benzophenanthrene and/or pyrene or atropisomers of these compounds. An oligoarylene in the context of this invention shall be understood to mean a compound in which at least three aryl or arylene groups are bonded to one another. Preference is further given to the anthracene derivatives disclosed in WO 2006/097208, WO 2006/131192, WO 2007/065550, WO 2007/110129, WO 2007/065678, WO 2008/145239, WO 2009/100925, WO 2011/054442 and EP 1553154, and the pyrene compounds disclosed in EP 1749809, EP 1905754 and US 2012/0187826.

Preferred matrix materials for phosphorescent emitting compounds are, as well as the compounds of the formula (I), aromatic ketones, aromatic phosphine oxides or aromatic sulphoxides or sulphones, for example according to WO 2004/013080, WO 2004/093207, WO 2006/005627 or WO 2010/006680, triarylamines, carbazole derivatives, e.g. CBP (N,N-biscarbazolylbiphenyl) or the carbazole derivatives disclosed in WO 2005/039246, US 2005/0069729, JP 2004/288381, EP 1205527 or WO 2008/086851, indolocarbazole derivatives, for example according to WO 2007/063754 or WO 2008/056746, indenocarbazole derivatives, for example according to WO 2010/136109, WO 2011/000455 or WO 2013/041176, azacarbazole derivatives, for example according to EP 1617710, EP 1617711, EP 1731584, JP 2005/347160, bipolar matrix materials, for example according to WO 2007/137725, silanes, for example according to WO 2005/111172, azaboroles or boronic esters, for example according to WO 2006/117052, triazine derivatives, for example according to WO 2010/015306, WO 2007/063754 or WO 2008/056746, zinc complexes, for example according to EP 652273 or WO 2009/062578, diazasilole or tetraazasilole derivatives, for example according to WO 2010/054729, diazaphosphole derivatives, for example according to WO 2010/054730, bridged carbazole derivatives, for example according to US 2009/0136779, WO 2010/050778, WO 2011/042107, WO 2011/088877 or WO 2012/143080, triphenylene derivatives, for example according to WO 2012/048781, or lactams, for example according to WO 2011/116865 or WO 2011/137951.

Suitable charge transport materials as usable in the hole injection or hole transport layer or electron blocker layer or in the electron transport layer of the electronic device of the invention are, for example, the compounds disclosed in Y. Shirota et al., Chem. Rev. 2007, 107(4), 953-1010, or other materials as used in these layers according to the prior art.

Materials used for the electron transport layer may be any materials as used according to the prior art as electron transport materials in the electron transport layer. Especially suitable are aluminium complexes, for example Alq₃, zirconium complexes, for example Zrq₄, lithium complexes, for example Liq, benzimidazole derivatives, triazine derivatives, pyrimidine derivatives, pyridine derivatives, pyrazine derivatives, quinoxaline derivatives, quinoline derivatives, oxadiazole derivatives, aromatic ketones, lactams, boranes, diazaphosphole derivatives and phosphine oxide derivatives. Further suitable materials are derivatives of the above-mentioned compounds as disclosed in JP 2000/053957, WO 2003/060956, WO 2004/028217, WO 2004/080975 and WO 2010/072300.

Preferred cathodes of the electronic device are metals having a low work function, metal alloys or multilayer structures composed of various metals, for example alkaline earth metals, alkali metals, main group metals or lanthanoids (e.g. Ca, Ba, Mg, Al, In, Mg, Yb, Sm, etc.). Additionally suitable are alloys composed of an alkali metal or alkaline earth metal and silver, for example an alloy composed of magnesium and silver. In the case of multilayer structures, in addition to the metals mentioned, it is also possible to use further metals having a relatively high work function, for example Ag or Al, in which case combinations of the metals such as Ca/Ag, Mg/Ag or Ba/Ag, for example, are generally used. It may also be preferable to introduce a thin interlayer of a material having a high dielectric constant between a metallic cathode and the organic semiconductor. Examples of useful materials for this purpose are alkali metal or alkaline earth metal fluorides, but also the corresponding oxides or carbonates (e.g. LiF, Li₂O, BaF₂, MgO, NaF, CsF, Cs₂CO₃, etc.). It is also possible to use lithium quinolinate (LiQ) for this purpose. The layer thickness of this layer is preferably between 0.5 and 5 nm.

Preferred anodes are materials having a high work function. Preferably, the anode has a work function of greater than 4.5 eV versus vacuum. Firstly, metals having a high redox potential are suitable for this purpose, for example Ag, Pt or Au. Secondly, metal/metal oxide electrodes (e.g. Al/Ni/NiOₓ, Al/PtOₓ) may also be preferred. For some applications, at least one of the electrodes has to be transparent or partly transparent in order to enable the irradiation of the organic material (organic solar cell) or the emission of light (OLED, O-LASER). Preferred anode materials here are conductive mixed metal oxides. Particular preference is given to indium tin oxide (ITO) or indium zinc oxide (IZO). Preference is further given to conductive doped organic materials, especially conductive doped polymers. In addition, the anode may also consist of two or more layers, for example of an inner layer of ITO and an outer layer of a metal oxide, preferably tungsten oxide, molybdenum oxide or vanadium oxide. Preference is furthermore given to an organic electroluminescent device, characterised in that one or more layers are applied by means of a sublimation process, in which the materials are vapour-deposited in vacuum sublimation units at an initial pressure of usually less than 10⁻⁵ mbar, preferably less than 10⁻⁶ mbar. However, it is also possible for the initial pressure to be even lower, for example less than 10⁻⁷ mbar.

Preference is likewise given to an organic electroluminescent device, characterised in that one or more layers are applied by means of the OVPD (organic vapour phase deposition) process or with the aid of carrier-gas sublimation, in which the materials are applied at a pressure between 10⁻⁵ mbar and 1 bar. A special case of this process is the OVJP (organic vapour jet printing) process, in which the materials are applied directly through a nozzle and thus structured (for example M. S. Arnold et al., Appl. Phys. Lett. 2008, 92, 053301).

Preference is furthermore given to an organic electroluminescent device, characterised in that one or more layers are produced from solution, such as, for example, by spin coating, or by means of any desired printing process, such as, for example, LITI (light induced thermal imaging, thermal transfer printing), ink-jet printing, screen printing, flexographic printing, offset printing or nozzle printing. Soluble compounds, which are obtained, for example, by suitable substitution, are necessary for this purpose. These processes are also particularly suitable for the compounds according to the invention, since these generally have very good solubility in organic solvents.

Also possible are hybrid processes, in which, for example, one or more layers are applied from solution and one or more further layers are applied by vapour deposition. Thus, for example, the emitting layer can be applied from solution and the electron-transport layer by vapour deposition.

These processes are generally known to the person skilled in the art and can be applied by him without inventive step to organic electroluminescent devices comprising the compounds according to the invention.

For the processing of the inventive compounds from the liquid phase, for example by spin-coating or by printing methods, formulations of the inventive compounds are required. These formulations may, for example, be solutions, dispersions or emulsions. For this purpose, it may be preferable to use mixtures of two or more solvents. Suitable and preferred solvents are, for example, toluene, anisole, o-, m- or p-xylene, methyl benzoate, mesitylene, tetralin, veratrole, THF, methyl-THF, THP, chlorobenzene, dioxane, phenoxytoluene, especially 3-phenoxytoluene, (-)-fenchone, 1,2,3,5-tetramethylbenzene, 1,2,4,5-tetramethylbenzene, 1-methylnaphthalene, 2-methylbenzothiazole, 2-phenoxyethanol, 2-pyrrolidinone, 3-methylanisole, 4-methylanisole, 3,4-dimethylanisole, 3,5-dimethylanisole, acetophenone, α-terpineol, benzothiazole, butyl benzoate, cumene, cyclohexanol, cyclohexanone, cyclohexylbenzene, decalin, dodecylbenzene, ethyl benzoate, indane, methyl benzoate, NMP, p-cymene, phenetole, 1,4-diisopropylbenzene, dibenzyl ether, diethylene glycol butyl methyl ether, triethylene glycol butyl methyl ether, diethylene glycol dibutyl ether, triethylene glycol dimethyl ether, diethylene glycol monobutyl ether, tripropylene glycol dimethyl ether, tetraethylene glycol dimethyl ether, 2-isopropylnaphthalene, pentylbenzene, hexylbenzene, heptylbenzene, octylbenzene, 1,1-bis(3,4-dimethylphenyl)ethane or mixtures of these solvents.

The present invention therefore furthermore relates to a formulation, in particular a solution, dispersion or mini-emulsion, comprising at least one compound of the formulae (I-1), (I-2), (I-3) or (I-4) or the preferred embodiments indicated above and at least one solvent, in particular an organic solvent. The way in which solutions of this type can be prepared is known to the person skilled in the art and is described, for example, in WO 2002/072714, WO 2003/019694 and the literature cited therein.

The present invention furthermore relates to mixtures comprising at least one compound of the formulae (I-1), (I-2), (I-3) or (I-4) or the preferred embodiments indicated above and at least one further compound. The further compound can be, for example, a fluorescent or phosphorescent emitter if the compound according to the invention is used as matrix material. The mixture may then also additionally comprise a further material as additional matrix material.

The present invention furthermore relates to the use of a compound according to the invention in an electronic device. Preferably, the compound according to the invention is used in a electron-transport layer or as matrix material in an emission layer as mentioned above and below.

The compounds according to the invention and the electronic devices, in particular organic electroluminescent devices, obtainable therefrom are distinguished over the prior art by one or more of the following surprising advantages:
1. The electronic devices obtainable using the compounds according to the invention exhibit very high stability and a very long lifetime compared with electronic devices obtained using conventional compounds.
2. The electronic devices obtainable using the compounds according to the invention exhibit a high efficiency, especially a high luminance efficiency and a high external quantum efficiency.
3. The compounds according to the invention provide a low operating voltage.
4. The compounds according to the invention can be processed using conventional methods, so that cost advantages can also be achieved thereby.
5. The layers obtainable using the compounds of the present invention exhibit excellent quality, in particular with respect to the uniformity of the layer.
6. The compounds according to the invention can be produced in a very rapid and easy manner using conventional methods, so that cost advantages can also be achieved thereby.

These above-mentioned advantages are not accompanied by an impairment of the other electronic properties.

It should be pointed out that variations of the embodiments described in the present invention fall within the scope of this invention. Each feature disclosed in the present invention can, unless this is explicitly excluded, be replaced by alternative features which serve the same, an equivalent or a similar purpose. Thus, each feature disclosed in the present invention is, unless stated otherwise, to be regarded as an example of a generic series or as an equivalent or similar feature.

All features of the present invention can be combined with one another in any way, unless certain features and/or steps are mutually exclusive. This applies, in particular, to preferred features of the present invention. Equally, features of non-essential combinations can be used separately (and not in combination).

It should furthermore be pointed out that many of the features, and in particular those of the preferred embodiments of the present invention, are themselves inventive and are not to be regarded merely as part of the embodiments of the present invention. For these features, independent protection can be sought in addition or as an alternative to each invention presently claimed.

The teaching on technical action disclosed in the present invention can be abstracted and combined with other examples.

The invention is explained in greater detail by the following examples, without wishing to restrict it thereby. On the basis of the descriptions, the person skilled in the art will be able to carry out the invention throughout the range disclosed and prepare further compounds according to the invention without inventive step and use them in electronic devices or use the process according to the invention.

### Working examples

### Scheme 1:

### Step 1)

Main synthetic procedure for the preparation:

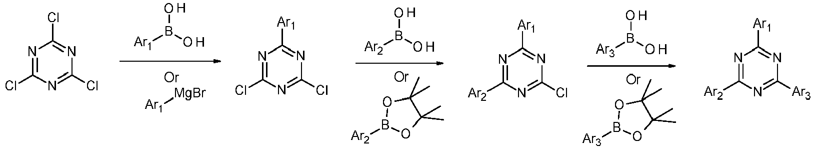

### Example 1:

### Synthesis of 2-Biphenyl-4-yl-4-(9,9-diphenyl-9H-dibenzosilol-4-yl)-6-phenyl- [1,3,5] triazine (1-1) and derivatives (1-2) bis (1-21)

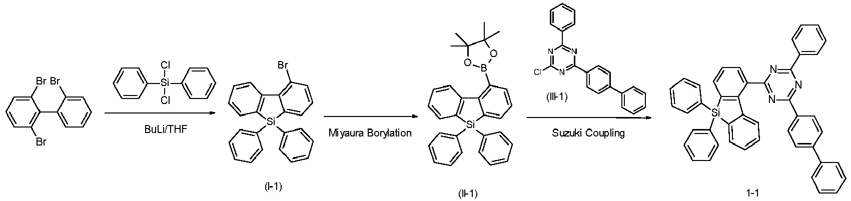

### Synthesis of 4'-bromo-9,9-diphenyl-9H -9-silafluorene (I-1)

10 g (25.58 mmol) of 2,6,2'-tribrombiphenyl is suspended in 120 mL of diethyl ether under Ar atmosphere then cool at -30~40 °C. 22.51 mL of (56.28 mmol / 2.5 M in hexane) n-BuLi is added dropwise at -30~40 °C and the mixture is stirred for 1 hr at the same temperature. Then, 6.8 g (26.86 mmol) of dichlorodiphenylsilane in diethyl ether (30 mL) dropwise at - 30-40 °C and the mixture is stirred for 3hrs at the same temperature then allow to warm up to room temperature. After reaction completion, 200 mL of H₂O and 300 mL of dichloromethane are added in the flask. The organic phase is separated off and dried over magnesium sulfate, filtrated and subsequently evaporated to dryness. The residue is washed with 300 mL of heptane. The yield is 4.2 g (10.16 mmol), corresponding to 40 % of theory.

The following compounds are synthesized analogously:

| Ex | Dichlorosilane | Tribromo biphenyl | Product | Yield |
|---|---|---|---|---|
| I-1 | 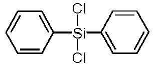 [80-10-4] | 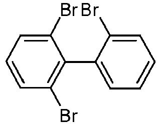 [507241-82-9] | 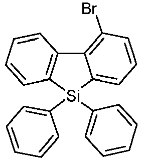 | 40% |
| I-2 | 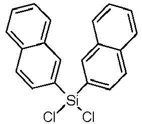 [1796541-30-4] | 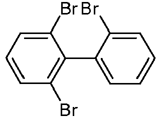 [507241-82-9] | 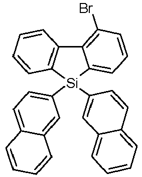 | 34% |
| I-3 | 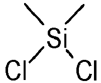 [75-78-5] | 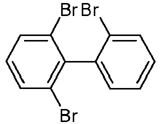 [507241-82-9] | 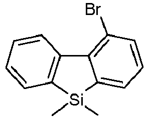 | 37% |
| I-4 | 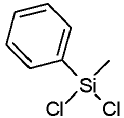 [149-74-6] | 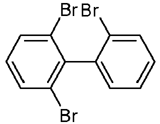 [507241-82-9] | 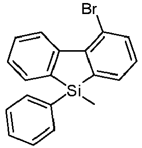 | 42% |
| I-5 | 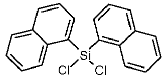 [18676-65-8] | 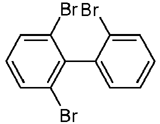 [507241-82-9] | 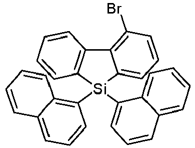 | 31% |
| I-6 | 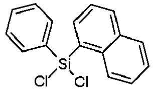 [7751-39-5] | 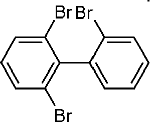 [507241-82-9] | 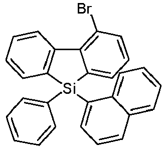 | 38% |
| I-7 | 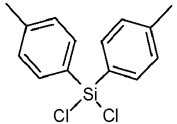 [18414-38-5] | 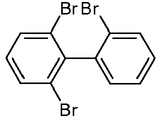 [507241-82-9] | 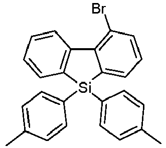 | 44% |

### Synthesis of 2-(5,5-diphenylbenzo[b][1] benzosilol-1-yl)-4,4,5,5-tetramethyl-1,3,2-dioxaborolane(II-1)

4.0 g (9.68 mmol) of compound(I-1) and 3.0g (11.61 mmol) of bis(pinacolato)-diboron are suspended in 26 mL of DMF (dimethylformamide) under Ar atmosphere. 2.84 g (29.03 mmol) of potassium acetate is added to the flask and stirred under Ar atmosphere. 0.23 g (0.29 mmol) of Pd(dppf)Cl₂ CH₂Cl₂ is added to the flask and stirred under Ar atmosphere. The reaction mixture is heated at 80 °C and stirred under Ar for 16 hrs. The reaction mixture is cooled to room temperature, the organic phase is quenched with water and extract three times with 100 mL of EA (ethyl acetate) and organic phase is washed three times with water, dry over magnesium sulfate, filtrated and subsequently evaporate to dryness. The residue is purified column chromatography with EA and Heptane. The yield is 4.0 g (8.51 mmol), corresponding to 88 % of theory.

The following compounds are synthesized analogously:

| Ex | Bromide | Bis(pinacolato)diborane | Product | Yield |
|---|---|---|---|---|
| II-1 | 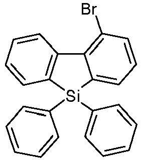 | 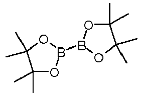 [73183-34-3] | 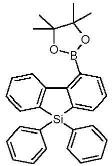 | 88% |
| II-2 | 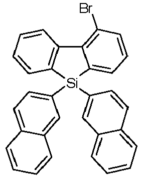 | 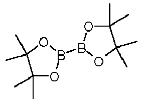 [73183-34-3] | 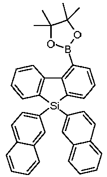 | 68% |
| II-3 | 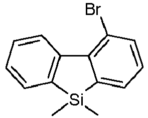 | 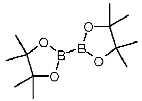 [73183-34-3] | 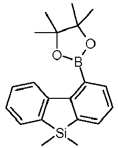 | 77% |
| II-4 | 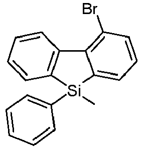 | 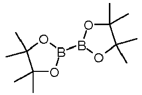 [73183-34-3] | 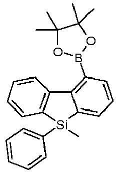 | 80% |
| II-5 | 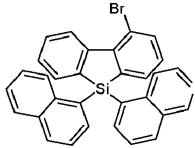 | 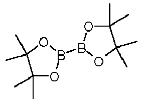 [73183-34-3] | 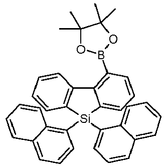 | 65% |
| II-6 | 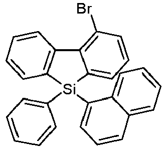 | 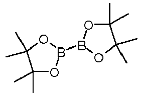 [73183-34-3] | 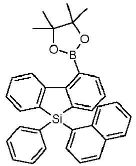 | 60% |
| II-7 | 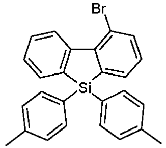 | 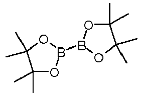 [73183-34-3] | 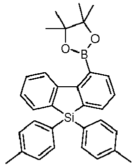 | 80% |

### Synthesis of 2-Chloro-4-phenyl-6-(4-phenylphenyl)-1,3,5-triazine(III-1)

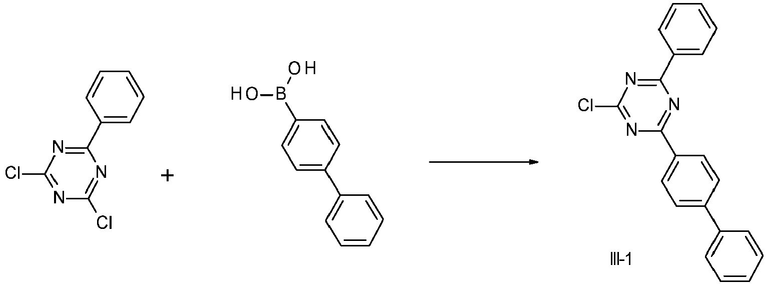

30 g (150 mmol) of 4-biphenyl boronic acid and 47.9 g (210 mmol) of 2,4-dichloro-6-phenyl- [1,3,5]-triazine are suspended in 420 mL of 1,4-Dioxane, 210 mL of Toluene and 420mL of H₂O under Ar atmosphere. 17.6 g (166 mmol) of Sodium carbonate is added to the flask and stirred under Ar atmosphere. 1.7 g (0.15 mmol) of tetrakis(triphenyl phosphine) palladium is added to the flask. The reaction mixture is heated at 60 °C and stirred under Ar for 16 hrs. The reaction mixture is cooled to room temperature, the organic phase is quenched with water and extracted three times with 200 mL of ethyl acetate. The organic phase is separated off and dried over magnesium sulfate, filtrated and subsequently evaporated to dryness. The residue is washed with EtOH 250mL. The yield is 41 g (119 mmol), corresponding to 78 % of theory.

The following compounds are synthesized analogously:

| Ex | Chloride | Boronic acid | Product | Overall Yield |
|---|---|---|---|---|
| III-1 | 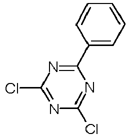 [1700-02-3] | 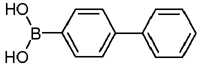 [5122-94-1] | 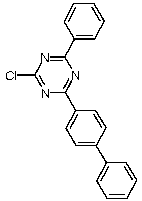 | 78% |
| III-2 | 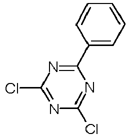 [1700-02-3] | 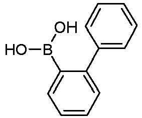 [4688-76-0] | 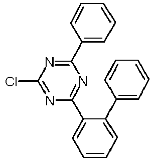 | 52% |
| III-3 | 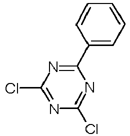 [1700-02-3] | 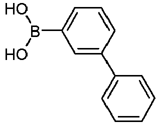 [5122-95-2] | 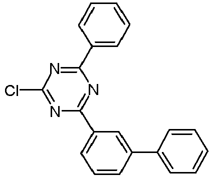 | 75% |
| III-4 | 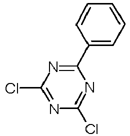 [1700-02-3] | 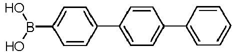 [877993-09-4] | 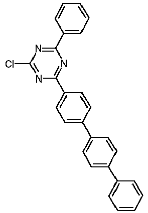 | 88% |
| III-5 | 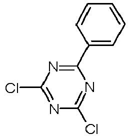 [1700-02-3] | 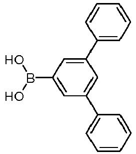 [128388-54-5] | 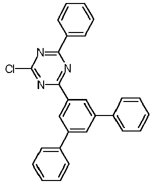 | 70% |
| III-6 | 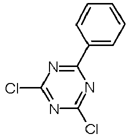 [1700-02-3] | 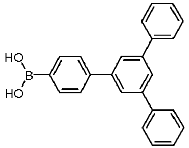 [491612-72-7] | 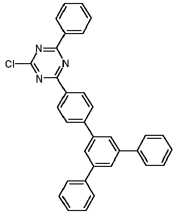 | 75% |
| III-7 | 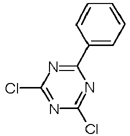 [1700-02-3] | 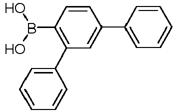 [364050-45-3] | 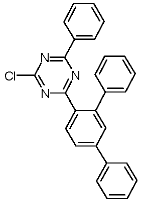 | 46% |
| III-8 | 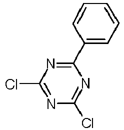 [1700-02-3] | 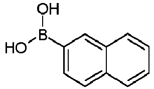 [32316-92-0] | 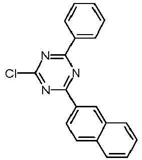 | 82% |
| III-9 | 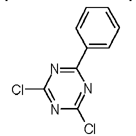 [1700-02-3] | 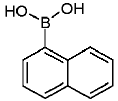 [13922-41-3] | 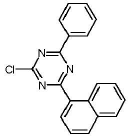 | 85% |
| III-10 | 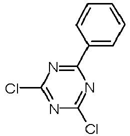 [1700-02-3] | 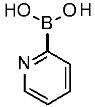 [197958-29-5] | 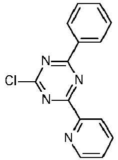 | 88% |
| III-11 | 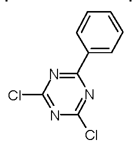 [1700-02-3] | 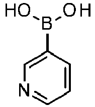 [1692-25-7] | 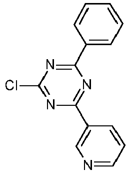 | 81% |
| III-12 | 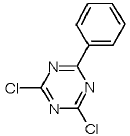 [1700-02-3] | 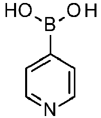 [1692-15-5] | 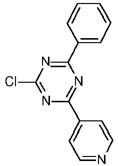 | 85% |
| III-13 | 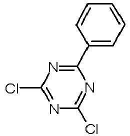 [1700-02-3] | 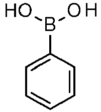 [98-80-6] | 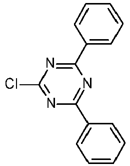 | 87% |

### Synthesis of 2-(5,5-diphenylbenzo[b][1] benzosilol-1-yl)-4-phenyl-6-(4-phenylphenyl)-1,3,5-triazine (1-1)

4.0 g (8.69 mmol) of compound(II-1) and 2.98 g (8.69mmol) of compound(III-1) are suspended in 40 mL of 1,4-Dioxane, 30 mL of Toluene and 40mL of H₂O under Ar atmosphere. 2.02 g (19.11 mmol) of Sodium carbonate is added to the flask and stirred under Ar atmosphere. 0.3 g (0.26 mmol) of tetrakis(triphenyl-phosphine) palladium is added to the flask. The reaction mixture is heated at 110 °C and stirred under Ar for 16 hrs. The reaction mixture is cooled to room temperature, the organic phase is quenched with water and extracted three times with 100 mL of toluene, dried over magnesium sulfate, filtrated and subsequently evaporate to dryness. The residue is washed with ethyl acetate. The yield is 4.06 g (6.54 mmol), corresponding to 75 % of theory.

The following compounds are synthesized analogously:

| Ex | Boronic ester | Chloride | Product | Yield |
|---|---|---|---|---|
| 1-1 | 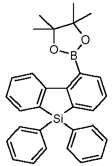 | 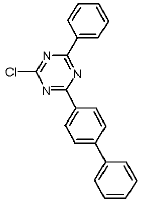 | 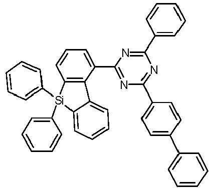 | 75% |
| 1-2 | 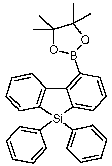 | 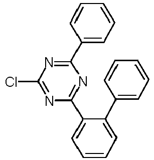 | 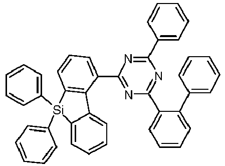 | 63% |
| 1-3 | 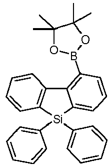 | 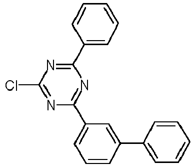 | 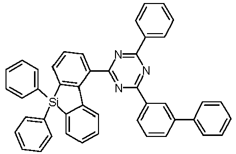 | 70% |
| 1-4 | 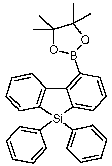 | 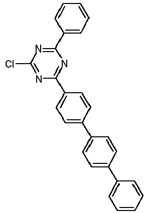 | 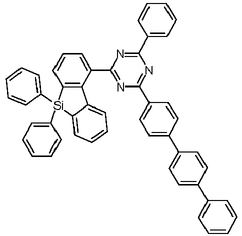 | 57% |
| 1-5 | 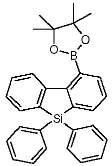 | 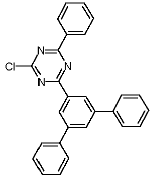 | 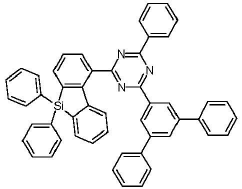 | 72% |
| 1-6 | 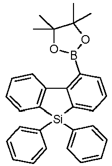 | 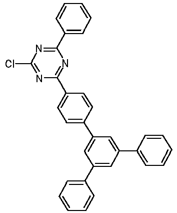 | 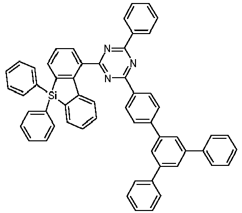 | 51% |
| 1-7 | 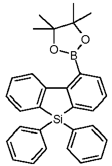 | 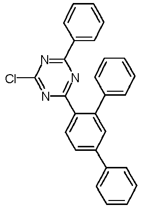 | 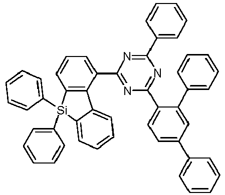 | 69% |
| 1-8 | 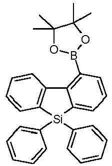 | 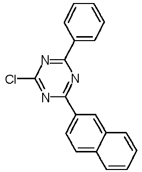 | 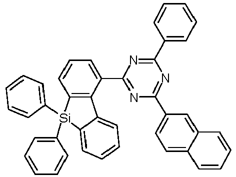 | 79% |
| 1-9 | 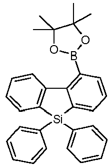 | 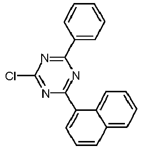 | 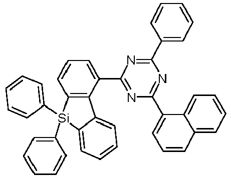 | 61% |
| 1-10 | 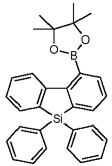 | 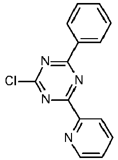 | 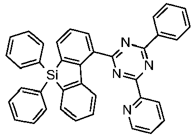 | 86% |
| 1-11 | 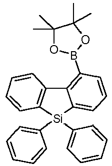 | 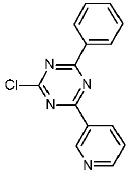 | 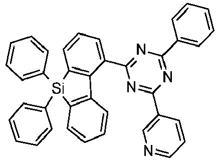 | 82% |
| 1-12 | 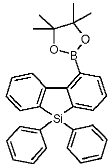 | 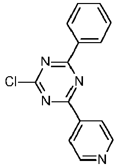 | 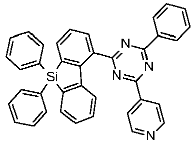 | 87% |
| 1-13 | 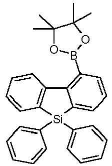 | 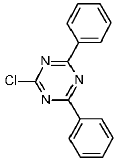 | 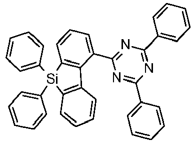 | 88% |
| 1-14 | 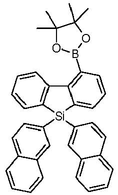 | 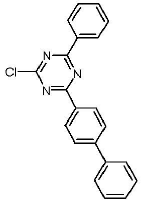 | 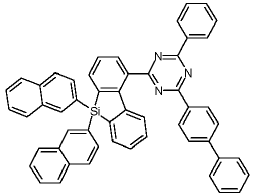 | 70% |
| 1-15 | 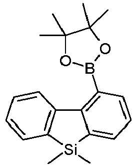 | 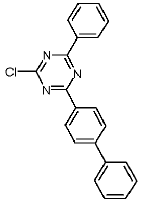 | 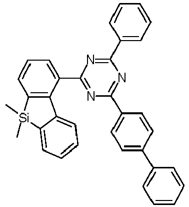 | 75% |
| 1-16 | 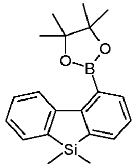 | 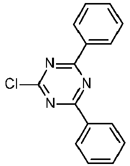 | 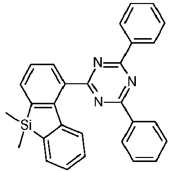 | 81% |
| 1-17 | 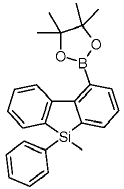 | 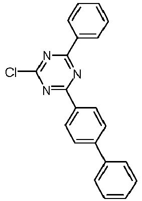 | 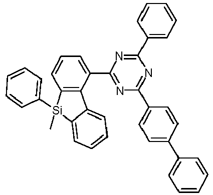 | 66% |
| 1-18 | 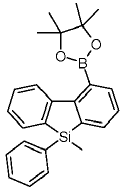 | 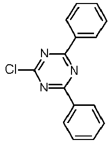 | 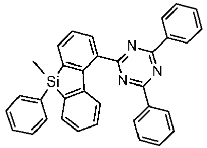 | 69% |
| 1-19 | 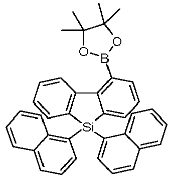 | 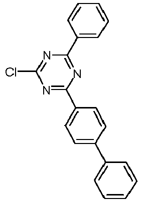 | 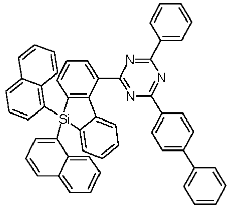 | 62% |
| 1-20 | 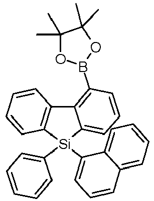 | 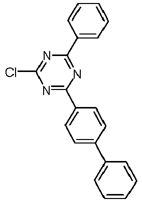 [1547491-85-9] | 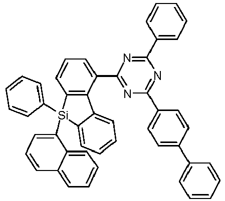 | 55% |
| 1-21 | 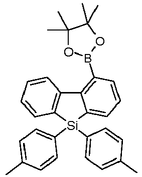 | 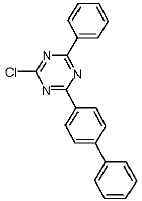 | 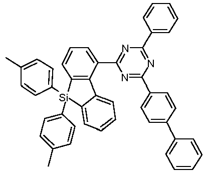 | 69% |

### Example 2:

### Synthesis of 2-(5,5-diphenylbenzo[b][1] benzosilol-4-yl)-4-phenyl-6-(4-phenylphenyl)-1,3,5-triazine (2-1) and derivatives (2-2) bis (2-8)

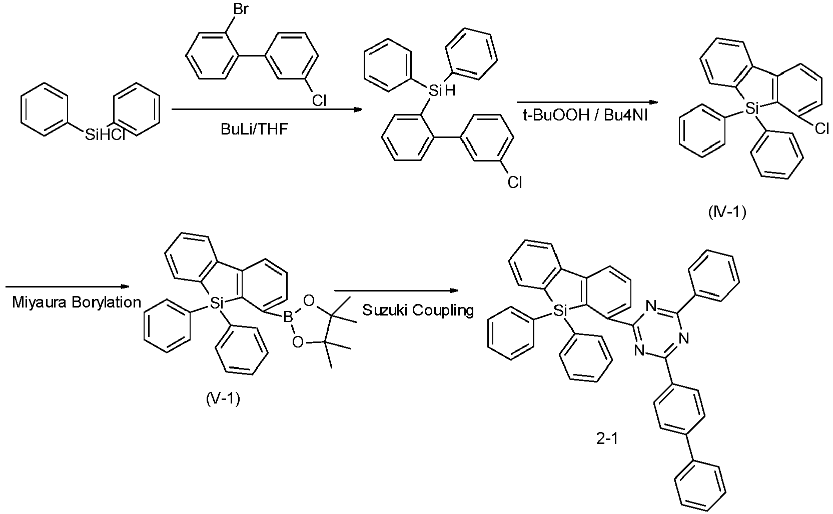

### Synthesis of 1-Chloro-9,9-diphenyl-7H-9-silafluorene (IV-1)

8.59 g (32.1 mmol) of 2-bromo-3'-chlorobiphenyl in 150 mL of THF under Ar atmosphere then cool at -78 °C. 24 mL (38 mmol / 1.6 M in hexane) of *n-*BuLi is added dropwise at -78 °C and the mixture is stirred for 30min at the same temperature. Then, 7.5 ml (38 mmol) of chlorodiphenylsilane in diethyl ether (100 mL) dropwise at -78 °C and the mixture is stirred for 3hrs at the same temperature then allow to warm up to room temperature. After reaction completion, the mixture is quenched with a saturated aqueous solution of NH₄Cl in water. After extraction with diethyl ether (3 × 100 mL), drying over magnesium sulfate, filtrated and subsequently evaporate to dryness. The residue is washed with 300 mL of heptane. The yield is 10 g (27 mmol), corresponding to 83 % of theory. Tetrabutylammonium iodide (90 mg, 25.1 mmol, 1 mol %) and a solution of tert-butyl hydroperoxide (15 mL / 5.5 M in decane, 0.83 mmol, 3.3 eq.) are added to a solution of 8.89 g (25.1 mmol) of 2-(3'chloro) biphenyldiphenylsilane in toluene (200mL).

After stirring for 5 min at room temperature the mixture is heated to 90 °C, stirred for 24 hrs at this temperature and cool to room temperature. After filtration through a short pad of silica eluting with dichloromethane, crude 1H-NMR analysis and concentration in vacuo the residue is purified by fractional column chromatography to afford the desired silafluorenes (IV-1). For analysis, compound is recrystallized from dichloromethane and acetonitrile. The yield is 3.8 g (10.3 mmol), corresponding to 41 % of theory.

The following compounds are synthesized analogously:

| Ex | Chlorosilane | 2-bromo-3'-chlorobiphenyl | Product | Yield |
|---|---|---|---|---|
| IV-1 | 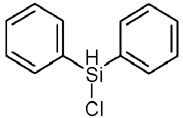 [1631-83-0] | 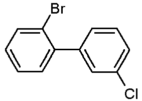 [154407-17-7] | 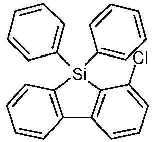 | 41% |
| IV-2 | 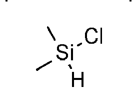 [1066-35-9] | 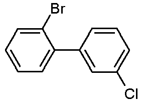 [154407-17-7] | 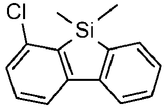 | 25% |
| IV-3 | 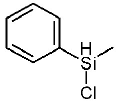 [1631-82-9] | 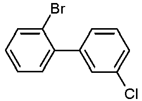 [154407-17-7] | 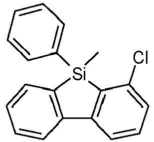 | 31% |
| IV-4 | 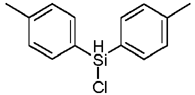 [18551-61-6] | 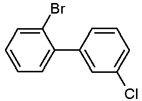 [154407-17-7] | 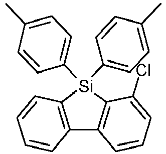 | 28% |

### Synthesis of 2-(9,9-Diphenyl-9H-dibenzosilol-1-yl)-4,4,5,5-tetramethyl-[1,3,2] dioxaborolane (V-1)

3.8 g (10.30 mmol) of compound(IV-1) and 3.1g (12.36mmol) of bis(pinacolato)-diborane are suspended in 26 mL of DMF under Ar atmosphere. 3.1 g (30.90 mmol) of potassium acetate is added to the flask and stirred under Ar atmosphere. 0.25 g (0.31 mmol) of Pd(dppf)Cl₂ CH₂Cl₂ is added to the flask and stirred under Ar atmosphere. The reaction mixture is heated at 80 °C and stirred under Ar for 16 hrs. The reaction mixture is cooled to room temperature, the organic phase is quenched with water and extracted three times with 100 mL of EA and organic phase is washed three times with water, dried over magnesium sulfate, filtrated and subsequently evaporate to dryness. The residue is purified column chromatography with EA and Heptane. The yield is 4.0 g (8.75 mmol), corresponding to 85 % of theory.

The following compounds are synthesized analogously:

| Ex | Chloride | Bis(pinacolato)diborane | Product | Yield |
|---|---|---|---|---|
| V-1 | 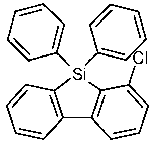 | 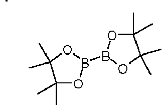 [73183-34-3] | 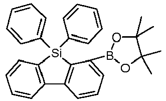 | 85% |
| V-2 | 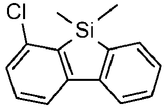 | 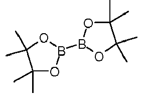 [73183-34-3] | 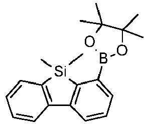 | 62% |
| V-3 | 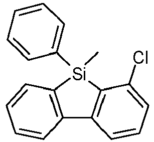 | 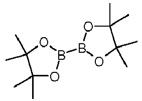 [73183-34-3] | 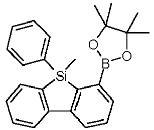 | 68% |
| V-4 | 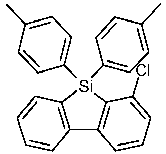 | 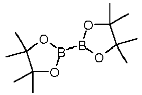 [73183-34-3] | 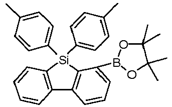 | 77% |

### Synthesis of 2-(5,5-diphenylbenzo[b][1] benzosilol-4-yl)-4,4,5,5-tetramethyl-1,3,2-dioxaborolane (2-1)

4.0 g (8.75 mmol) of compound(V-1) and 3.01 g (8.75mmol) of compound(III-1) are suspended in 40 mL of 1,4-Dioxane, 30 mL of Toluene and 40mL of H₂O under Ar atmosphere. 2.04 g (19.25 mmol) of Sodium carbonate is added to the flask and stirred under Ar atmosphere. 0.3 g (0.26 mmol) of tetrakis (triphenyl phosphine) palladium is added to the flask. The reaction mixture is heated at 110 °C and stirred under Ar for 16 hrs. The reaction mixture is cooled to room temperature, the organic phase is quenched with water and extracted three times with 100 mL of toluene, dried over magnesium sulfate, filtrated and subsequently evaporate to dryness. The residue is washed with ethyl acetate. The yield is 4.2 g (6.56 mmol), corresponding to 75 % of theory.

The following compounds are synthesized analogously:

| Ex | Boronic ester | Chloride | Product | Yield |
|---|---|---|---|---|
| 2-1 | 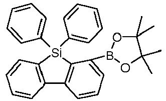 | 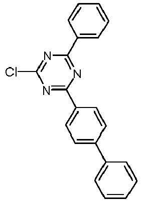 | 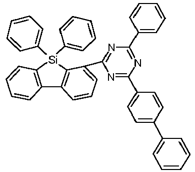 | 75% |
| 2-2 | 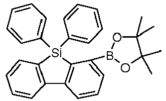 | 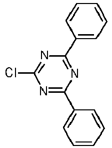 | 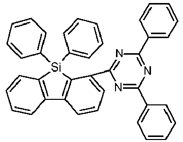 | 72% |
| 2-3 | 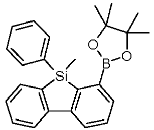 | 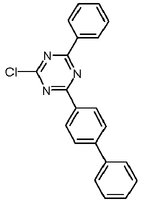 | 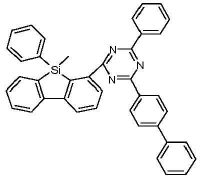 | 62% |
| 2-4 | 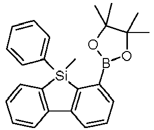 | 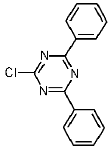 | 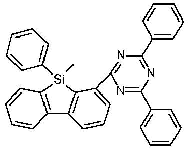 | 68% |
| 2-5 | 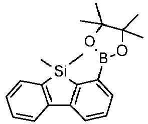 | 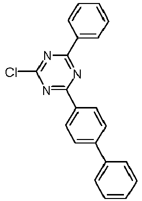 | 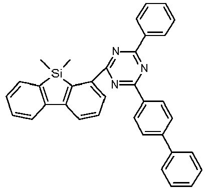 | 75% |
| 2-6 | 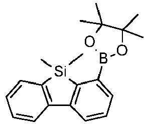 | 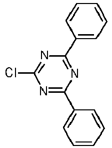 | 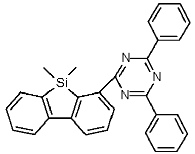 | 77% |
| 2-7 | 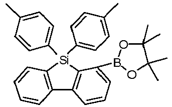 | 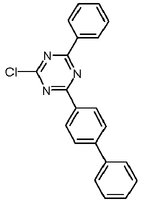 | 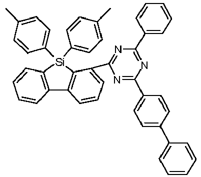 | 69% |
| 2-8 | 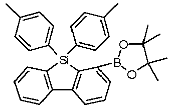 | 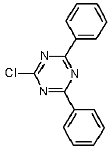 | 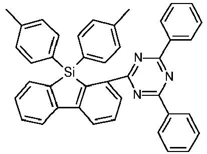 | 71% |

### Example 3

### Synthesis of 2-[4-(5,5-diphenylbenzo[b][1] benzosilol-1-yl) phenyl]-4-phenyl-6-(4-phenylphenyl)-1,3,5-triazine (3-1) and derivatives (3-2) bis (3-10)

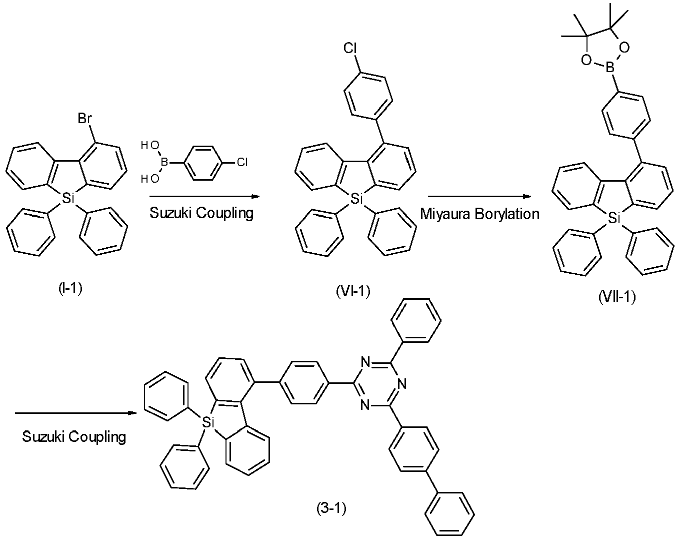

### Synthesis of 4-(4-chlorophenyl)-9,9-diphenyl-7H-9-silafluorene (VI-1)

27.7 g (67 mmol) of compound(I-1), 11.1 g (71 mmol) of 4-chloro-phenyl boronic acid and 14.3 g (135 mmol) of sodium carbonate are suspended in 500 mL of EtOH, 500 mL of H₂O and 200 mL of toluene and stirred under Ar atmosphere. 2.3 g (2 mmol) of tetrakis(triphenylphosphine)palladium is added to the flask. The reaction mixture is heated at 110 °C and stirred under Ar for 16 hrs. The reaction mixture is cooled to room temperature, the reaction mixture is quenched. The organic phase is separated, washed three times with 200 mL of water, dried over magnesium sulfate, filtrated and subsequently evaporate to dryness. The residue is purified by column chromatography on silica gel using a mixture of DCM / heptane (1:10). The yield is 21.7 g (49 mmol), corresponding to 73 % of theory.

The following compounds are synthesized analogously:

| Ex | Bromide | Aryl boronic acid | Product | Yield |
|---|---|---|---|---|
| VI-1 | 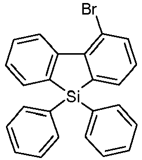 **(I-1)** | 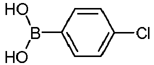 [1679-18-1] | 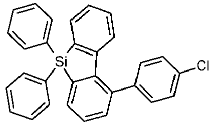 | 73% |
| VI-2 | 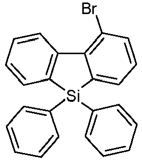 **(I-1)** | 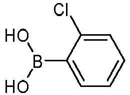 [3900-89-8] | 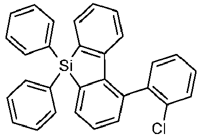 | 65% |
| VI-3 | 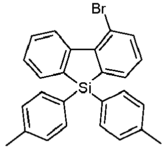 (I-7) | 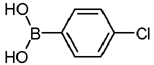 [1679-18-1] | 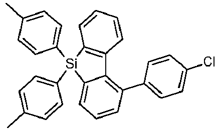 | 67% |
| VI-4 | 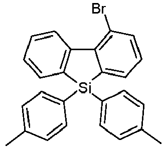 (I-7) | 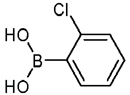 [3900-89-8] | 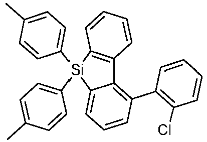 | 69% |
| VI-5 | 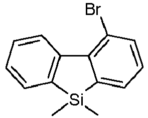 | 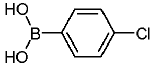 [1679-18-1] | 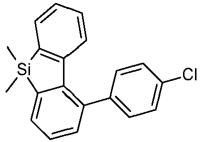 | 75% |
| VI-6 | 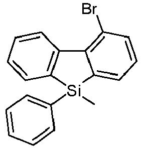 | 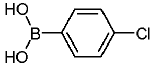 [1679-18-1] | 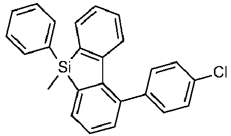 | 77% |

### Synthesis of 2-[4-(9,9-Diphenyl-9H-dibenzosilol-4-yl)-phenyl]-4,4,5,5-tetramethyl-[1,3,2] dioxaborolane(VII-1)

5.0 g (11.23 mmol) of compound (VI-1) and 3.4g (13.48 mmol) of bis(pinacolato)-diborane are suspended in 30 mL of DMF under Ar atmosphere. 2.62 g (24.7 mmol) of potassium acetate is added to the flask and stir under Ar atmosphere. 0.39 g (0.33 mmol) of Pd(dppf)Cl₂ CH₂Cl₂ is added to the flask and stirred under Ar atmosphere. The reaction mixture is heated at 80°C and stirred under Ar for 16 hrs. The reaction mixture is cooled to room temperature, the organic phase is quenched with water and extracted three times with 100 mL of EA and organic phase is washed three times with water, dried over magnesium sulfate, filtrated and subsequently evaporate to dryness. The residue is purified column chromatography with EA and Heptane. The yield is 4.9 g (9.2 mmol), corresponding to 82 % of theory.

The following compounds are synthesized analogously:

| Ex | Chloride | Bis(pinacolato) diborane | Product | Yield |
|---|---|---|---|---|
| VII-1 | 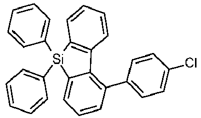 | 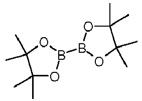 [73183-34-3] | 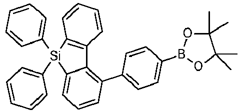 | 82% |
| VII-2 | 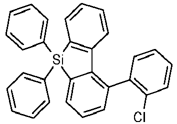 | 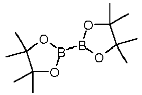 [73183-34-3] | 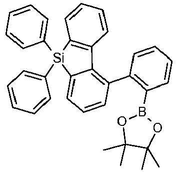 | 65% |
| VII-3 | 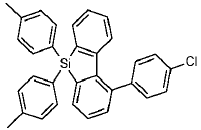 | 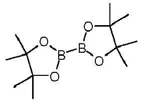 [73183-34-3] | 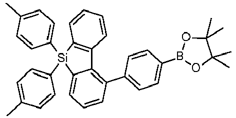 | 67% |
| VII-4 | 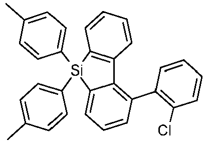 | 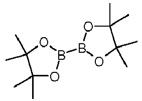 [73183-34-3] | 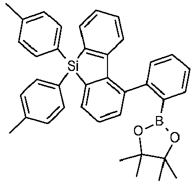 | 62% |
| VII-5 | 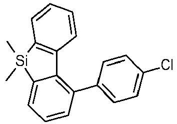 | 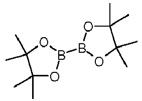 [73183-34-3] | 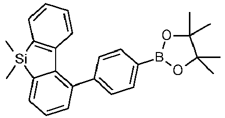 | 76% |
| VII-6 | 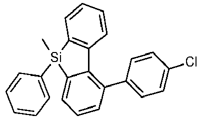 | 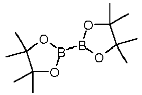 [73183-34-3] | 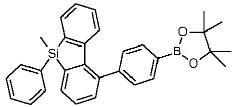 | 77% |

### Synthesis of 2-[4-(5,5-diphenylbenzo[b][1] benzosilol-1-yl) phenyl]-4-phenyl-6-(4-phenylphenyl)-1,3,5-triazine (3-1)

4.0 g (8.38 mmol) of compound(VII-1) and 2.88 g (8.38 mmol) of compound(III-1) are suspended in 40 mL of 1,4-Dioxane, 30 mL of Toluene and 40mL of H₂O under Ar atmosphere. 1.95 g (18.43 mmol) of Sodium carbonate is added to the flask and stirred under Ar atmosphere. 0.3 g (0.25 mmol) of tetrakis(triphenylphosphine)palladium is added to the flask. The reaction mixture is heated at 110 °C and stirred under Ar for 16 hrs. The reaction mixture is cooled to room temperature, the organic phase is quenched with water and extracted three times with 100 mL of toluene, dried over magnesium sulfate, filtrated and subsequently evaporate to dryness. The residue is washed with ethyl acetate. The yield is 4.45 g (6.20 mmol), corresponding to 74 % of theory

The following compounds are synthesized analogously:

| Ex | Boronic ester | Chloride | Product | Yield |
|---|---|---|---|---|
| 3-1 | 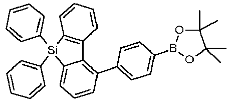 | 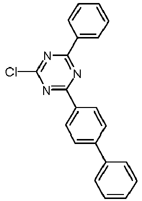 | 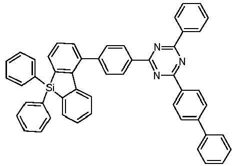 | 74% |
| 3-2 | 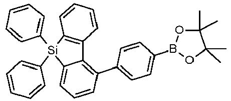 | 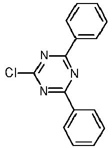 | 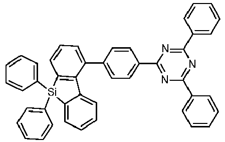 | 78% |
| 3-3 | 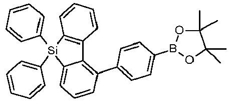 | 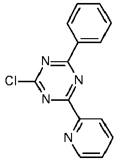 | 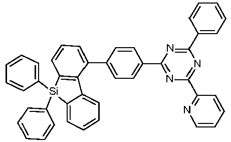 | 80% |
| 3-4 | 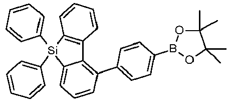 | 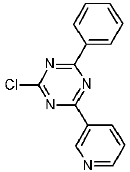 | 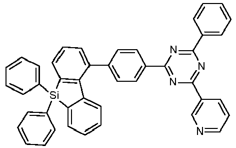 | 79% |
| 3-5 | 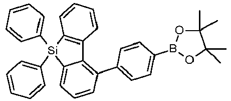 | 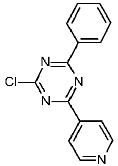 | 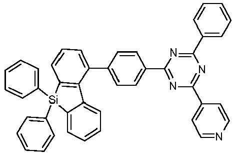 | 77% |
| 3-6 | 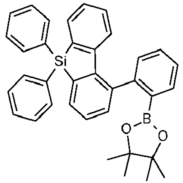 | 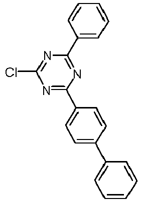 | 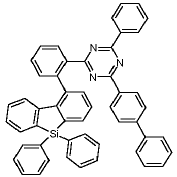 | 81% |
| 3-7 | 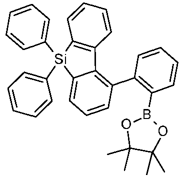 | 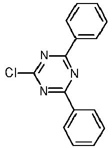 | 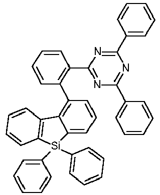 | 83% |
| 3-8 | 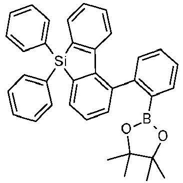 | 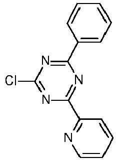 | 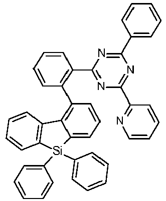 | 78% |
| 3-9 | 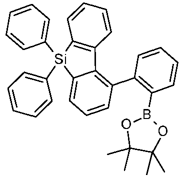 | 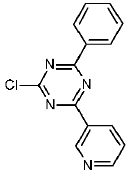 | 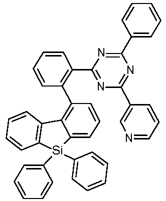 | 75% |
| 3-10 | 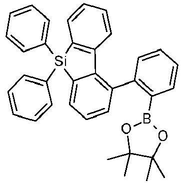 | 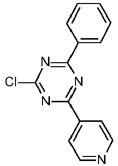 | 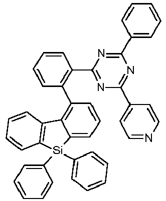 | 80% |

### Example 4

### Synthesis of 2-(5,5-diphenylbenzo[b][1] benzosilol-3-yl)-4-phenyl-6-(4-phenylphenyl)-1,3,5-triazine (4-1) and derivatives (4-2) bis (4-17)

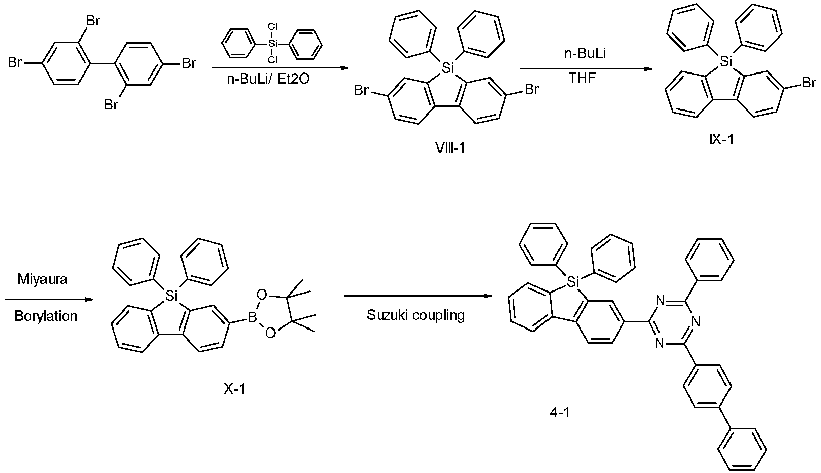

### Synthesis of 3,7-dibromo-5,5-diphenyl-benzo[b][1]benzosilole(VIII-1)

26 g (55.34 mmol) of 2,4,2',4'-Tetrabromo-biphenyl in 1000 mL of Et₂O under Ar atmosphere then cool at -78 °C. 46.4 mL (116 mmol / 2.5 M in hexane) of n-BuLi is added dropwise at -78 °C and the mixture is stirred for 1hr at the same temperature. Then, 14 g (55.34 mmol) dichlorodiphenylsilane in diethyl ether (100 mL) dropwise at -78 °C and the mixture is stirred for 1hr at the same temperature then allow to warm up to room temperature for 12 hrs. After reaction completion, the mixture is quenched with water. After extraction with EA (3 × 400 mL), drying over magnesium sulfate, filtrated and subsequently evaporate to dryness. The residue is purified by column chromatography. The yield is 15 g (30.47 mmol), corresponding to 54 % of theory.

The following compounds are synthesized analogously:

| Ex | Dichlorosilane | Tetrabrom-biphenyl | Product | Yield |
|---|---|---|---|---|
| VIII-1 | 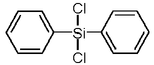 [80-10-4] | 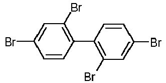 [66115-57-9] | 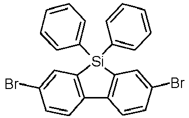 | 55% |
| VIII-2 | 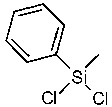 [149-74-6] | 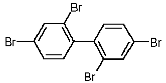 [66115-57-9] | 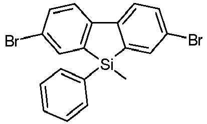 | 48% |
| VIII-3 | 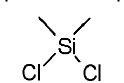 [75-78-5] | 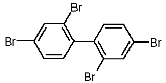 [66115-57-9] | 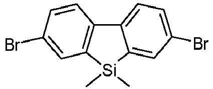 | 38% |
| VIII-4 | 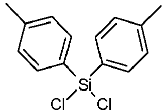 [18414-38-5] | 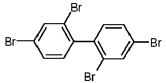 [66115-57-9] | 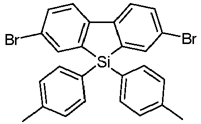 | 48% |
| VIII-5 | 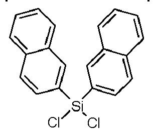 [1796541-30-4] | 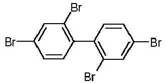 [66115-57-9] | 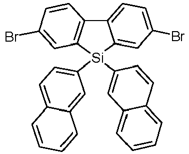 | 31% |
| VIII-6 | 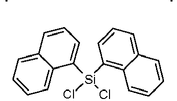 [18676-65-8] | 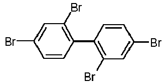 [66115-57-9] | 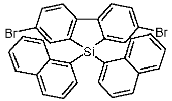 | 37% |
| VIII-7 | 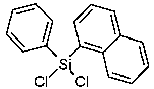 [7751-39-5] | 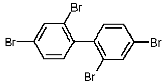 [66115-57-9] | 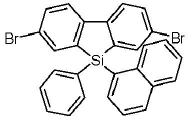 | 30% |

### Synthesis of 3-bromo-5,5-diphenyl-benzo[b][1] benzosilole (IX-1)

15 g (30.49 mmol) of compound(VIII-1) in 300 mL of THF under Ar atmosphere then cool at -78 °C. 12.2 mL (30.49 mmol / 2.5 M in hexane) of n-BuLi is added dropwise at -78 °C and the mixture is stirred for 2hrs at the same temperature. After reaction completion, the mixture is quenched with water. After extraction with EA (3 × 400 mL), drying over magnesium sulfate, filtrated and subsequently evaporate to dryness. The residue is purified by column chromatography. The yield is 7 g (16.93 mmol), corresponding to 55 % of theory.

The following compounds are synthesized analogously:

| Ex | Dibromo-dibenzosilole | Product | Yield |
|---|---|---|---|
| IX-1 | 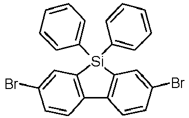 | 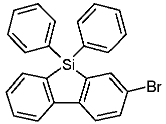 | 55% |
| IX-2 | 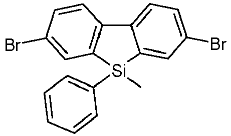 | 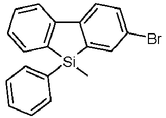 | 51% |
| IX-3 | 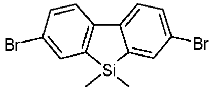 | 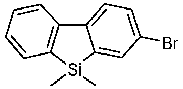 | 47% |
| IX-4 | 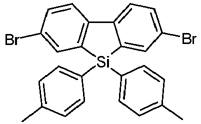 | 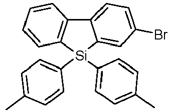 | 50% |
| IX-5 | 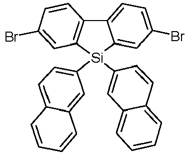 | 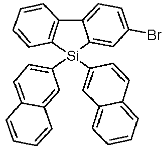 | 45% |
| IX-6 | 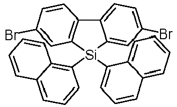 | 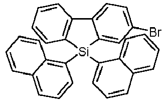 | 42% |
| IX-7 | 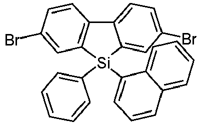 | 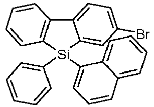 | 55% |

### Synthesis of 2-(5,5-diphenylbenzo[b][1] benzosilol-3-yl)-4,4,5,5-tetramethyl-1,3,2-dioxaborolane(X-1)

7 g (16.93 mmol) of compound(IX-1) and 5.12g (20.31 mmol) of bis(pinacolato)-diboron are suspended in 100 mL of DMF under Ar atmosphere. 3.57 g (33.69 mmol) of potassium acetate is added to the flask and stirred under Ar atmosphere. 0.59 g (0.50 mmol) of Pd(dppf)Cl₂ CH₂Cl₂ is added to the flask and stirred under Ar atmosphere. The reaction mixture is heated at 80 °C and stirred under Ar for 16 hrs. The reaction mixture is cooled to room temperature, the organic phase is quenched with water and extracted three times with 200 mL of EA and organic phase is washed three times with water, dried over magnesium sulfate, filtrated and subsequently evaporate to dryness. The residue is purified column chromatography with EA and Heptane.

The yield is 5.8 g (12.69 mmol), corresponding to 75 % of theory.

The following compounds are synthesized analogously:

| Ex | Bromo-dibenzosilole | Bis(pinacolato) diborane | Product | Yield |
|---|---|---|---|---|
| X-1 | 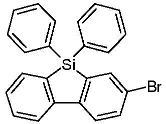 | 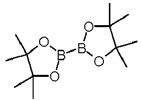 [73183-34-3] | 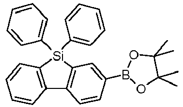 | 75% |
| X-2 | 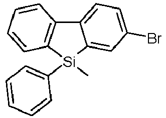 | 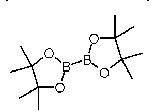 [73183-34-3] | 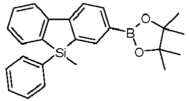 | 69% |
| X-3 | 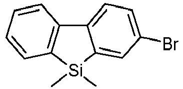 | 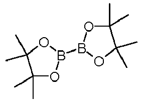 [73183-34-3] | 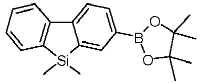 | 74% |
| X-4 | 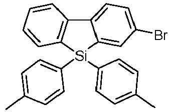 | 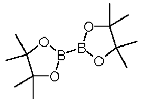 [73183-34-3] | 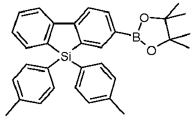 | 68% |
| X-5 | 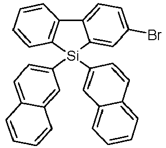 | 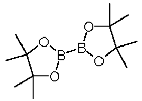 [73183-34-3] | 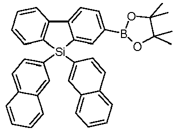 | 64% |
| X-6 | 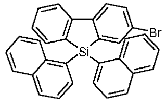 | 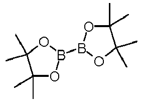 [73183-34-3] | 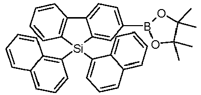 | 61% |
| X-7 | 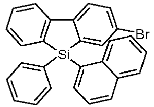 | 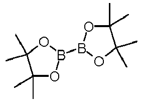 [73183-34-3] | 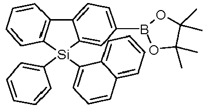 | 72% |

### Synthesis of 2-(5,5-diphenylbenzo[b][1] benzosilol-3-yl)-4-phenyl-6-(4-phenylphenyl)-1,3,5-triazine (4-1)

5.8 g (12.69 mmol) of compound(X-1) and 4.36 g (12.69 mmol) of compound(III-1) are suspended in 50 mL of 1,4-Dioxane, 40 mL of Toluene and 50mL of H₂O under Ar atmosphere. 2.95 g (27.91 mmol) of Sodium carbonate is added to the flask and stirred under Ar atmosphere. 0.43 g (0.38 mmol) of tetrakis(triphenyl-phosphine) palladium is added to the flask. The reaction mixture is heated at 110 °C and stirred under Ar for 16 hrs. The reaction mixture is cooled to room temperature, the organic phase is quenched with water and extracted three times with 200 mL of toluene, dried over magnesium sulfate, filtrated and subsequently evaporate to dryness. The residue is washed with ethyl acetate. The yield is 6.51 g (10.15 mmol), corresponding to 80 % of theory.

The following compounds are synthesized analogously where the asterix "*" marks non-inventive examples

| Ex | Boronic ester | Chloride | Product | Yield |
|---|---|---|---|---|
| 4-1 | 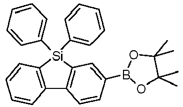 | 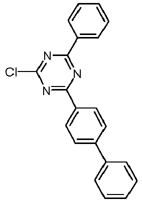 | 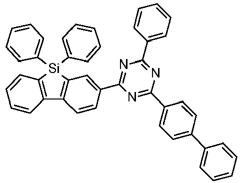 | 74% |
| 4-2 | 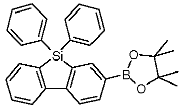 | 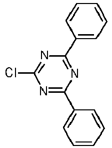 | 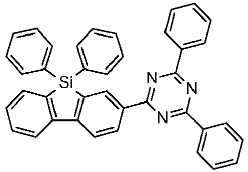 | 78% |
| 4-3 | 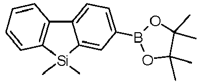 | 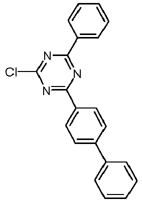 | 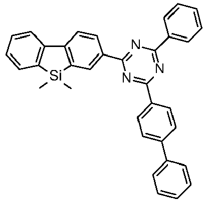 | 80% |
| 4-4 | 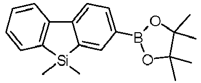 | 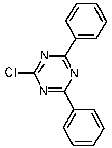 | 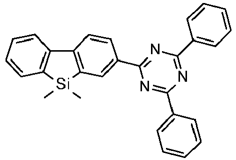 | 79% |
| 4-5* | 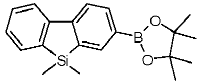 | 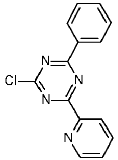 | 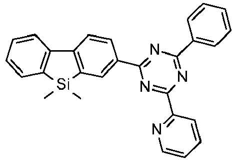 | |
| 4-6* | 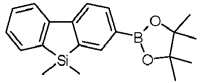 | 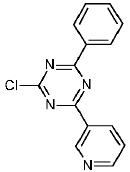 | 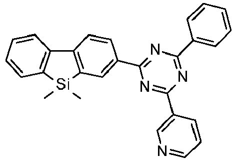 | 80% |
| 4-7* | 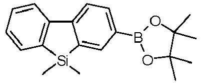 | 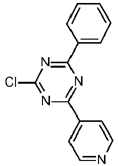 | 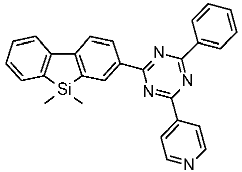 | 81% |
| 4-8 | 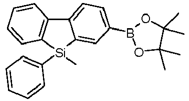 | 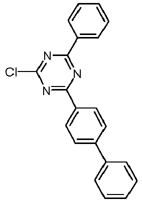 | 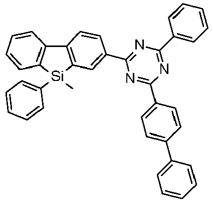 | 77% |
| 4-9 | 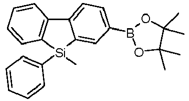 | 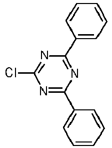 | 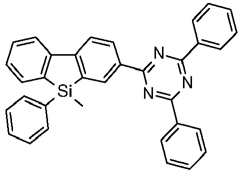 | 81% |
| 4-10 | 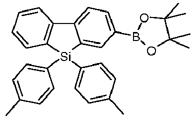 | 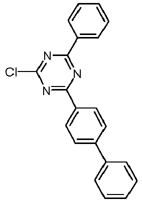 | 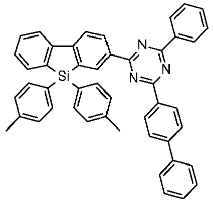 | 83% |
| 4-11 | 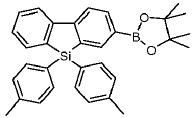 | 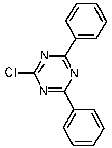 | 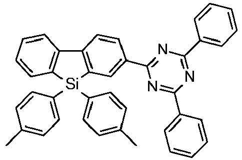 | 77% |
| 4-12 | 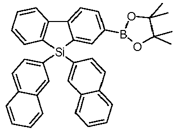 | 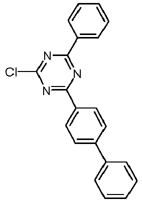 | 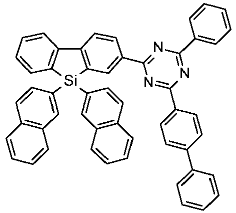 | 65% |
| 4-13 | 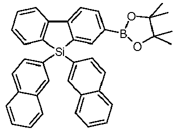 | 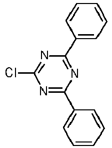 | 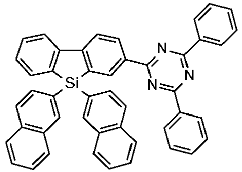 | 70% |
| 4-14 | 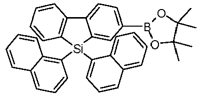 | 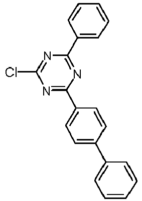 | 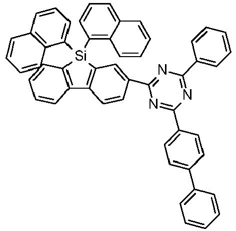 | 45% |
| 4-15 | 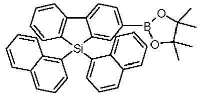 | 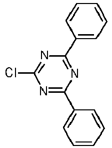 | 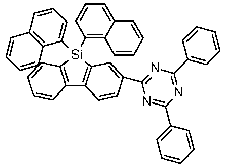 | 48% |
| 4-16 | 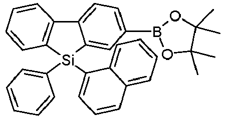 | 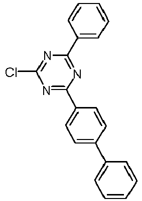 | 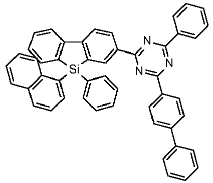 | 52% |
| 4-17 | 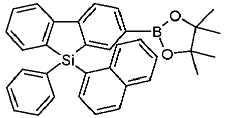 | 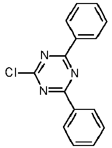 | 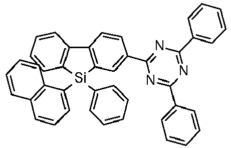 | 55% |

### Example 5

### Synthesis of 2-[4-(5,5-diphenylbenzo[b][1] benzosilol-3-yl) phenyl]-4-phenyl-6-(4-phenylphenyl)-1,3,5-triazine (5-1) and derivatives bis (5-2) and (5-28)

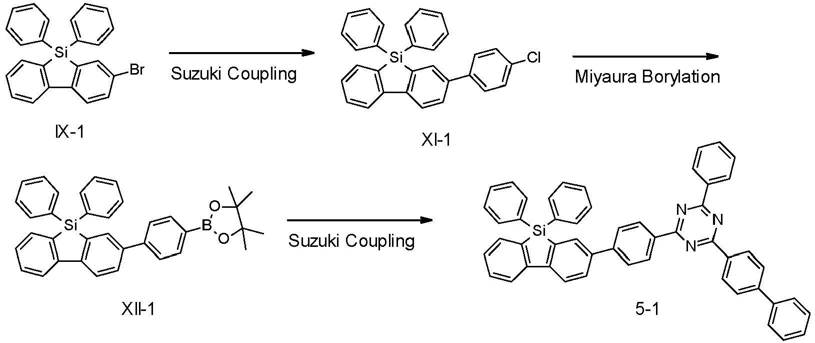

### Synthesis of 3-(4-chlorophenyl)-5,5-diphenyl-benzo[b][1] benzosilole (XI-1)

27.7 g (67 mmol) of compound(IX-1), 11.1 g (71 mmol) of 4-chloro-phenyl boronic acid and 14.3 g (134 mmol) of sodium carbonate are suspended in 500 mL of EtOH, 500 mL of H₂O and 200 mL of toluene and stirred under Ar atmosphere. 2.3 g (1.3 mmol) of tetrakis(triphenyl phosphine) palladium is added to the flask. The reaction mixture is heated at 110 °C and stirred under Ar for 16 hrs. The reaction mixture is cooled to room temperature, the reaction mixture is quenched. The organic phase is separated, washed three times with 200 mL of water, dried over magnesium sulfate, filtrated and subsequently evaporate to dryness. The residue is purified by column chromatography on silica gel using a mixture of DCM / heptane (1:10). The yield is 24.7 g (55 mmol), corresponding to 83% of theory.

The following compounds are synthesized analogously:

| Ex | Bromide | Aryl boronic acid | Product | Yield |
|---|---|---|---|---|
| XI-1 | 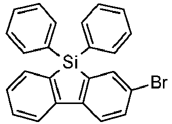 | 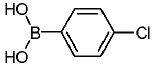 [1679-18-1] | 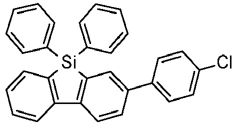 | 83% |
| XI-2 | 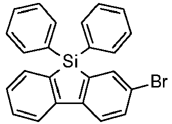 | 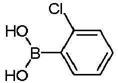 [3900-89-8] | 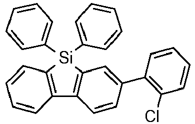 | 79% |
| XI-3 | 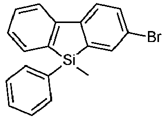 | 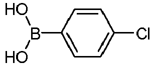 [1679-18-1] | 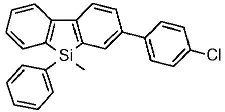 | 81% |
| XI-4 | 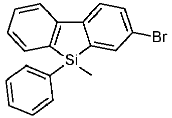 | 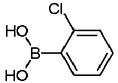 [3900-89-8] | 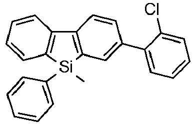 | 74% |
| XI-5 | 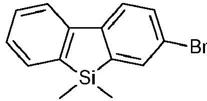 | 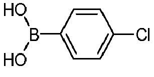 [1679-18-1] | 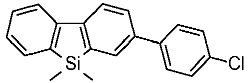 | 80% |
| XI-6 | 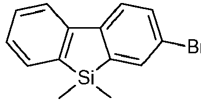 | 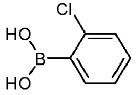 [3900-89-8] | 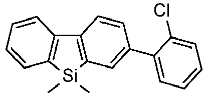 | 82% |
| XI-7 | 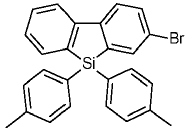 | 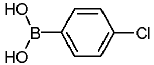 [1679-18-1] | 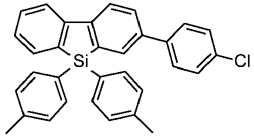 | 79% |
| XI-8 | 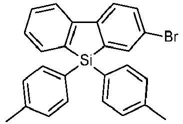 | 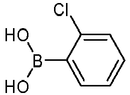 [3900-89-8] | 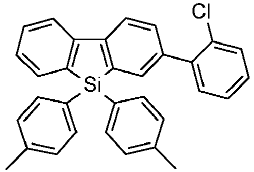 | 75% |
| XI-9 | 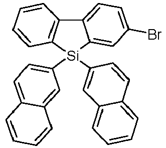 | 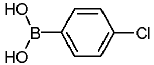 [1679-18-1] | 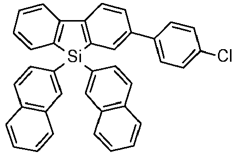 | 86% |
| XI-10 | 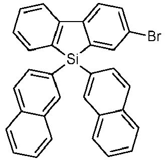 | 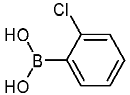 [3900-89-8] | 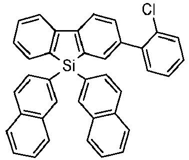 | 84% |
| XI-11 | 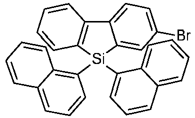 | 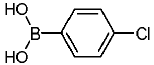 [1679-18-1] | 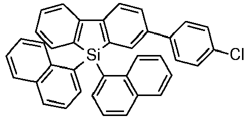 | 88% |
| XI-12 | 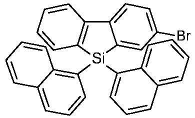 | 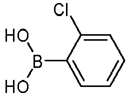 [3900-89-8] | 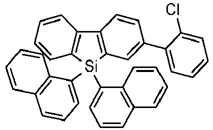 | 81% |
| XI-13 | 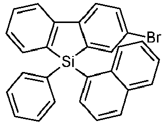 | 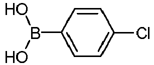 [1679-18-1] | 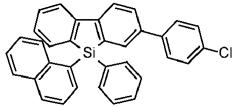 | 86% |
| XI-14 | 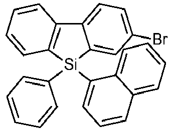 | 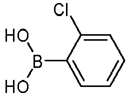 [3900-89-8] | 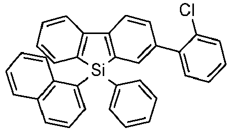 | 82% |

### Synthesis of 2-[4-(5,5-diphenylbenzo[b][1] benzosilol-3-yl) phenyl]-4,4,5,5-tetramethyl-1,3,2-dioxaborolane(XII-1)

5.0 g (11.23 mmol) of compound(XI-1) and 3.4g (13.48 mmol) of bis(pinacolato)-diborane are suspended in 30 mL of DMF under Ar atmosphere. 2.62 g (24.7 mmol) of potassium acetate is added to the flask and stirred under Ar atmosphere. 0.39 g (0.33 mmol) of Pd(dppf)Cl₂ CH₂Cl₂ is added to the flask and stirred under Ar atmosphere. The reaction mixture is heated at 80 °C and stirred under Ar for 16 hrs. The reaction mixture is cooled to room temperature, the organic phase is quenched with water and extracted three times with 100 mL of EA and organic phase is washed three times with water, dried over magnesium sulfate, filtrated and subsequently evaporate to dryness. The residue is purified column chromatography with EA and Heptane. The yield is 4.9 g (9.2 mmol), corresponding to 82 % of theory.

The following compounds are synthesized analogously:

| Ex | Chloride | Bis(pinacolato) diborane | Product | Yield |
|---|---|---|---|---|
| XII-1 | 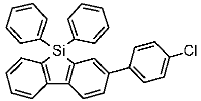 | 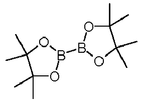 [73183-34-3] | 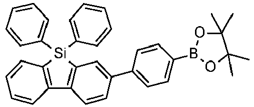 | 82% |
| XII-2 | 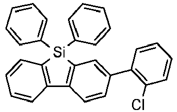 | 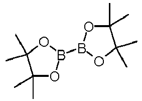 [73183-34-3] | 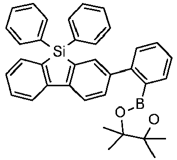 | 77% |
| XII-3 | 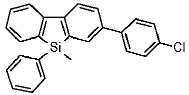 | 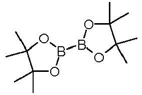 [73183-34-3] | 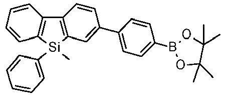 | 78% |
| XII-4 | 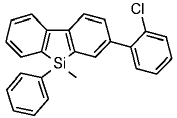 | 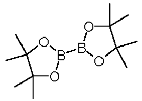 [73183-34-3] | 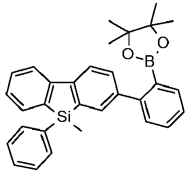 | 75% |
| XII-5 | 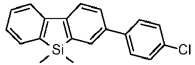 | 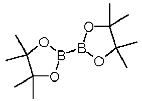 [73183-34-3] | 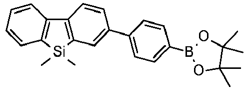 | 81% |
| XII-6 | 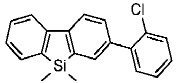 | 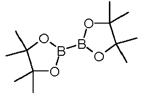 [73183-34-3] | 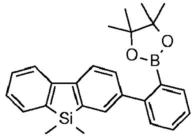 | 79% |
| XII-7 | 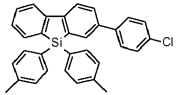 | 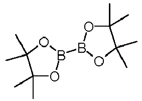 [73183-34-3] | 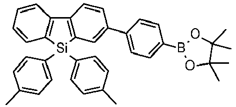 | 81% |
| XII-8 | 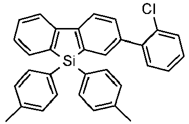 | 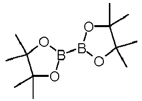 [73183-34-3] | 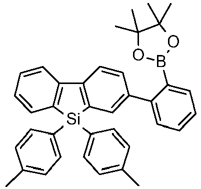 | 77% |
| XII-9 | 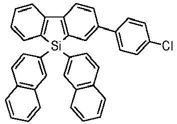 | 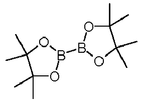 [73183-34-3] | 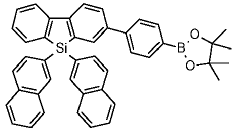 | 85% |
| XII-10 | 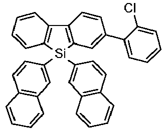 | 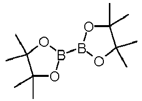 [73183-34-3] | 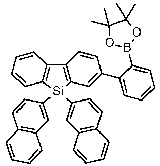 | 81% |
| XII-11 | 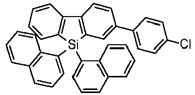 | 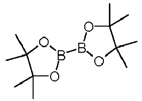 [73183-34-3] | 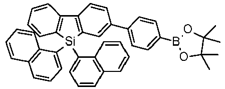 | 77% |
| XII-12 | 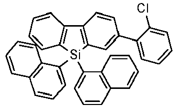 | 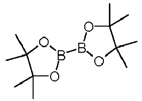 [73183-34-3] | 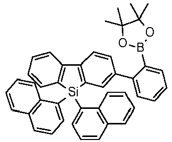 | 75% |
| XII-13 | 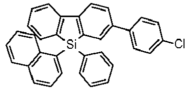 | 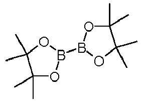 [73183-34-3] | 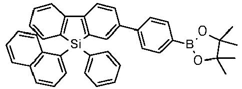 | 79% |
| XII-14 | 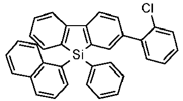 | 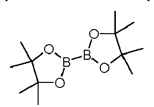 [73183-34-3] | 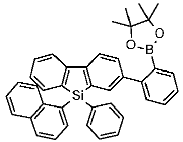 | 72% |

### Synthesis of 2-[4-(5,5-diphenylbenzo[b][1] benzosilol-3-yl) phenyl]-4-phenyl-6-(4-phenylphenyl)-1,3,5-triazine (5-1)

5.8 g (12.69 mmol) of compound(XII-1) and 4.36 g (12.69 mmol) of compound(III-1) are suspended in 50 mL of 1,4-Dioxane, 40 mL of Toluene and 50mL of H₂O under Ar atmosphere. 2.95 g (27.91 mmol) of Sodium carbonate is added to the flask and stirred under Ar atmosphere. 0.43 g (0.38 mmol) of tetrakis(triphenyl-phosphine) palladium is added to the flask. The reaction mixture is heated at 110 °C and stirred under Ar for 16 hrs. The reaction mixture is cooled to room temperature, the organic phase is quenched with water and extracted three times with 200 mL of toluene, dried over magnesium sulfate, filtrated and subsequently evaporate to dryness. The residue is washed with ethyl acetate. The yield is 7.56 g (10.53 mmol), corresponding to 83 % of theory.

The following compounds are synthesized analogously:

| Ex | Boronic ester | Chloride | Product | Yield |
|---|---|---|---|---|
| 5-1 | 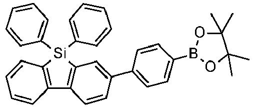 | 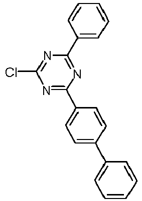 | 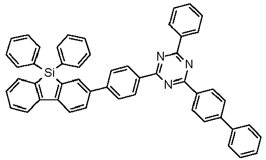 | 85% |
| 5-2 | 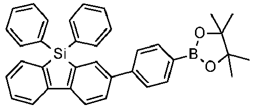 | 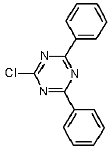 | 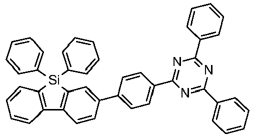 | 78% |
| 5-3 | 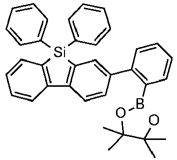 | 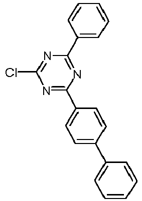 | 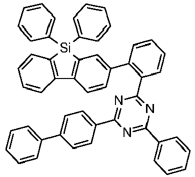 | 79% |
| 5-4 | 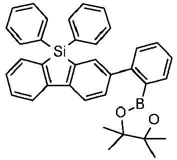 | 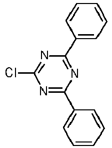 | 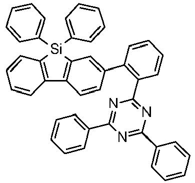 | 80% |
| 5-5 | 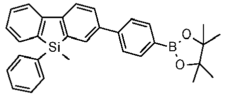 | 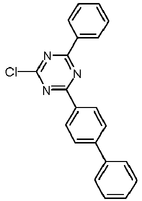 | 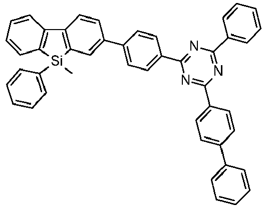 | 80% |
| 5-6 | 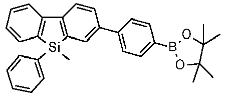 | 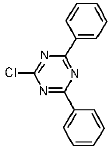 | 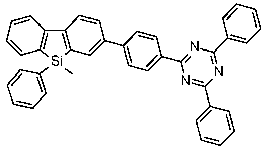 | 82% |
| 5-7 | 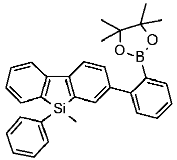 | 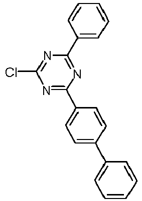 | 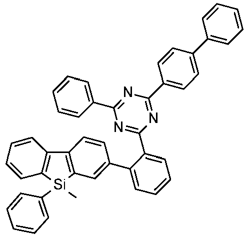 | 79% |
| 5-8 | 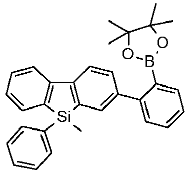 | 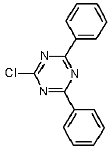 | 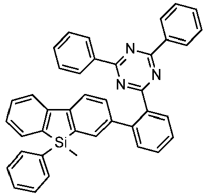 | 77% |
| 5-9 | 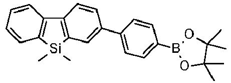 | 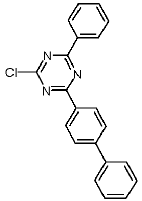 | 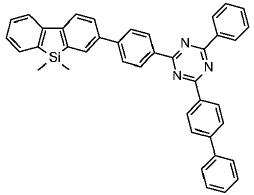 | 75% |
| 5-10 | 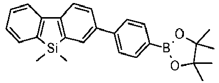 | 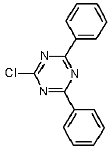 | 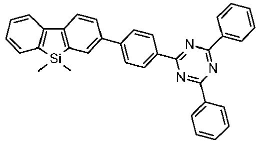 | 78% |
| 5-11 | 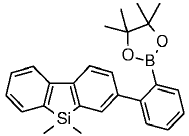 | 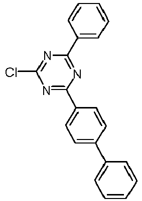 | 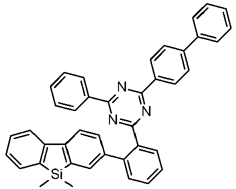 | 81% |
| 5-12 | 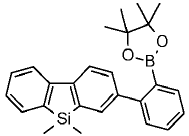 | 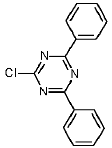 | 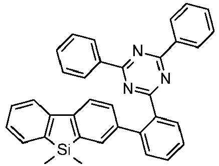 | 79% |
| 5-13 | 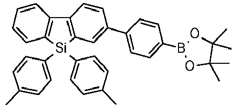 | 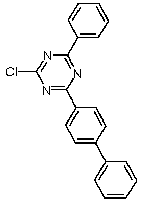 | 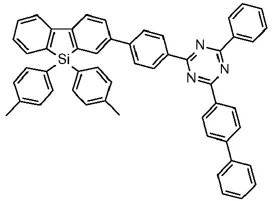 | 83% |
| 5-14 | 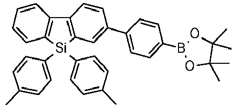 | 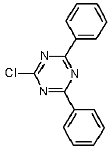 | 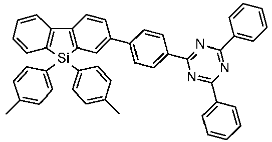 | 84% |
| 5-15 | 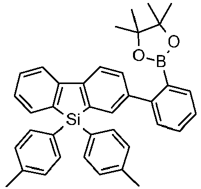 | 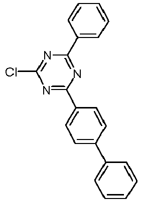 | 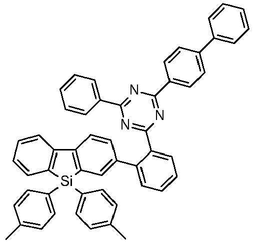 | 83% |
| 5-16 | 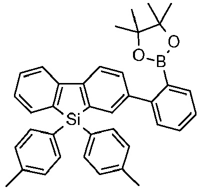 | 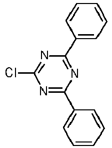 | 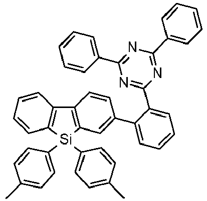 | 72% |
| 5-17 | 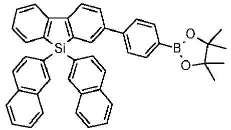 | 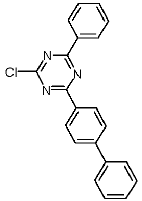 | 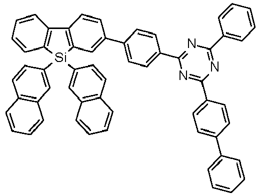 | 75% |
| 5-18 | 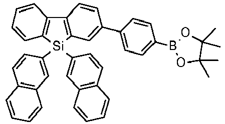 | 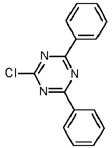 | 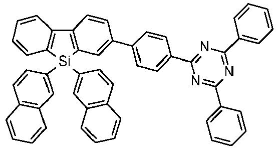 | 78% |
| 5-19 | 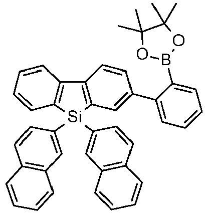 | 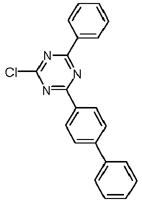 | 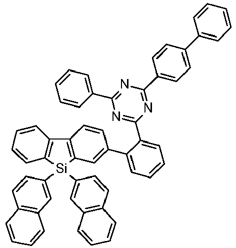 | 69% |
| 5-20 | 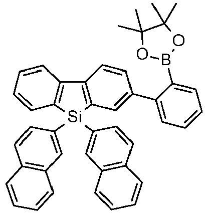 | 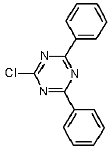 | 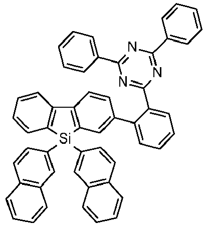 | 70% |
| 5-21 | 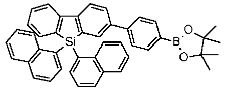 | 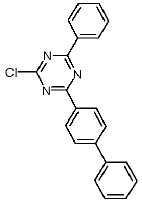 | 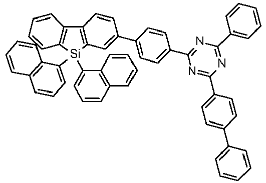 | 67% |
| 5-22 | 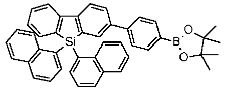 | 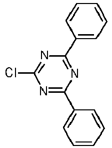 | 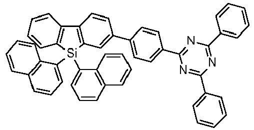 | 69% |
| 5-23 | 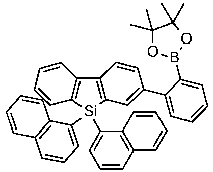 | 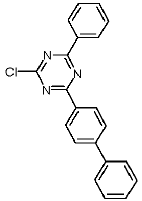 | 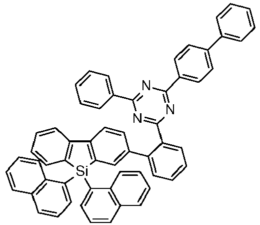 | 67% |
| 5-24 | 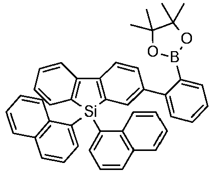 | 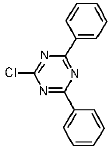 | 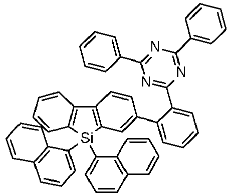 | 65% |
| 5-25 | 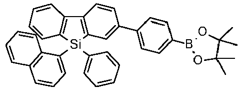 | 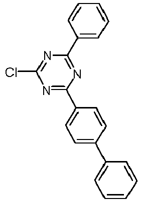 | 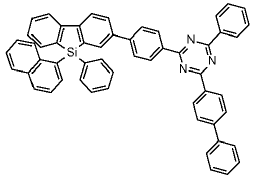 | 79% |
| 5-56 | 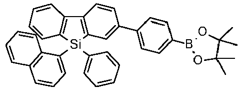 | 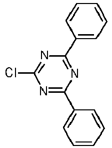 | 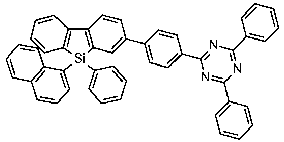 | 81% |
| 5-27 | 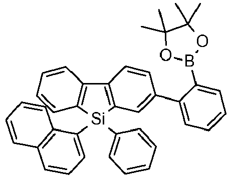 | 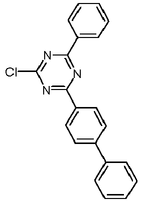 | 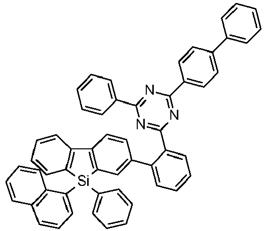 | 76% |
| 5-28 | 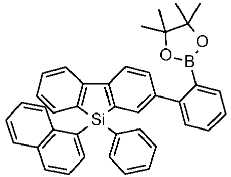 | 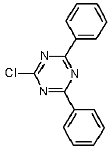 | 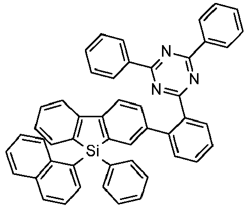 | 78% |

### Example 6

### Synthesis of 2-(5,5-diphenylbenzo[b][1]benzosilol-2-yl)-4-phenyl-6-(4-phenylphenyl)-1,3,5-triazine(6-1) and derivatives (6-2) and (6-3)

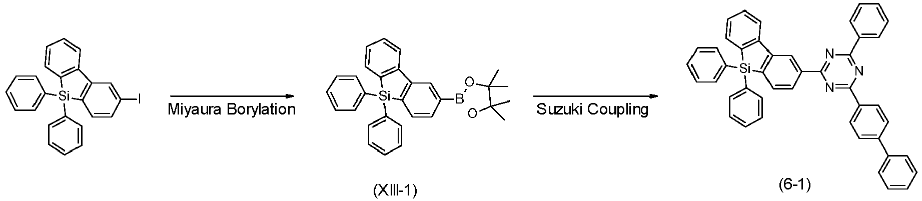

### Synthesis of 2-(5,5-diphenylbenzo[b][1]benzosilol-2-yl)-4,4,5,5-tetramethyl-1,3,2-dioxaborolane(XIII-1)

5.0 g (10.86 mmol) of 2-iodo-5,5-diphenyl-benzo[b][1]benzosilole (from WO1610-9386) and 3.3g (13.03 mmol) of bis(pinacolato)diborane are suspended in 30 mL of DMF under Ar atmosphere. 2.4g (23.9 mmol) of potassium acetate is added to the flask and stirred under Ar atmosphere. 0.39 g (0.33 mmol) of Pd(dppf)Cl₂ CH₂Cl₂ is added to the flask and stirred under Ar atmosphere. The reaction mixture is heated at 80 °C and stirred under Ar for 16 hrs. The reaction mixture is cooled to room temperature, the organic phase is quenched with water and extract three times with 100 mL of EA and organic phase is washed three times with water, dried over magnesium sulfate, filtrated and subsequently evaporate to dryness. The residue is purified column chromatography with EA and Heptane.

The yield is 4.3 g (9.2 mmol), corresponding to 85 % of theory.

### Synthesis of 2-(5,5-diphenylbenzo[b][1]benzosilol-2-yl)-4-phenyl-6-(4-phenylphenyl)-1,3,5-triazine(6-1)

5.8 g (12.69 mmol) of compound(XIII-1) and 4.36 g (12.69 mmol) of compound(III-1) are suspended in 50 mL of 1,4-Dioxane, 40 mL of Toluene and 50mL of H2O under Ar atmosphere. 2.95 g (27.91 mmol) of sodium carbonate is added to the flask and stirred under Ar atmosphere. 0.43 g (0.38 mmol) of tetrakis (triphenylphosphine) palladium is added to the flask. The reaction mixture is heated at 110 °C and stirred under Ar for 16 hrs.

The reaction mixture is cooled to room temperature, the organic phase is quenched with water and extract three times with 200 mL of toluene, dry over magnesium sulfate, filtrated and subsequently evaporate to dryness. The residue is washed with ethyl acetate. The yield is 6.51 g (10.15 mmol), corresponding to 80 % of theory.

The following compounds are synthesized analogously where the asterix "*" marks non-inventive examples:

| Ex | Boronic ester | Chloride | Product | Yield |
|---|---|---|---|---|
| 6-1 | 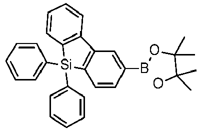 [1964439-61-9] | 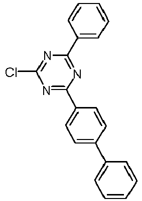 | 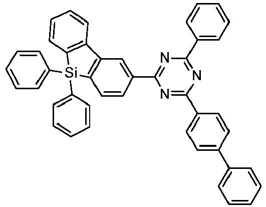 | 80% |
| 6-2 | 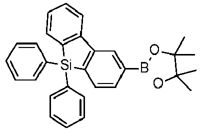 [1964439-61-9] | 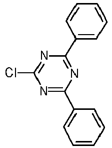 | 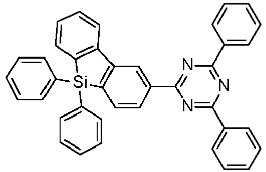 | 83% |
| 6-3* | 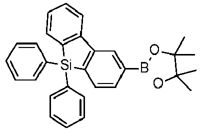 [1964439-61-9] | 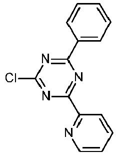 | 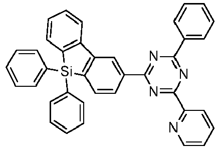 | 81% |

### B) Devices examples

OLED devices are prepared according to the following process:
The substrates used are glass plates coated with structured ITO (indium tin oxide) in a thickness of 50nm. The OLEDs have the following layer structure: substrate / hole-injection layer (HIL) / hole-transport layer (HTL) / hole-injection layer (HTL2) / electron-blocking layer (EBL) / emission layer (EML) / electron-transport layer (ETL) / electron-injection layer (EIL) and finally a cathode. The cathode is formed by an aluminum layer with a thickness of 100nm. The precise structure of the prepared OLEDs is shown in Table 1. The materials required for the production of the OLEDs are shown in Table 3.

All materials are evaporated by thermal vapor deposition in a vacuum chamber. The emission layer always consists of minimum one matrix material (host material) and an emitting dopant (emitter), which is admixed with the matrix material or matrix materials in a certain proportion by volume by co-evaporation. An expression such as H1:SEB (5%) denotes that material H1 is present in the layer in a proportion by volume of 95% and SEB is present in the layer in a proportion of 5%. Analogously, other layers may also consist of a mixture of two or more materials.

The OLEDs are characterized by standard methods. For this purpose, the electroluminescence spectra and the external quantum efficiency (EQE, measured in per cent) as a function of the luminous density, calculated from current/voltage/luminous density characteristic lines (IUL characteristic lines) assuming Lambertian emission characteristics, and the lifetime are determined. The expression EQE @ 10mA/cm² denotes the external quantum efficiency at an operating current density of 10mA/cm². LT80 @ 60mA/cm² is the lifetime until the OLED has dropped from its initial luminance of i.e. 5000cd/m² to 80% of the initial intensity, i.e. to 4000cd/m² without using any acceleration factor. The data for the various OLEDs containing inventive and comparative materials are summarized in Table 2.

Compounds according to the invention are suitable as ETL or matrix material in the EML in OLEDs. They are suitable as a single layer, but also as mixed component as EIL, ETL or within the EML.

Compared with compounds from prior art (C1 to C4), the samples comprising the compounds according to the invention (E1 to E10 and E13 to E16) exhibit both higher efficiencies and also improved lifetimes in singlet blue emitting devices. In the following, the asterix "*" marks non-inventive examples.

| Table 1: Structure of the OLEDs | | | | | | | |
|---|---|---|---|---|---|---|---|
| Ex | HIL | HTL | HTL2 | EBL | EML | ETL | EIL |
| | Thickness / nm | Thickness / nm | Thickness / nm | Thickness / nm | Thickness / nm | Thickness / nm | Thickness / nm |
| C1 | HIM:F4TC NQ(5%) 20nm | HIM 160nm | HTM:F4TC NQ(5%) 20nm | HTM 10nm | H1:SEB(5%) 20 nm | ETMc3:LiQ (50%) 30 nm | LiQ 1nm |
| E1 | HIM:F4TC NQ(5%) 20nm | HIM 160nm | HTM:F4TC NQ(5%) 20nm | HTM 10nm | H1:SEB(5%) 20 nm | ETM1:LiQ (50%) 30 nm | LiQ 1nm |
| E2 | HIM:F4TC NQ(5%) 20nm | HIM 160nm | HTM:F4TC NQ(5%) 20nm | HTM 10nm | H1:SEB(5%) 20 nm | ETM2:LiQ (50%) 30 nm | LiQ 1nm |
| E3 | HIM:F4TC NQ(5%) 20nm | HIM 160nm | HTM:F4TC NQ(5%) 20nm | HTM 10nm | H1:SEB(5%) 20 nm | ETM3:LiQ (50%) 30 nm | LiQ 1nm |
| E4 | HIM:F4TC NQ(5%) 20nm | HIM 160nm | HTM:F4TC NQ(5%) 20nm | HTM 10nm | H1:SEB(5%) 20 nm | ETM4:LiQ (50%) 30 nm | LiQ 1nm |
| E5 | HIM:F4TC NQ(5%) 20nm | HIM 160nm | HTM:F4TC NQ(5%) 20nm | HTM 10nm | H1:SEB(5%) 20 nm | ETM5:LiQ (50%) 30 nm | LiQ 1nm |
| E6 | HIM:F4TC NQ(5%) 20nm | HIM 160nm | HTM:F4TC NQ(5%) 20nm | HTM 10nm | H1:SEB(5%) 20 nm | ETM6:LiQ (50%) 30 nm | LiQ 1nm |
| E7 | HIM:F4TC NQ(5%) 20nm | HIM 160nm | HTM:F4TC NQ(5%) 20nm | HTM 10nm | H1:SEB(5%) 20 nm | ETM7:LiQ (50%) 30 nm | LiQ 1nm |
| E8 | HIM:F4TC NQ(5%) 20nm | HIM 160nm | HTM:F4TC NQ(5%) 20nm | HTM 10nm | H1:SEB(5%) 20 nm | ETM8:LiQ (50%) 30 nm | LiQ 1nm |
| E9 | HIM:F4TC NQ(5%) 20nm | HIM 160nm | HTM:F4TC NQ(5%) 20nm | HTM 10nm | H1:SEB(5%) 20 nm | ETM9:LiQ (50%) 30 nm | LiQ 1nm |
| E10 | HIM:F4TC NQ(5%) 20nm | HIM 160nm | HTM:F4TC NQ(5%) 20nm | HTM 10nm | H1:SEB(5%) 20 nm | ETM10:LiQ (50%) 30 nm | LiQ 1nm |
| E11* | HIM:F4TC NQ(5%) 20nm | HIM 160nm | HTM:F4TC NQ(5%) 20nm | HTM 10nm | H1:SEB(5%) 20 nm | ETM11:LiQ (50%) 30 nm | LiQ 1nm |
| E12* | HIM:F4TC NQ(5%) 20nm | HIM 160nm | HTM:F4TC NQ(5%) 20nm | HTM 10nm | H1:SEB(5%) 20 nm | ETM12:LiQ (50%) 30 nm | LiQ 1nm |
| E13 | HIM:F4TC NQ(5%) 20nm | HIM 160nm | HTM:F4TC NQ(5%) 20nm | HTM 10nm | H1:SEB(5%) 20 nm | ETM13:LiQ (50%) 30 nm | LiQ 1nm |
| E14 | HIM:F4TC NQ(5%) 20nm | HIM 160nm | HTM:F4TC NQ(5%) 20nm | HTM 10nm | H1:SEB(5%) 20 nm | ETM14:LiQ (50%) 30 nm | LiQ 1nm |
| E15 | HIM:F4TC NQ(5%) 20nm | HIM 160nm | HTM:F4TC NQ(5%) 20nm | HTM 10nm | H1:SEB(5%) 20 nm | ETM15:LiQ (50%) 30 nm | LiQ 1nm |
| E16 | HIM:F4TC NQ(5%) 20nm | HIM 160nm | HTM:F4TC NQ(5%) 20nm | HTM 10nm | H1:SEB(5%) 20 nm | ETM16:LiQ (50%) 30 nm | LiQ 1nm |
| E17* | HIM:F4TC NQ(5%) 20nm | HIM 160nm | HTM:F4TC NQ(5%) 20nm | HTM 10nm | H1:SEB(5%) 20 nm | ETM17:LiQ (50%) 30 nm | LiQ 1nm |
| E18* | HIM:F4TC NQ(5%) 20nm | HIM 160nm | HTM:F4TC NQ(5%) 20nm | HTM 10nm | H1:SEB(5%) 20 nm | ETM18:LiQ (50%) 30 nm | LiQ 1nm |
| E19* | HIM:F4TC NQ(5%) 20nm | HIM 160nm | HTM:F4TC NQ(5%) 20nm | HTM 10nm | H1:SEB(5%) 20 nm | ETM19:LiQ (50%) 30 nm | LiQ 1nm |
| E20* | HIM:F4TC NQ(5%) 20nm | HIM 160nm | HTM:F4TC NQ(5%) 20nm | HTM 10nm | H1:SEB(5%) 20 nm | ETM20:LiQ (50%) 30 nm | LiQ 1nm |

| Table 2: Data for the OLEDs | | |
|---|---|---|
| Ex. | EQE @ 10mA/cm² | LT80 @ 60mA/cm² |
| C1 | 7.5 | 300 |
| E1 | 7.8 | 350 |
| E2 | 8.2 | 370 |
| E3 | 8.3 | 350 |
| E4 | 7.9 | 340 |
| E5 | 8.3 | 360 |
| E6 | 7.9 | 350 |
| E7 | 8.4 | 400 |
| E8 | 8.0 | 360 |
| E9 | 8.5 | 360 |
| E10 | 8.5 | 350 |
| E11* | 8.1 | 330 |
| E12* | 8.5 | 340 |
| E13 | 8.7 | 370 |
| E14 | 8.0 | 400 |
| E15 | 7.8 | 360 |
| E16 | 8.1 | 360 |
| E17* | 7.7 | 360 |
| E18* | 7.3 | 290 |
| E19* | 7.5 | 290 |
| E20* | 7.2 | 320 |

| Table 3 - Structures of the materials used | | |
|---|---|---|
| 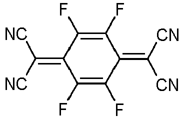 | 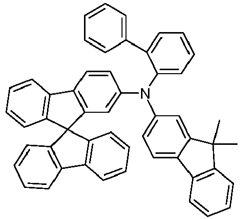 | 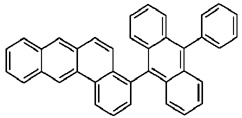 |
| F4TCNQ | HIM | H1 |
| 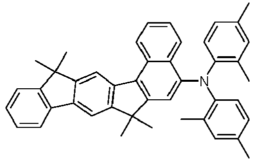 | 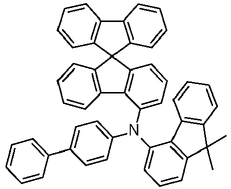 | 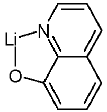 |
| SEB | HTM | LiQ |
| 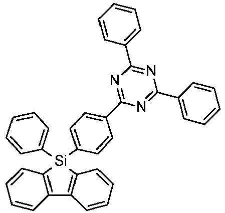 | 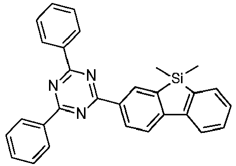 | 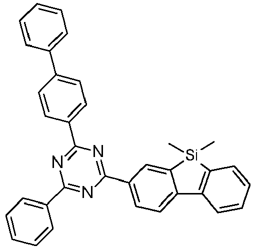 |
| ETMc1 | ETM1 | ETM2 |
| 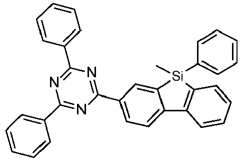 | 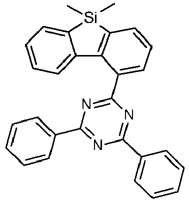 | 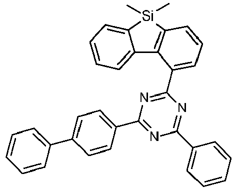 |
| ETM3 | ETM4 | ETM5 |
| 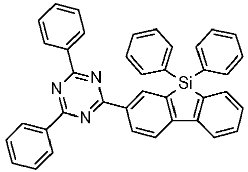 | 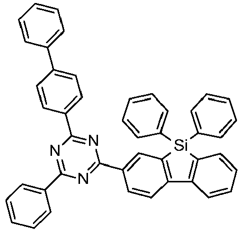 | 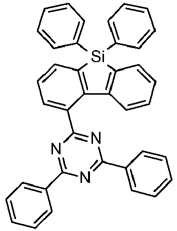 |
| ETM6 | ETM7 | ETM8 |
| 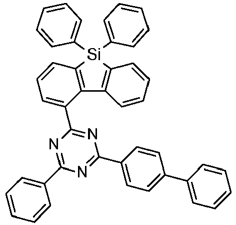 | 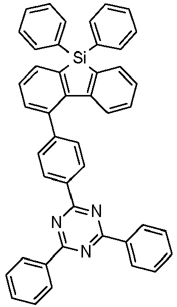 | 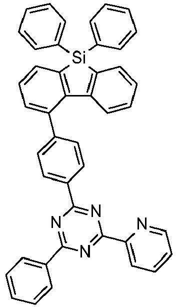 |
| ETM9 | ETM10 | ETM11* |
| 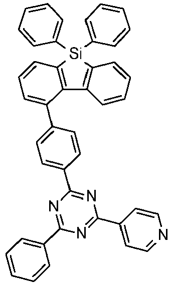 | 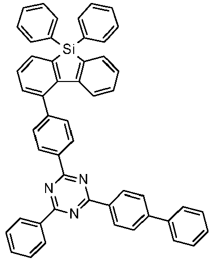 | 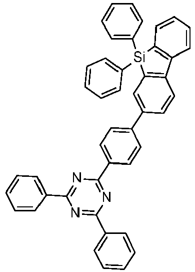 |
| ETM12* | ETM13 | ETM14 |
| 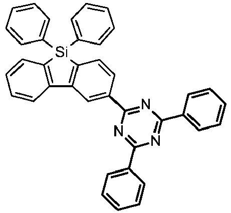 | 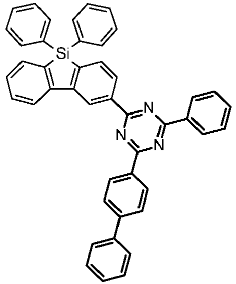 | 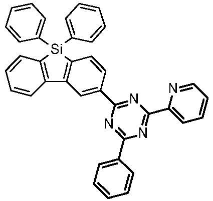 |
| ETM15 | ETM16 | ETM17* |
| 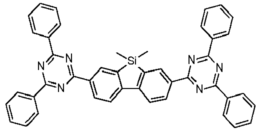 | 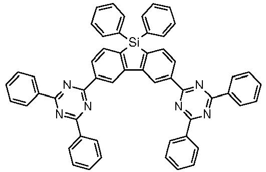 | 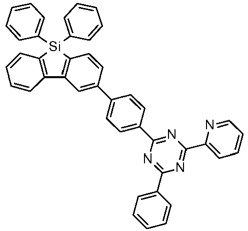 |
| ETM18* | ETM19* | ETM20* |

In the above examples, it is shown, that the external quantum efficiency of the device @ 10mA/cm² with inventive materials ETM1 to ETM10 and ETM13 to ETM16 is higher than the one of the comparative example 1. Even in lifetime the inventive examples E1 to E10 and E13 to E16 are much better than the reference. The device with ETM7 and ETM14 have a lifetime down to 80% of its initial brightness @ 60mA/cm² constant driving current density of 400h. The comparative example achieves 300h.

The comparision of inventive materials ETM1 to ETM10 and ETM13 to ETM16 with the non-inventive materials ETM18 and ETM19 show that an unexpected improvement can be achieved with materials having exactly one triazine group. The inventive examples ETM1 to ETM10 and ETM13 to ETM16 do show higher lifetimes than the Examples ETM18 and EMT19 with 330h and twice 400h.

Furthermore, the comparision of inventive materials ETM1 to ETM10 and ETM13 to ETM16 with the non-inventive material EMT20 show that the combination of an aryl linking group with a pyridinyl group as residue Ar¹, a phenyl group as residue Ar², two phenyl groups as residue R^{a} and a 3 position substitution of silafluorene group shows remarkably disadvantages. Although the lifetime of Example E20 is better than reference Example C1, the results of Example E20 in view of the preferred inventive Examples E1 to E10 and E13 to E16 are rather low. In particular the comparison of E12 and E20 shows the effect of the position of the substituent.

In addition thereto, the present examples show that inventive compounds according to formulae (I-1), (I-2), (I-3) or (I-4) having an Ar¹ or Ar² residue comprising an aryl group having two or more aromatic rings provide astonishing improvements in lifetime and EQE (E4 compared E5 and E6 compared E7) if the residue R^{a} are alkyl groups or the silafluorene group is substutited at 2- position. In the case that the silafluorene group is substutited at 4- position, astonishing improvements in EQE can be achieved (E8 compared E9).

Furthermore, the present examples show that inventive compounds according to formulae (I-1), (I-2), (I-3) or (I-4) having an R^{a} residue comprising an aryl or heteroaryl group provide astonishing improvements in EQE in view of compounds having only alkyl groups as residue R^{a} (E1 compared E3 and E6, respecitively).

Moreover, the present examples show that a substitution of the silafluorene group at 2- or 4-position is preferred over a substitution in 3 position (E6 and E8 compared E15).

Devices for direct comparison, from which the technical effect according to the invention can be seen, are
i) C1 compared to E6 to E9, and E15 to E16
ii) E18 compared to E1 to E5,
iii) E19 compared to E15 to E16, and
iv) E20 compared to E10 to E16.

## Claims

1. Compound of a formula (I-1), (I-2), (I-3) or (I-4) 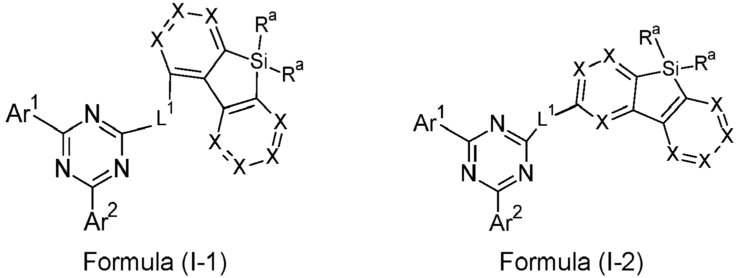 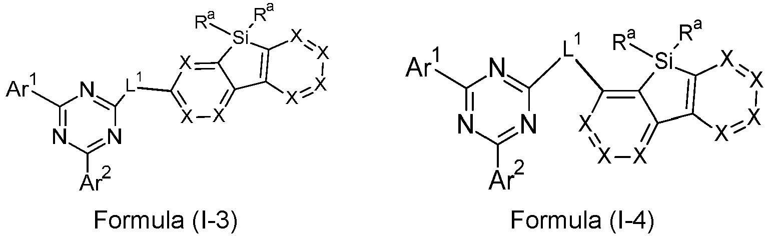 where the following applies to the variable groups:
Ar¹, Ar² are selected, identically or differently on each occurrence, from aromatic ring systems having 6 to 40 aromatic ring atoms, which may be substituted by one or more radicals R¹;
L¹ is a single bond or a group selected from aromatic ring systems having 6 to 50 aromatic ring atoms, each of which may be substituted by one or more radicals R²;
X is, identically or differently on each occurrence, selected from CR¹ and N;
R^{a} is selected, identically or differently at each occurrence, from H, D, F, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals R^{a} may be connected to each other to form a ring; where the said alkyl, alkoxy, alkenyl and alkynyl groups and the said aromatic and heteroaromatic ring systems may in each case be substituted by one or more radicals R², and where one or more CH₂ groups in the said alkyl, alkoxy, alkenyl and alkynyl groups may in each case be replaced by -R²C=CR²-, -C=C-, Si(R²)₂, C=O, C=NR², -C(=O)O-, -C(=O)NR²-, NR², P(=O)(R²), -O-, -S-, SO or SO₂;
R¹ is selected, identically or differently at each occurrence, from H, D, F, C(=O)R², CN, Si(R²)₃, P(=O)(R²)₂, OR², S(=O)R², S(=O)₂R², straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms; where two or more radicals R¹ may be connected to each other to form a ring; where the said alkyl, alkoxy, alkenyl and alkynyl groups and the said aromatic ring systems may in each case be substituted by one or more radicals R², and where one or more CH₂ groups in the said alkyl, alkoxy, alkenyl and alkynyl groups may in each case be replaced by - R²C=CR²-, -C≡C-, Si(R²)₂, C=O, C=NR², -C(=O)O-, -C(=O)NR²-, NR², P(=O)(R²), -O-, -S-, SO or SO₂;
R² is selected, identically or differently at each occurrence, from H, D, F, C(=O)R³, CN, Si(R³)₃, N(R³)₂, P(=O)(R³)₂, OR³, S(=O)R³, S(=O)₂R³, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals R² may be connected to each other to form a ring; where the said alkyl, alkoxy, alkenyl and alkynyl groups and the said aromatic and heteroaromatic ring systems may in each case be substituted by one or more radicals R³, and where one or more CH₂ groups in the said alkyl, alkoxy, alkenyl and alkynyl groups may in each case be replaced by -R³C=CR³-, -C≡C-, Si(R³)₂, C=O, C=NR³, -C(=O)O-, -C(=O)NR³-, NR³, P(=O)(R³), -O-, -S-, SO or SO₂; and
R³ is selected, identically or differently at each occurrence, from H, D, F, CN, alkyl groups having 1 to 20 C atoms, aromatic ring systems having 6 to 40 C atoms, or heteroaromatic ring systems having 5 to 40 aromatic ring atoms; where two or more radicals R³ may be connected to each other to form a ring; and where the said alkyl groups, aromatic ring systems and heteroaromatic ring systems may be substituted by F and CN.

2. Compound according to claim 1, **characterized in that** the compound includes exactly one triazine group.

3. Compound according to one or more of claims 1 to 2, **characterized in that** the group Ar¹ is different to the group Ar².

4. Compound according to one or more of claims 1 to 3, **characterized in that** the group Ar² comprises more aromatic ring atoms than the group Ar¹.

5. Compound according to one or more of claims 1 to 4, **characterized in that** the group Ar¹comprises at least two aromatic rings which may be condensed or non-condensed.

6. Compound according to one or more of claims 1 to 5, **characterized in that** the group Ar² comprises at least two aromatic rings which may be condensed or non-condensed.

7. Compound according to one or more of claims 1 to 6, **characterized in that** the compound conforms to one of formulae (I-1), (I-3) and (I-4), wherein compounds of formulae (I-1) and (I-4) are especially preferred.

8. Compound according to one or more of claims 1 to 7, **characterized in that** the compound conforms to one of formulae (I-5), (I-6), (I-7) and (I-8) 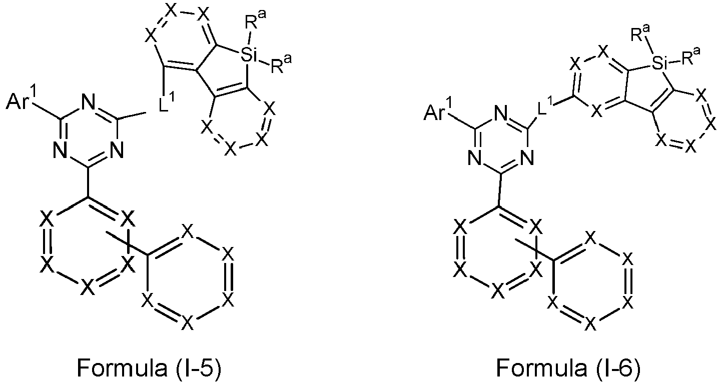 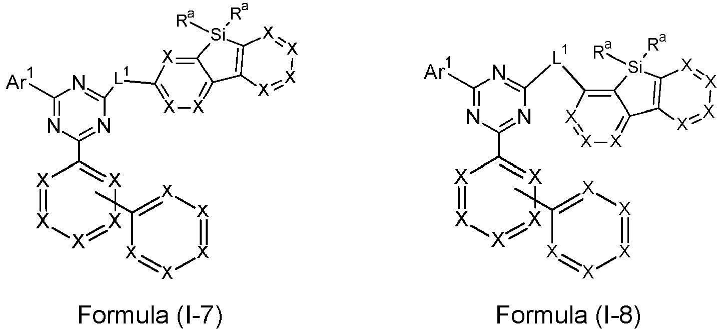 where the variables occurring are defined as in one or more of claims 1 to 5, wherein compounds of formulae (I-5), (I-7) and (I-8) are preferred and compounds of formulae (I-5) and (I-8) are especially preferred.

9. Compound according to one or more of claims 1 to 8, **characterized in that** the compound conforms to one of formulae (I-5a), (I-6a), (I-7a) and (I-8a) 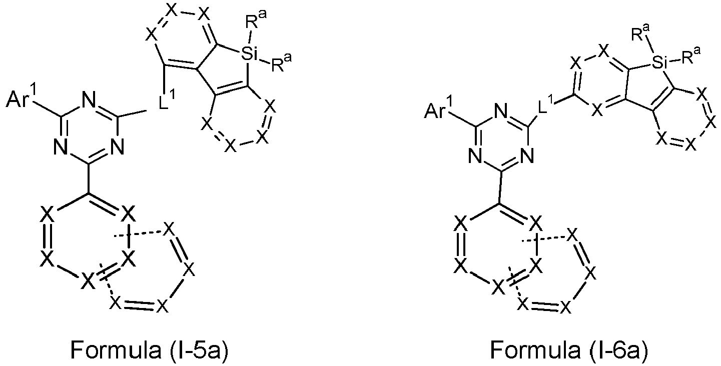 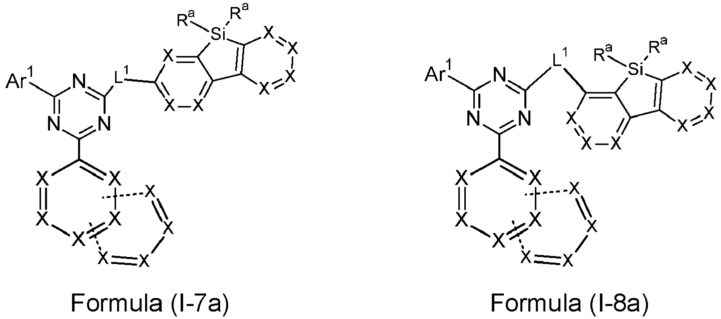 where the variables occurring are defined as in one or more of claims 1 to 5, wherein compounds of formulae (I-5a), (I-7a) and (I-8a) are preferred and compounds of formulae (I-5a) and (I-8a) are especially preferred.

10. Compound according to one or more of claims 1 to 9, **characterized in that** the compound conforms to one of formulae (I-9), (I-10), (I-11) and (I-12) 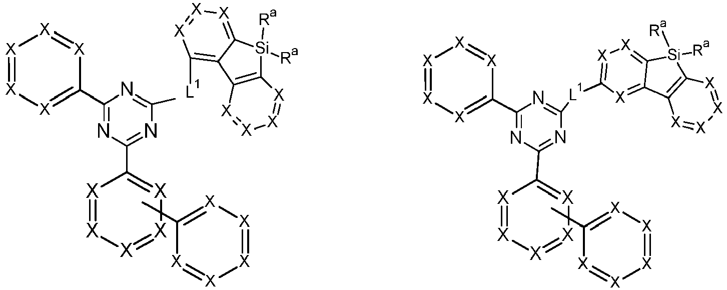 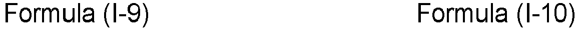 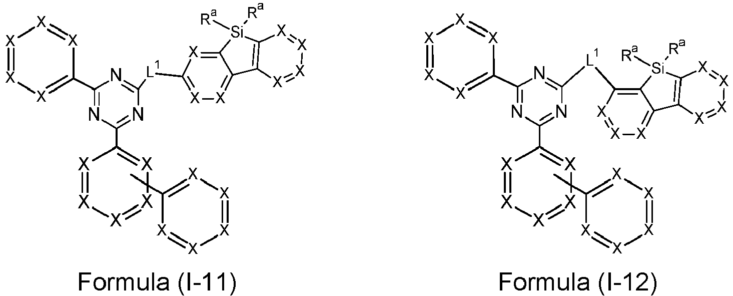 where the variables occurring are defined as in one or more of claims 1 to 4, wherein compounds of formulae (I-9), (I-11) and (I-12) are preferred and compounds of formulae (I-9) and (I-12) are especially preferred.

11. Process for preparation of a compound according one or more of claims 1 to 10, **characterized in that** a mono- or dihalogenated silyl derivative is reacted with a halogenated biphenyl group to a silafluorene derivative.

12. Oligomer, polymer or dendrimer, comprising one or more compounds according to one or more of claims 1 to 10, where the bond(s) to the polymer, oligomer or dendrimer may be localised at any desired positions in formula (I-1), (I-2), (I-3) or (I-4) substituted by R^{a}, R¹, R² or R³.

13. Formulation, comprising at least one compound according to one or more of claims 1 to 10 or at least one polymer, oligomer or dendrimer according to claim 12, and at least one solvent.

14. Electronic device, comprising at least one compound according to one or more of claims 1 to 10, or at least one polymer, oligomer or dendrimer according to claim 12.

15. Use of a compound according to one or more of claims 1 to 10, or of a polymer, oligomer or dendrimer according to claim 12, in an electronic device.

## Patentansprüche

1. Verbindung einer Formel (I-1), (I-2), (I-3) oder (I-4) 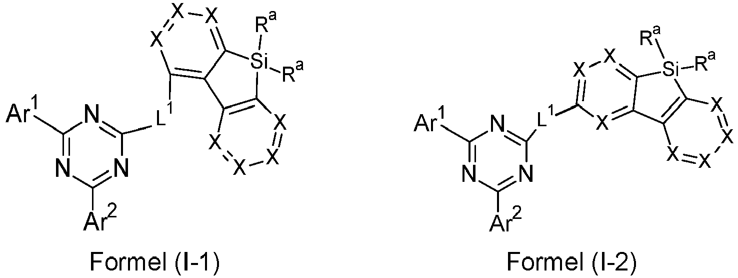 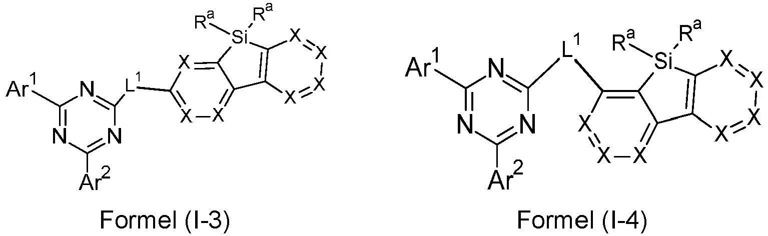 wobei für die variablen Gruppen Folgendes gilt:
Ar¹, Ar² sind bei jedem Auftreten gleich oder verschieden ausgewählt aus aromatischen Ringsystemen mit 6 bis 40 aromatischen Ringatomen, die durch einen oder mehrere Reste R¹ substituiert sein können;
L¹ ist eine Einfachbindung oder eine Gruppe, die ausgewählt ist aus aromatischen Ringsystemen mit 6 bis 50 aromatischen Ringatomen, die jeweils durch einen oder mehrere Reste R² substituiert sein können;
X ist bei jedem Auftreten gleich oder verschieden ausgewählt aus CR¹ und N;
R^{a} ist bei jedem Auftreten gleich oder verschieden ausgewählt aus H, D, F, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste R^{a} miteinander zu einem Ring verbunden sein können; wobei die genannten Alkyl-, Alkoxy-, Alkenyl- und Alkinylgruppen und die genannten aromatischen und heteroaromatischen Ringsysteme jeweils durch einen oder mehrere Reste R² substituiert sein können und wobei eine oder mehrere CH₂-Gruppen in den genannten Alkyl-, Alkoxy-, Alkenyl- und Alkinylgruppen jeweils durch -R²C=CR²-, -C≡C-, Si(R²)₂, C=O, C=NR², -C(=O)O-, -C(=O)NR²-, NR², P(=O)(R²), -O-, -S-, SO oder SO₂ ersetzt sein können;
R¹ ist bei jedem Auftreten gleich oder verschieden ausgewählt aus H, D, F, C(=O)R², CN, Si(R²)₃, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen; wobei zwei oder mehr Reste R¹ miteinander zu einem Ring verbunden sein können; wobei die genannten Alkyl-, Alkoxy-, Alkenyl- und Alkinylgruppen und die genannten aromatischen Ringsysteme jeweils durch einen oder mehrere Reste R² substituiert sein können und wobei eine oder mehrere CH₂-Gruppen in den genannten Alkyl-, Alkoxy-, Alkenyl- und Alkinylgruppen jeweils durch -R²C=CR²-, -C≡C-, Si(R²)₂, C=O, C=NR², -C(=O)O-, -C(=O)NR²-, NR², P(=O)(R²), -O-, -S-, SO oder SO₂ ersetzt sein können;
R² ist bei jedem Auftreten gleich oder verschieden ausgewählt aus H, D, F, C(=O)R³, CN, Si(R³)₃, N(R³)₂, P(=O)(R³)₂, OR³, S(=O)R³, S(=O)₂R³, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste R² miteinander zu einem Ring verbunden sein können; wobei die genannten Alkyl-, Alkoxy-, Alkenyl- und Alkinylgruppen und die genannten aromatischen und heteroaromatischen Ringsysteme jeweils durch einen oder mehrere Reste R³ substituiert sein können und wobei eine oder mehrere CH₂-Gruppen in den genannten Alkyl-, Alkoxy-, Alkenyl- und Alkinylgruppen jeweils durch -R³C=CR³-, -C≡C-, Si(R³)₂, C=O, C=NR³, -C(=O)O-, -C(=O)NR³-, NR³, P(=O)(R³), -O-, -S-, SO oder SO₂ ersetzt sein können; und
R³ ist bei jedem Auftreten gleich oder verschieden ausgewählt aus H, D, F, CN, Alkylgruppen mit 1 bis 20 C-Atomen, aromatischen Ringsystemen mit 6 bis 40 C-Atomen oder heteroaromatischen Ringsystemen mit 5 bis 40 aromatischen Ringatomen; wobei zwei oder mehr Reste R³ miteinander zu einem Ring verbunden sein können; und wobei die genannten Alkylgruppen, aromatischen Ringsysteme und heteroaromatischen Ringsysteme durch F und CN substituiert sein können.

2. Verbindung nach Anspruch 1, **dadurch gekennzeichnet, dass** die Verbindung genau eine Triazingruppe enthält.

3. Verbindung nach einem oder mehreren der Ansprüche 1 bis 2, **dadurch gekennzeichnet, dass** die Gruppe Ar¹ von der Gruppe Ar² verschieden ist.

4. Verbindung nach einem oder mehreren der Ansprüche 1 bis 3, **dadurch gekennzeichnet, dass** die Gruppe Ar² mehr aromatische Ringatome enthält als die Gruppe Ar¹.

5. Verbindung nach einem oder mehreren der Ansprüche 1 bis 4, **dadurch gekennzeichnet, dass** die Gruppe Ar¹ mindestens zwei aromatische Ringe enthält, die kondensiert oder nicht kondensiert sein können.

6. Verbindung nach einem oder mehreren der Ansprüche 1 bis 5, **dadurch gekennzeichnet, dass** die Gruppe Ar² mindestens zwei aromatische Ringe enthält, die kondensiert oder nicht kondensiert sein können.

7. Verbindung nach einem oder mehreren der Ansprüche 1 bis 6, **dadurch gekennzeichnet, dass** die Verbindung einer der Formeln (I-1), (I-3) und (I-4) entspricht, bei denen Verbindungen der Formeln (I-1) und (I-4) insbesondere bevorzugt sind.

8. Verbindung nach einem oder mehreren der Ansprüche 1 bis 7, **dadurch gekennzeichnet, dass** die Verbindung einer der Formeln (I-5), (I-6), (I-7) und (I-8) 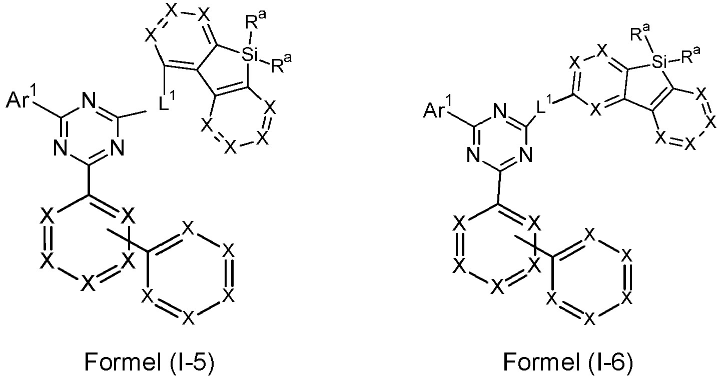 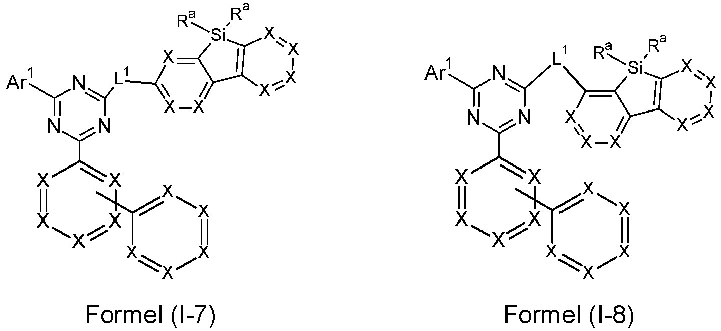 entspricht, wobei die auftretenden Variablen wie in einem oder mehreren der Ansprüche 1 bis 5 definiert sind, bei denen Verbindungen der Formeln (I-5), (I-7) und (I-8) bevorzugt sind und Verbindungen der Formeln (I-5) und (I-8) insbesondere bevorzugt sind.

9. Verbindung nach einem oder mehreren der Ansprüche 1 bis 8, **dadurch gekennzeichnet, dass** die Verbindung einer der Formeln (I-5a), (I-6a), (I-7a) und (I-8a) 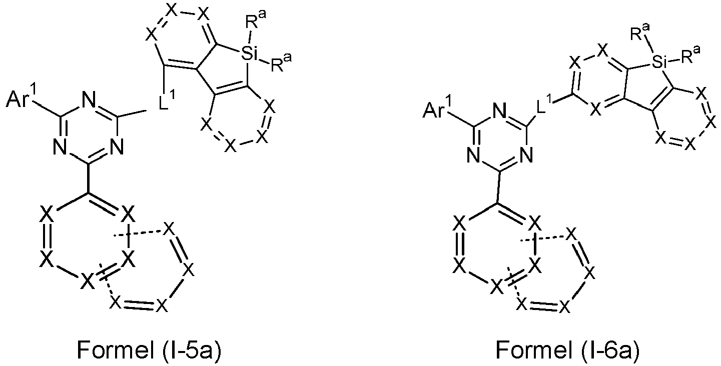 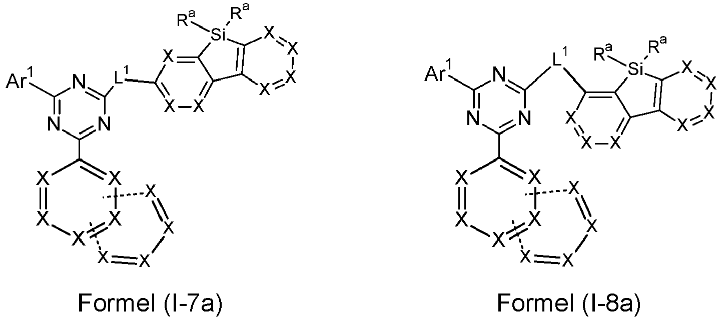 entspricht, wobei die auftretenden Variablen wie in einem oder mehreren der Ansprüche 1 bis 5 definiert sind, bei denen Verbindungen der Formeln (I-5a), (I-7a) und (I-8a) bevorzugt sind und Verbindungen der Formeln (I-5a) und (I-8a) insbesondere bevorzugt sind.

10. Verbindung nach einem oder mehreren der Ansprüche 1 bis 9, **dadurch gekennzeichnet, dass** die Verbindung einer der Formeln (I-9), (I-10), (I-11) und (I-12) 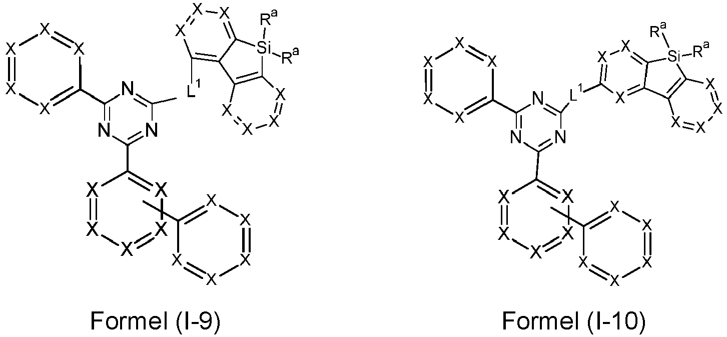 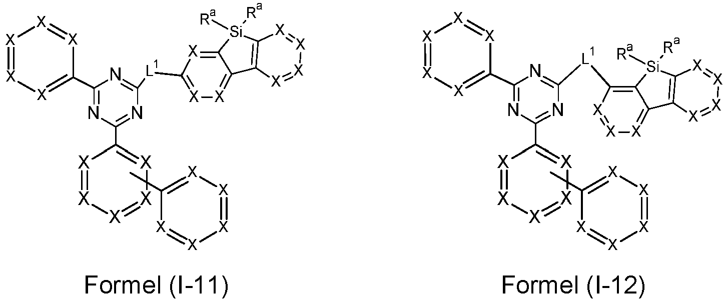 entspricht, wobei die auftretenden Variablen wie in einem oder mehreren der Ansprüche 1 bis 4 definiert sind, bei denen Verbindungen der Formeln (I-9), (I-11) und (I-12) bevorzugt sind und Verbindungen der Formeln (I-9) und (I-12) insbesondere bevorzugt sind.

11. Verfahren zur Herstellung einer Verbindung nach einem oder mehreren der Ansprüche 1 bis 10, **dadurch gekennzeichnet, dass** ein ein- oder zweifach halogeniertes Silylderivat mit einer halogenierten Biphenylgruppe zu einem Silafluorenderivat umgesetzt wird.

12. Oligomer, Polymer oder Dendrimer enthaltend eine oder mehrere Verbindungen nach einem oder mehreren der Ansprüche 1 bis 10, wobei die Bindung(en) zu dem Polymer, Oligomer oder Dendrimer an beliebigen Positionen in Formel (I-1), (I-2), (I-3) oder (I-4) lokalisiert sein können, die durch R^{a}, R¹, R² oder R³ substituiert sind.

13. Formulierung enthaltend mindestens eine Verbindung nach einem oder mehreren der Ansprüche 1 bis 10 oder mindestens ein Polymer, Oligomer oder Dendrimer nach Anspruch 12 und mindestens ein Lösungsmittel.

14. Elektronische Vorrichtung enthaltend mindestens eine Verbindung nach einem oder mehreren der Ansprüche 1 bis 10 oder mindestens ein Polymer, Oligomer oder Dendrimer nach Anspruch 12.

15. Verwendung einer Verbindung nach einem oder mehreren der Ansprüche 1 bis 10 oder eines Polymers, Oligomers oder Dendrimers nach Anspruch 12 in einer elektronischen Vorrichtung.

## Revendications

1. Composé de formule (I-1), (I-2), (I-3) ou (I-4) 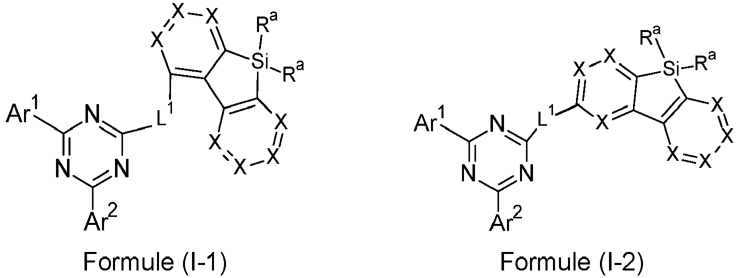 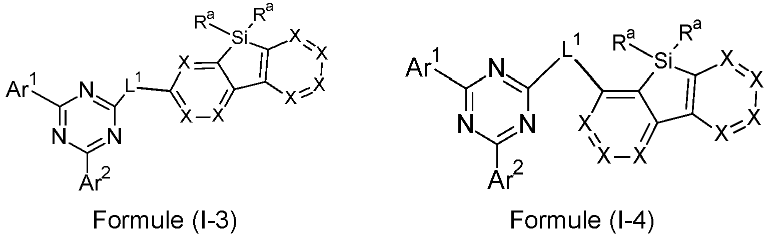 dans laquelle ce qui suit s'applique aux groupements variables :
Ar¹, Ar² sont choisis, de manière identique ou différente à chaque occurrence, parmi des noyaux aromatiques ayant de 6 à 40 atomes de cycle aromatique, pouvant être substitués par un ou plusieurs radicaux R¹ ;
L¹ est une liaison simple ou un groupement choisi parmi des noyaux aromatiques ayant de 6 à 50 atomes de cycle aromatique, chacun d'entre eux pouvant être substitué par un ou plusieurs radicaux R² ;
X est, de manière identique ou différente à chaque occurrence, choisi parmi CR¹ et N ;
R^{a} est choisi, de manière identique ou différente à chaque occurrence, parmi H, D, F, des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux R^{a} peuvent être reliés les uns aux autres pour former un cycle ; où lesdits groupements alkyle, alcoxy, alcényle et alcynyle et lesdits noyaux aromatiques et hétéroaromatiques peuvent dans chaque cas être substitués par un ou plusieurs radicaux R², et où un ou plusieurs groupements CH₂ dans lesdits groupements alkyle, alcoxy, alcényle et alcynyle peuvent dans chaque cas être remplacés par -R²C=CR²-, -C=C-, Si(R²)₂, C=O, C=NR², -C(=O)O-, -C(=O)NR²-, NR², P(=O)(R²), -O-, -S-, SO ou SO₂ ;
R¹ est choisi, de manière identique ou différente à chaque occurrence, parmi H, D, F, C(=O)R², CN, Si(R²)₃, P(=O)(R²)₂, OR², S(=O)R², S(=O)₂R², des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique ; où deux, ou plus, radicaux R¹ peuvent être reliés les uns aux autres pour former un cycle ; où lesdits groupements alkyle, alcoxy, alcényle et alcynyle et lesdits noyaux aromatiques peuvent dans chaque cas être substitués par un ou plusieurs radicaux R², et où un ou plusieurs groupements CH₂ dans lesdits groupements alkyle, alcoxy, alcényle et alcynyle peuvent dans chaque cas être remplacés par -R²C=CR²-, -C≡C-, Si(R²)₂, C=O, C=NR², -C(=O)O-, -C(=O)NR²-, NR², P(=O)(R²), -O-, -S-, SO ou SO₂ ;
R² est choisi, de manière identique ou différente à chaque occurrence, parmi H, D, F, C(=O)R³, CN, Si(R³)₃, N(R³)₂, P(=O)(R³)₂, OR³, S(=O)R³, S(=O)₂R³, des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux R² peuvent être reliés les uns aux autres pour former un cycle ; où lesdits groupements alkyle, alcoxy, alcényle et alcynyle et lesdits noyaux aromatiques et hétéroaromatiques peuvent dans chaque cas être substitués par un ou plusieurs radicaux R³, et où un ou plusieurs groupements CH₂ dans lesdits groupements alkyle, alcoxy, alcényle et alcynyle peuvent dans chaque cas être remplacés par -R³C=CR³-, -C≡C-, Si(R³)₂, C=O, C=NR³, -C(=O)O-, -C(=O)NR³-, NR³, P(=O)(R³), -O-, -S-, SO ou SO₂; et
R³ est choisi, de manière identique ou différente à chaque occurrence, parmi H, D, F, CN, des groupements alkyle ayant de 1 à 20 atomes de C, des noyaux aromatiques ayant de 6 à 40 atomes de C, ou des noyaux hétéroaromatiques ayant de 5 à 40 atomes de cycle aromatique ; où deux, ou plus, radicaux R³ peuvent être reliés les uns aux autres pour former un cycle ; et où lesdits groupements alkyle, noyaux aromatiques et noyaux hétéroaromatiques peuvent être substitués par F et CN.

2. Composé selon la revendication 1, **caractérisé en ce que** le composé inclut exactement un seul groupement triazine.

3. Composé selon l'une ou plusieurs parmi les revendications 1 à 2, **caractérisé en ce que** le groupement Ar¹ est différent du groupement Ar².

4. Composé selon l'une ou plusieurs parmi les revendications 1 à 3, **caractérisé en ce que** le groupement Ar² comprend plus d'atomes de cycle aromatique que le groupement Ar¹.

5. Composé selon l'une ou plusieurs parmi les revendications 1 à 4, **caractérisé en ce que** le groupement Ar¹ comprend au moins deux cycles aromatiques qui peuvent être condensés ou non condensés.

6. Composé selon l'une ou plusieurs parmi les revendications 1 à 5, **caractérisé en ce que** le groupement Ar² comprend au moins deux cycles aromatiques qui peuvent être condensés ou non condensés.

7. Composé selon l'une ou plusieurs parmi les revendications 1 à 6, **caractérisé en ce que** le composé répond à l'une des formules (I-1), (I-3) et (I-4), où les composés de formules (I-1) et (I-4) sont particulièrement préférés.

8. Composé selon l'une ou plusieurs parmi les revendications 1 à 7, **caractérisé en ce que** le composé répond à l'une des formules (I-5), (I-6), (I-7) et (I-8) 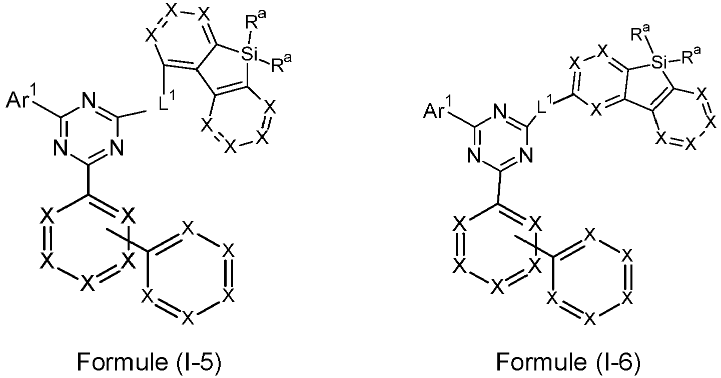 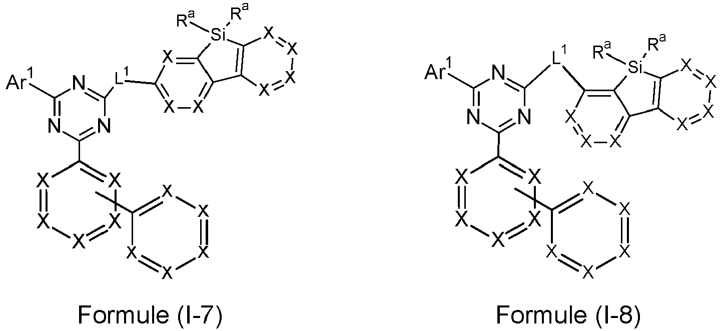 dans lesquelles les variables présentes sont telles que définies selon l'une ou plusieurs parmi les revendications 1 à 5, où les composés de formules (I-5), (I-7) et (I-8) sont préférés et les composés de formules (I-5) et (I-8) sont particulièrement préférés.

9. Composé selon l'une ou plusieurs parmi les revendications 1 à 8, **caractérisé en ce que** le composé répond à l'une des formules (I-5a), (I-6a), (I-7a) et (I-8a) 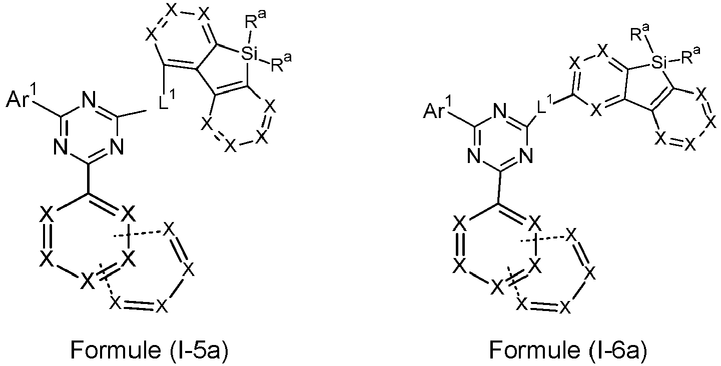 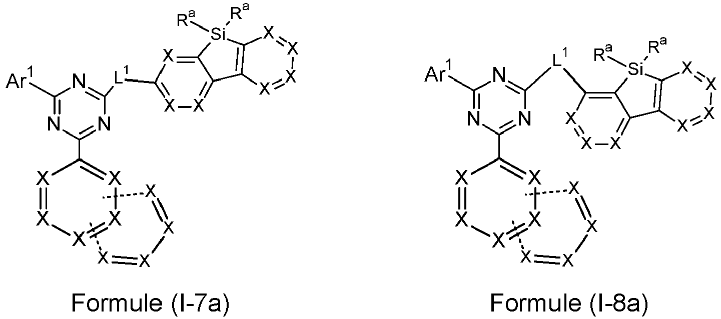 dans lesquelles les variables présentes sont telles que définies selon l'une ou plusieurs parmi les revendications 1 à 5, où les composés de formules (I-5a), (I-7a) et (I-8a) sont préférés et les composés de formules (I-5a) et (I-8a) sont particulièrement préférés.

10. Composé selon l'une ou plusieurs parmi les revendications 1 à 9, **caractérisé en ce que** le composé répond à l'une des formules (I-9), (I-10), (I-11) et (I-12) 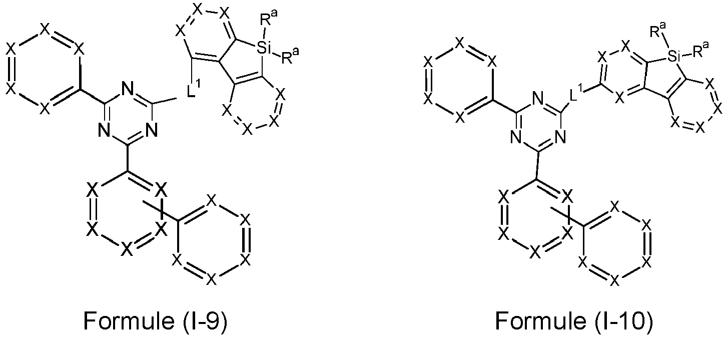 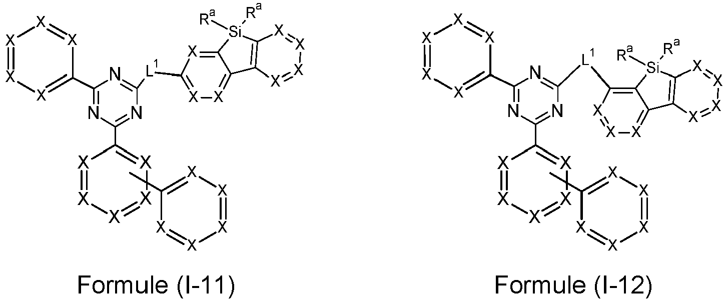 dans lesquelles les variables présentes sont telles que définies selon l'une ou plusieurs parmi les revendications 1 à 4, où les composés de formules (I-9), (I-11) et (I-12) sont préférés et les composés de formules (I-9) et (I-12) sont particulièrement préférés.

11. Procédé de préparation d'un composé selon l'une ou plusieurs parmi les revendications 1 à 10, **caractérisé en ce qu'**un dérivé silyle mono- ou dihalogéné est réagi avec un groupement biphényle halogéné en un dérivé silafluorène.

12. Oligomère, polymère ou dendrimère comprenant un ou plusieurs composés selon l'une ou plusieurs parmi les revendications 1 à 10, la ou les liaisons au polymère, à l'oligomère ou au dendrimère pouvant être situées au niveau de positions désirées quelconques dans la formule (I-1), (I-2), (I-3) ou (I-4) substitués par R^{a}, R¹, R² ou R³.

13. Formulation, comprenant au moins un composé selon l'une ou plusieurs parmi les revendications 1 à 10 ou au moins un polymère, oligomère ou dendrimère selon la revendication 12, et au moins un solvant.

14. Dispositif électronique, comprenant au moins un composé selon l'une ou plusieurs parmi les revendications 1 à 10, ou au moins un polymère, oligomère ou dendrimère selon la revendication 12.

15. Utilisation d'un composé selon l'une ou plusieurs parmi les revendications 1 à 10, ou d'un polymère, oligomère ou dendrimère selon la revendication 12, dans un dispositif électronique.
